# EUROPÄISCHE PATENTSCHRIFT

(11) **EP 4 581 408 B1**
(45) Veröffentlichungstag und Bekanntmachung des Hinweises auf die Patenterteilung: **18.11.2026**
(21) Anmeldenummer: 23772107.1
(22) Anmeldetag: 04.09.2023
(51) Int. Cl.: B23K 26/0622, B82Y 20/00, H02S 40/10, H10F 19/80, G02B 1/18, G02B 1/118, G02B 27/09, G03F 7/00, B23K 26/082, B23K 26/08, B23K 26/352

(54) **SUBSTRAT MIT ANTI-FOGGING-EIGENSCHAFTEN**
SUBSTRATE HAVING ANTI-FOGGING PROPERTIES
SUBSTRAT AYANT DES PROPRIÉTÉS ANTIBUÉE

(30) Priorität: 02.09.2022 LU 103001
(43) Veröffentlichungstag der Anmeldung: 09.07.2025
(73) Patentinhaber: Fusion Bionic GmbH, 01159 Dresden (DE)
(72) Erfinder: ALAMRI, Sabri, 01159 Dresden (DE); KUNZE, Tim, 01159 Dresden (DE)
(74) Vertreter: Gruner, Leopold Joachim
(86) Internationale Anmeldenummer: PCT/EP2023/074180
(87) Internationale Veröffentlichungsnummer: WO 2024/047256

(56) Entgegenhaltungen:
- CN-A- 108 241 185
- US-A1- 2001 035 991
- US-A1- 2015 183 152
- ANONYMOUS PAWEL ET AL: "What Is the Value of Water Contact Angle on Silicon? - PMC", MATERIALS, vol. 13, no. 7, 27 March 2020 (2020-03-27), pages 1554, XP093229551, ISSN: 1996-1944, Retrieved from the Internet <URL:https://pmc.ncbi.nlm.nih.gov/articles/PMC7177545/> DOI: 10.3390/ma13071554
- ZHOU Y ET AL: "ARTICLES YOU MAY BE INTERESTED IN Fabrication of large-area 3D optical fishnet metamaterial by laser interference lithography", APPL. PHYS. LETT. APPL. PHYS. LETT. PHYSICS LETTERS, 30 September 2013 (2013-09-30), XP093021250, Retrieved from the Internet <URL:https://aip.scitation.org/doi/pdf/10.1063/1.4821508> [retrieved on 20230206]
- ANONYMOUS: "Contact Angle of Water on Smooth Surfaces and Wettability", 31 December 2020 (2020-12-31), pages 1 - 4, XP093106057, Retrieved from the Internet <URL:http://www.uskino.com/articleshow_113.html> [retrieved on 20231127]

## Beschreibung

### TECHNISCHES GEBIET

Die vorliegende Erfindung betrifft den Bereich der Strukturierung von Substraten, insbesondere ein strukturiertes Substrat - beispielhaft sind hier flächige Substrate genannt - mit Anti-Fogging Eigenschaften, das eine periodische Punktstruktur, insbesondere eine erste periodische Punktstruktur, bevorzugt eine hierarchische periodische Struktur, umfasst, welche Anti-Fogging-Eigenschaften aufweist. Zudem betrifft die vorliegende Erfindung eine Vorrichtung und ein Verfahren zur Strukturierung von Oberflächen eines transparenten Substrats mittels Laserinterferenzstrukturierung.

### STAND DER TECHNIK

Aus dem Stand der Technik sind Verfahren zur Behandlung von Oberflächen bekannt, mit denen die Oberfläche von transparenten Substraten, insbesondere Glas, aber auch festen Polymeren, so verändert werden kann, dass die Benetzungseigenschaften der Oberfläche, insbesondere die Hydrophilie der Oberfläche eines Substrats verbessert, bzw. erhöht wird, sodass das Substrat Anti-Fogging-Eigenschaften aufweist. Durch die Behandlung der Oberfläche wird Tropfenbildung auf der Oberfläche unterbunden und stattdessen verläuft Wasser auf dem Substrat zu einem dünnen, homogenen Film, der gewährleistet, dass das Substrat auch bei ungünstigen Umweltbedingungen transparent bleibt. Typische Verfahren bringen hierzu ein zusätzliches Material auf die Oberfläche des Substrats auf (sog. Struktur- oder Schicht-aufbauende Verfahren), wobei das zusätzliche Material eine hohe Hydrophilie aufweist.

So ist ein Verfahren publiziert ("Characterization of Multilayer Anti-Fog Coatings", Chevallier et al., American Chemical Society 2011), welches die folgenden Schritte umfasst: Aktivieren der Oberfläche eines Substrats, insbesondere Glas, durch eine Plasmabehandlung zum Erzeugen von Aminogruppen an der Oberfläche, Aufbringen von Poly-(ethylenmaleinsäureanhydrid) (PEMA) und Aufbringen von Polyvinylalkohol (PVA), wobei PEMA als Schnittstelle zwischen den funktionellen Gruppen auf der Oberfläche des Substrats (Aminogruppen) und den Hydroxidgruppen des PVA fungiert. PVA bringt die notwendigen hydrophilen Eigenschaften mit, die gewährleisten, dass die aufgebrachte Beschichtung Anti-Fogging-Eigenschaften aufweist.

Nachteilig an einem solchen Verfahren ist jedoch, dass eine solche Beschichtung anfällig für mechanische Beanspruchung (Abrieb, Stöße) ist und dementsprechend eine schnelle Abnahme der Qualität aufgrund von schneller Degradation zeigen. Nach einiger Zeit löst sich die Beschichtung daher häufig vom Substrat und/oder verliert ihre Anti-Fogging-Eigenschaften.

Auch basiert das Verfahren auf der Verwendung von verschiedenen Chemikalien, deren Umweltverträglichkeit gering und deren Entsorgung oftmals aufwendig ist. Zusätzlich müssen die verwendeten Chemikalien auf das zu beschichtende Substrat abgestimmt werden, sodass diese Lösung nicht für jede Art Substrat universell anwendbar ist.

Aus wissenschaftlichen Publikationen ("Microfabrication and Surface Functionalization of Soda Lime Glass through Direct Laser Interference Patterning", Soldera et al., Nanomaterials 2021) sind Verfahren zur direkten Laserinterferenzstrukturierung bekannt, welche zum Erzeugen von Strukturen auf Kalk-Natron-Glas verwendet werden, um dem Material hydrophile Eigenschaften zu verleihen. Die erzeugten punktartigen oder linienförmigen Strukturen weisen eine Interferenzperiode von 2,3 µm oder 9 µm auf und sind durch direkte Laserinterferenzstrukturierung (direct laser interference patterning, DLIP) erzeugbar. Den durch DLIP erzeugten punktartigen oder linienförmigen Strukturen sind linienförmige Strukturen mit einer Interferenzperiode von 300 nm überlagert, welche als laser-erzeugte periodische Oberflächenstrukturen (laser-induced periodic surface structures, LIPSS) bezeichnet werden. Diese Strukturen entstehen durch einen Selbstorganisationsprozess, welcher durch das Anregen (Erwärmen) des Glases an Punkten, in denen das zur DLIP genutzte Interferenzmuster eine hohe Strahlungsintensität aufweist, entstehen. Durch den hohen Energieeintrag des einfallenden Laserstrahls in diesen Punkten wird das erwärmte Substrat derart umgeformt, dass sich ein quasi-periodisches Linienmuster ergibt, in welchem das Substrat im Anschluss erstarrt. Der Begriff quasi-periodisch bezieht sich auf sich regelmäßig wiederholende Strukturmerkmale, welche allerdings im Gegensatz zu einer echt periodischen Struktur Abweichungen in der Interferenzperiode aufweisen, wobei diese Abweichungen jedoch in einem Bereich deutlich kleiner als die Abmessungen der Strukturmerkmale, bevorzugt im Bereich von bis zu 20 %, bevorzugt bis zu 10 % und besonders bevorzugt bis zu 5 % der Abmessungen der Strukturmerkmale liegen. Somit ergeben sich zusätzlich zu den durch DLIP erzeugten punktartigen oder linienförmigen Strukturen überlagerte linienförmige Strukturen. Die entstehende Gesamtstruktur wird auch als hierarchische Struktur bezeichnet. Kalk-Natron-Glas mit einer solchen Strukturierung weist Anti-Fogging-Eigenschaften auf.

Allerdings benötigen diese Verfahren zum Kontrollieren der erzeugten Strukturen einen aufwändigen Umbau und eine Neuausrichtung von mehr als einem optischen Element im Strahlengang. Bei industrieller Anwendung mit einem hohen Durchsatz an zu strukturierenden Substraten mit unterschiedlichen Ansprüchen an die gewünschten Strukturweiten erfordert dies ein regelmäßiges Bewegen und Justieren der optischen Elemente im Strahlengang, wodurch der Prozess zum einen weniger flexibel ist, und zum anderen die optischen Elemente durch das regelmäßige Handling einem größeren Verschleiß und einer Beschädigungsgefahr ausgesetzt sind.

Darüber hinaus sind die durch direkte Laserinterferenzstrukturierung erzeugbaren minimalen Strukturabmessungen auf den Mikrometerbereich beschränkt. Dadurch ergeben sich jedoch an der Oberfläche des Substrates nachteilig Beugungseffekte, wodurch es zu einem regenbogenartigen Schimmer kommen kann, welche die Transparenz der Oberfläche sowie den Farbeindruck beeinträchtigen. Für Anwendungen, die ein transparentes Substrat erfordern, ist diese Art der Strukturierung, insbesondere die Auswahl der Interferenzperiode ungeeignet.

Weiterhin ist ein Verfahren zum Erzeugen hierarchischer Mikrotexturen mittels Laserstrukturierter Stempel bekannt ("Hierarchical Microtextures Embossed on PET from Laser-Patterned Stamps", Bouchard et al., Materials 2021), wobei der Laserstrukturierte Stempel mittels Direct Laser Writing (DLW) und Direct Laser Interference Patterning (DLIP) erzeugt wird. Der Stempel, insbesondere Edelstahlstempel, dient zum Übertragen der erzeugten hierarchischen Mikrotexturen, bzw. -strukturen auf ein PET Substrat. Zum Übertragen wird eine Heißprägetechnik (hot embossing) verwendet. Zusätzlich zum Strukturieren mittels DLIP wird in dieser Veröffentlichung auch das Strukturieren mittels Direct Laser Writing verwendet. Dabei wird ein Laserstrahl direkt auf das Material gelenkt, um im Bereich der maximalen Intensität eine Strukturierung des Substrates, insbesondere eine zapfenförmige Strukturierung, vorzunehmen. Dabei werden mittels DLW Strukturweiten im Bereich von 110 µm erzeugt, denen weitere Strukturen, welche durch DLIP erzeugt werden, überlagert sind, wobei diese weiteren Strukturen Interferenzperioden von 3,1 µm aufweisen. Durch die aufgebrachten hierarchischen Strukturen verändern sich die Eigenschaften des PET Substrates nachweislich. Insbesondere weist das strukturierte PET Substrat hydrophobe Eigenschaften, insbesondere einen Wasserkontaktwinkel von über 90° auf, während das unstrukturierte Substrat einen Wasserkontaktwinkel von 76,7° und damit leicht hydrophile Eigenschaften aufweist.

Ein solches PET Substrat weist allerdings keine ausgeprägten Anti-Fogging Eigenschaften auf, da die Strukturierung nicht das Erzeugen von deutlich hydrophilen Eigenschaften ermöglicht, sondern lediglich hydrophobe Eigenschaften erzeugt. Darüber hinaus ist keine Möglichkeit aufgezeigt, ein PET Substrat mittels DLIP zu strukturieren, da ein Prägeverfahren notwendig ist, um die Strukturen zu übertragen.

Die US 2015/183152 A1 offenbart ein Erzeugnis aufweisend eine Mehrzahl von Schichten, in die eine Struktur eingebracht ist, wobei diese Struktur unter anderem aus in die Schichten ausgeprägte Kegel oder Kegelstümpfe ausgebildet sein kann. Die Strukturierung erfolgt hierbei über einen Trockenätzprozess in Zusammenspiel mit einer zuvor belichteten Fotolackmaske. Nachteilig ist dabei zu erwähnen, dass durch den Trockenätzprozess und die Beschichtung mit einem Fotolack die Oberflächeneigenschaften der darunterliegenden Schicht, insbesondere eines Substrats nachteilig verändert werden können, sodass eine präzise Einstellung insbesondere der Benetzungseigenschaften nicht möglich ist.

### AUFGABE

Es ist daher Aufgabe der vorliegenden Erfindung, ein strukturiertes Substrat mit Anti-Fogging-Eigenschaften bereitzustellen, das über ein einfaches Verfahren erzeugt werden kann.

Dabei ist es darüber hinaus Aufgabe der vorliegenden Erfindung, eine möglichst robuste Strukturierung zu erzeugen, die nicht durch Inanspruchnahme des Substrats, insbesondere transparenten Substrats, ihre Wirksamkeit verliert. Außerdem sollte die Strukturierung von flächigen Substraten innerhalb von kurzer Zeit durchführbar sein.

Eine weitere Aufgabe der Erfindung ist es, ein Verfahren zur Strukturierung mittels Laserinterferenz bereitzustellen, welches unabhängig von der Intensität der Laserstrahlungsquelle ist. Das Verfahren soll derart eingerichtet sein, dass auch bei hohen Intensitäten auf dem zu strukturierenden Substrat keine Beschädigung der optischen Elemente eintritt.

Eine weitere Aufgabe ist die Funktionalisierung bzw. das Bearbeiten von nicht planaren, insbesondere dreidimensionalen, Substraten.

Insbesondere ist es dabei auch Aufgabe der Erfindung, ein Verfahren zur Strukturierung bereitzustellen, welches für eine große Bandbreite an Substraten, insbesondere transparenten Substraten anwendbar ist und diesen effektiv Anti-Fogging-Eigenschaften verleiht. Insbesondere ist dabei ein reproduzierbarer Wasserkontaktwinkel von Bedeutung, welcher die hydrophilen Eigenschaften der Oberfläche charakterisiert.

Ganz besonders hervorzuheben ist dabei, dass durch das Strukturieren des transparenten Substrats dessen Transparenz nicht beeinträchtigt werden soll, also nach der Strukturierung unvermindert vorhanden sein muss, ohne dass diese durch Beugungseffekte beeinträchtigt wird.

### LÖSUNG

Die technische Aufgabe wird durch ein strukturiertes Substrat mit den Merkmalen des Anspruchs 1 sowie durch ein Verfahren und einer Verwendung gemäß der nebengeordneten Ansprüche erfüllt.

Weitere vorteilhafte Ausführungen sind der Beschreibung und den Unteransprüchen zu entnehmen.

Bevorzugt betrifft die Erfindung ein strukturiertes Substrat mit Anti-Fogging-Eigenschaften, welches durch eine periodische Punktstruktur im Mikro- und/oder Submikrometerbereich strukturiert ist, wobei die periodische Punktstruktur aus inversen Zapfen oder Zapfen gebildet ist, dadurch gekennzeichnet, dass die periodische Punktstruktur
A) aus genau einer ersten periodischen Punktstruktur aufweisend genau eine erste Interferenzperiode im Bereich von 50 nm bis 50 µm besteht, oder
B) aus zumindest einer ersten periodischen Punktstruktur, aufweisend zumindest eine erste Interferenzperiode im Bereich von 50 nm bis 2,0 µm und/oder Abmessungen im Bereich von 9,5 µm bis 50 µm, besteht,
wobei die die erste Punktstruktur aufweisende Oberfläche des Substrates bei Benetzen mit Wasser einen Wasserkontaktwinkel von unter 20°, vorzugsweise unter 10°, bevorzugt unter 5° aufweist.

### ALLGEMEINE VORTEILE

Die Erfindung stellt vorteilhaft ein Substrat, insbesondere transparentes Substrat mit Anti-Fogging-Eigenschaften bereit, wobei das Substrat eine hohe Umweltverträglichkeit aufweist, da auf das Verwenden von Chemikalien während der Herstellung verzichtet wird. Weiterhin weist ein so strukturiertes Substrat verglichen mit herkömmlichen chemischen Beschichtungen eine höhere Beständigkeit der erzeugten Struktur auf, da diese unempfindlich gegenüber Abrieb und Stößen ist.

Das strukturierte Substrat, insbesondere transparente strukturierte Substrat weist eine vielseitige Anwendbarkeit im Bereich von Automobiltechnik, Luftfahrt, Photovoltaik, Bauwesen, Optik etc. auf, da die erzeugten Anti-Fogging-Eigenschaften des Substrats unabhängig von vorherrschenden Umweltbedingungen und Beanspruchung Bestand haben.

Die Erfindung stellt ein strukturiertes Substrat, insbesondere strukturiertes transparentes Substrat bereit, wobei die Struktur in einer Ebene des Substrats eine Tröpfchenbildung und somit das Bilden von Beschlag in dieser Ebene zu bis zu 100% unterbindet und somit gewährleistet, dass auch bei entsprechenden Umweltbedingungen das Substrat nicht beschlägt.

Zudem weist sich ein Substrat mit einer Oberfläche, die aus einem erfindungsgemäßen strukturierten und einem unstrukturierten Bereich besteht, insbesondere aus einem strukturierten Bereich, der durch eine erste periodische Punktstruktur im Mikro- oder Submikrometerbereich mit einer ersten Interferenzperiode im Bereich von 50 nm bis 50 µm gebildet wird oder aus einem strukturierten Bereich, der eine erste periodische Punktstruktur im Mikro- oder Submikrometerbereich mit einer ersten Interferenzperiode im Bereich von 50 nm bis 2,0 µm aufweist oder aus einem strukturierten Bereich, der eine erste periodische Punktstruktur im Mikro- oder Submikrometerbereich mit einer ersten Interferenzperiode im Bereich von 9,5 µm bis 50 µm aufweist, dadurch aus, dass es hydrophile Eigenschaften aufweist. Vorteilhaft ist durch die gewählten Parameter insbesondere ein zuverlässig reproduzierbarer Wasserkontaktwinkel realisierbar.

Zudem zeichnet sich ein strukturiertes Substrat mit einer Oberfläche mit Anti-Fogging-Eigenschaften, wobei die Oberfläche aus einem strukturierten und einem unstrukturierten Bereich besteht, wobei der strukturierte Bereich durch eine erste periodische Punktstruktur im Mikro- oder Submikrometerbereich mit einer ersten Interferenzperiode im Bereich von 50 nm bis 50 µm gebildet wird, dadurch aus, dass die Oberflächeneigenschaften des Substrats präzise kontrollierbar sind. Nach einer vorteilhaften Ausführung des Verfahrens ist außerdem kontrollierbar, dass die optischen Eigenschaften des Substrats, insbesondere dessen Transparenz durch ein Auftreten von quasi-periodischen Wellenstrukturen, sog. LIPSS, welche durch unkontrollierte Selbstorganisationsprozesse entstehen, nicht beeinträchtigt ist. Durch Einfachbestrahlung mit begrenzter Intensität ist vorteilhaft die Tiefe der Strukturen, also die Strukturtiefe begrenzt. Insbesondere ist so durch eine präzise Einstellbarkeit geringer Strukturtiefen gewährleistet, dass die optischen Eigenschaften des strukturierten Substrats sich im Vergleich zu denen des unstrukturierten Substrats nicht verschlechtern. Ferner kann aufgrund des Vermeidens der Selbstorganisationsprozesse ein besonders kontrolliertes Einstellen der Eigenschaften des Substrats, insbesondere des Wasserkontaktwinkels, und somit ein zuverlässiges Erzeugen hydrophiler und superhydrophiler Eigenschaften der Oberfläche gewährleistet werden.

### AUSFÜHRLICHE BESCHREIBUNG

Das erfindungsgemäße strukturierte Substrat beschreibt ein Substrat, aufweisend eine erste **periodische Punktstruktur** im Mikro- und/oder Submikrometerbereich, insbesondere mit Anti-Fogging-Eigenschaften an der Oberfläche des Substrats. Die Erfindung umfasst weiterhin ein Verfahren zum Erzeugen eines strukturierten Substrats mit Anti-Fogging-Eigenschaften.

### Strukturiertes Substrat

### Substrat

Im Sinne der Erfindung bezieht sich der Begriff Substrat auf ein Substrat dessen Oberfläche eine Ausdehnung in mehrere Raumrichtungen hat. Es kann sich bei einem Substrat, bevorzugt flächigen und/oder transparenten Substrat, um ein planares Substrat oder ein gekrümmtes Substrat, beispielsweise ein parabolisches Substrat handeln. Unter flächig ist im Sinne der Erfindung ferner zu verstehen, dass die Ausdehnung eines Substrats, bevorzugt flächigen und/oder transparenten Substrats, beispielsweise eines planaren Substrates in x und y Richtung, beziehungsweise die Ausdehnung eines gekrümmten Substrates entlang seines Krümmungsradius größer ist als die Ausdehnung des Bereichs, in dem die zumindest drei Teilstrahlen miteinander interferieren.

In einer bevorzugten Ausgestaltung handelt es sich bei dem Substrat um ein Substrat, dessen Ausdehnung in x und y Richtung, beziehungsweise dessen Ausdehnung entlang eines Krümmungsradius kleiner oder gleich der Ausdehnung des Bereichs ist, in dem die zumindest drei Teilstrahlen miteinander interferieren. Eine homogene Strukturierung des Substrats ist in einem Bearbeitungsschritt (während eines Laserpulses) möglich.

In einer besonders bevorzugten Ausgestaltung handelt es sich bei dem Substrat um ein flächiges Substrat, dessen Ausdehnung in x und y Richtung, beziehungsweise dessen Ausdehnung entlang eines Krümmungsradius größer der Ausdehnung des Bereichs ist, in dem die zumindest drei Teilstrahlen miteinander interferieren. Durch Bewegen des Substrats in der x und y Ebene ist eine flächige, homogene Strukturierung des Substrats in mehreren Bearbeitungsschritten (mit mehreren Laserpulsen) möglich. Die Bewegung des Substrats kann hierbei durch Rotation oder Translation oder durch eine Überlagerung aus Rotation und Translation erfolgen.

Im Sinne der Erfindung umfasst die Bezeichnung Substrat ein festes Material mit reflektierender Oberfläche, bzw. einer Oberfläche, an welcher sich unter entsprechenden Umgebungsbedingungen Beschlag in Form von feinen Wassertropfen bildet. Beispiele für solche Materialien sind insbesondere Gläser.

Hinsichtlich der Substrate, die durch die Applizierung des erfindungsgemäßen Laserinterferenzstrukturierungsverfahrens mit einer Punktstruktur, vorzugsweise periodischen Punktstruktur, beispielsweise ersten periodischen Punktstruktur, mit Anti-Fogging-Eigenschaften bearbeitet werden können, besteht im Rahmen der vorliegenden Erfindung eine breite Auswahlmöglichkeit an transparenten und transluzenten, aber auch intransparenten Materialien. Vorzugsweise ist das Substrat ein flächiges und/oder transparentes Material.

Das Substrat kann als flexibles und/oder biegsames Substrat, wie bspw. ein (Kunst-)Leder, eine Metallfolie, ein dünnes Blech oder eine Kunststofffolie, wie dies bspw. für die Anwendung in einer Solarfolie oder in Displays zum Einsatz kommt, ausgebildet sein.

In einer besonders bevorzugten Ausführungsform umfasst das flächige Substrat ein transparentes Material, vorzugsweise besteht das Substrat aus einem transparenten Material. Ein Material bzw. Substrat ist im Sinne der vorliegenden Erfindung transparent, wenn es eine hohe Durchlässigkeit für zumindest einen Teilbereich des Spektrums elektromagnetischer Strahlung zwischen 1 nm und 1 m, aufweist. Derartige Teilbereiche sind beispielsweise elektromagnetische Strahlung im Bereich des sichtbaren Lichts von 380 nm bis 780 nm oder in einem Bereich, der auch infrarotes Licht umfasst, von 380 nm bis 5000 nm oder in einem Bereich des infraroten Lichtes oder in einem Bereich der Mikrowellenstrahlung oder auch ein anderer Teilbereich, der entsprechend der gewünschten Anwendung, insbesondere an die Wellenlänge der Laserquelle, angepasst ist. Ein solcher Teilbereich hat bevorzugt wenigstens eine Breite von 10 % oder von 50 % der Wellenlänge, welche die untere Grenze des Teilbereiches bildet. Eine hohe Durchlässigkeit in einem Teilbereich ist im Sinne der Erfindung ein Transmissionsgrad von wenigstens 50 % oder vorzugsweise wenigstens 70 % oder besonders bevorzugt wenigstens 80 % oder wenigstens 90 % für jede Wellenlänge in dem Teilbereich, also für das gesamte Spektrum in dem Teilbereich. Als ein transparentes Substrat kann aber auch ein Substrat bezeichnet werden, welches selektiv für bestimmte Wellenlängenbereiche im Bereich des sichtbaren Lichts eine hohe Durchlässigkeit aufweist, bspw. hat das Substrat eine hohe Durchlässigkeit für elektromagnetische Strahlung mit Wellenlängen im Bereich von 500 nm bis 800 nm. Dabei kann der Transmissionsgrad über den Wellenlängenbereich, welcher transmittiert wird, variieren, bspw. für Wellenlängen im Bereich von 380 nm bis 500 nm nicht weniger als 70 % betragen, und im Bereich von 500 nm bis 750 nm nicht weniger als 90 % betragen.

Ein transparentes Material umfasst im Sinne der vorliegenden Erfindung transparente Materialien, insbesondere Glas (z.B. Borosilikatgläser, Quarzgläser, Alkali-Erdalkali-Silikatgläser (bspw. Kalknatronglas), Alumosilikatgläser, metallische Gläser), aber auch feste Polymere (z.B. Polycarbonate, wie Makrolon^{®} und Apec^{®}; Polycarbonatblends, wie Makroblend^{®} und Bayblen^{®}; Polymethylmethacrylat, wie Plexiglas^{®}; Polyester; Polyethylenterephthalat, Polypropylen, Polyethylen) sowie transparente Keramiken (bspw. Spinell-Keramiken, wie Mg-Al-Spinell, ALON, Aluminiumoxid, Yttriumaluminiumgranat, Yttriumoxid oder Zirkonoxid) oder Mischungen daraus. Polycarbonate sind Homopolycarbonate, Copolycarbonate und thermoplastische Polyestercarbonate.

Nach einer besonders bevorzugten Ausgestaltung besteht das transparente Material aus einem Glas (wie hierin definiert).

Das Silikatgerüst von Glas sorgt vorzugsweise für ein Transmissionsfenster für Wellenlängen im Bereich zwischen 170 nm und 5.000 nm, d.h. Wellenlängenbereich die das sichtbare Licht im Bereich von 380 nm bis 780 nm einschließen und Infrarotstrahlung umfassen.

Zusätzlich weist ein Glas im unstrukturierten Zustand eine leichte Hydrophilie, bzw. hydrophile Eigenschaften auf. Unter Hydrophilie ist im Sinne der Erfindung zu verstehen, dass ein Substrat wasseranziehende Eigenschaften aufweist, welche sich insbesondere über den Wasserkontaktwinkel definieren. Der Wasserkontaktwinkel bezeichnet den Winkel, der sich zwischen der Oberfläche und einem sie benetzenden Wassertropfen ausbildet, wobei der Winkel zwischen der Außenfläche des Tropfens am äußeren Kontaktpunkt und der Oberfläche gemessen wird. Liegt der Wasserkontaktwinkel über 90°, spricht man von einem hydrophoben Substrat. Liegt der Wasserkontaktwinkel unter 90°, spricht man von einer hydrophilen Oberfläche. Bevorzugt handelt es sich bei einem Substrat im Sinne der Erfindung um ein Glas mit einem Wasserkontaktwinkel unter 90°, besonders bevorzugt unter 80°, besonders bevorzugt im Bereich von unter 40° oder unter 20°.

Der Wasserkontaktwinkel einer Oberfläche wird mittels Tropfenkonturanalyse ermittelt. Diese Bildanalysemethode nutzt das Schattenbild eines auf der Oberfläche angeordneten bzw. liegenden Tropfens, wobei dessen Form auf der Oberfläche analysiert wird. Es wird dabei ein Tropfen von 2 µl deionisiertem Wasser auf der Oberfläche des Substrats verwendet. Die Umgebungstemperatur beträgt 22°C.Alternativ dazu kann das Substrats, bevorzugt flächigen und/oder transparenten Substrats, auch ein intransparentes Material umfassen. Durch die Strukturierung des intransparenten Materials wird auf der Oberfläche des intransparenten Materials eine periodische Punktstruktur im Mikro- und/oder Submikrometerbereich, vorzugsweise eine erste periodische Punktstruktur, erzeugt. Im Ergebnis kann hierdurch auf einem intransparenten Material eine Struktur erzeugt werden, welche als Negativ für eine Anti-Fogging-Struktur fungieren kann. Insbesondere kann eine solche Struktur als Stempel genutzt werden, um die Struktureigenschaften auf ein gewünschtes transparentes Substrat zu übertragen. Als intransparente Materialien eignen sich insbesondere Metalle (z.B. Silizium, Aluminium, Kupfer, Gold), metallische Legierungen (z.B. Stahl, Messing), mit Emaille beschichtete Metalle oder Gläser und keramische Materialien (z.B. Zirkonoxid, Titandioxid, Zirkondioxid) sowie Kombinationen davon. Beispielsweise eignet sich ein derart strukturiertes Substrat als Negativform zur indirekten Aufbringung oder Erzeugung von Strukturen auf einem anderen Substrat.

Als Substrate eignen sich darüber hinaus auch Polymere, wie bspw. Polyethylen (PE), Polyethylenterephthalat (PET), Polypropylen (PP), Polyamide (PA), Polyacrylnitrile (PAN), Polyurethane (PUR), Polyvinylchlorid (PVC), Polyetheretherketone (PEEK), oder polyfluorierte Kohlenwasserstoffe, wie Teflon.

### Punktförmige Struktur/Interferenzmuster/Anti-Fogging-Verglasung

Der Begriff inverser Zapfen bezieht sich im Sinne dieser Erfindung auf Strukturen mit einer kreisförmigen, elliptischen, dreieckigen oder im Wesentlichen rechteckigen Grundfläche, insbesondere mit einer kreisförmigen Grundfläche, die in vertikaler Richtung kegelförmig in das Substrat zulaufen und in deren Sattelpunkt über eine abgerundete Kegelspitze verfügen. Die inversen Zapfen werden während des Strukturierungsprozesses, d.h. beim Auftreffen eines Laserpulses als Folge des Auftreffens eines Bereiches hoher Intensität in das zu strukturierende Substrat ausgebildet, wobei die Bereiche zwischen den inversen Zapfen auf dem Substrat idealerweise durch destruktive Interferenz deren Intensität Null ist im Wesentlichen unstrukturiert verbleiben. Folglich wird durch die Fokussierung der Laser(-teil)strahlen auf dem Substrat das Negativ von dem, was die Intensitätsverteilung vorgibt, ausgebildet. Die beschriebene Form der inversen Zapfen bezieht sich auf Punktstrukturen, vorzugsweise eine erste Punktstruktur, bevorzugt eine erste periodische Punktstruktur, welche an der Oberfläche des Substrates angeordnet sind. Eine Anordnung der Punktstrukturen in einer oder entlang einer Ebene innerhalb des Volumens führt zu einer Form welche symmetrischer ausgebildet ist.

Zapfen mit einer elliptischen Grundfläche können beispielsweise durch Neigung des Substrates im Verhältnis zum Einfallswinkel des bzw. der fokussierten Laser(-teil)strahlen erzeugt werden.

Die Periode der Struktur, auch Interferenzperiode oder Strukturweite, wird im Sinne der Erfindung als p bezeichnet. Sie ist im Allgemeinen abhängig von der Wellenlänge der interferierenden Laser(-teil)strahlen, dem Einfallswinkel der interferierenden Laser(-teil)strahlen und der Anzahl der interferierenden Laser(-teil)strahlen.

Unter einer periodischen Punktstruktur ist im Sinne der Erfindung allgemein eine Struktur zu verstehen, die punktförmige, sich regelmäßig wiederholende Strukturmerkmale aufweist. Insbesondere handelt es sich bei den sich regelmäßig wiederholenden Strukturmerkmalen um inverse Zapfen. Die Regelmäßigkeit der Strukturmerkmale ist dabei derart definiert, dass die einzelnen Strukturmerkmale derart zueinander positioniert sind, dass ihr Abstand über das Substrat, bzw. einen Interferenzpixel hinweg gleichbleibend ist.

Die Erfinder haben einen Zusammenhang zwischen der Oberflächenbeschaffenheit eines Substrats und der Bildung von Kondenswasser, insbesondere in Form von Beschlag oder Nebel, an dessen Oberfläche festgestellt. Insbesondere können demgemäß sog. Anti-Fogging-Eigenschaften erzeugt werden, wenn die Strukturgröße an der Oberfläche eines Substrates hinreichend klein ist. Forschungsergebnisse haben gezeigt, dass ein Substrat mit hydrophilen und/oder superhydrophilen Eigenschaften auch Anti-Fogging Eigenschaften aufweisen kann.

Unter Anti-Fogging-Eigenschaften ist im Sinne der Erfindung zu verstehen, dass an der Oberfläche eines Substrates kein oder nur sehr wenig Wasser, vorzugsweise nur bis zu 15 %, besonders bevorzugt nur bis zu 10 % und noch bevorzugter nur bis zu 5% des vorhandenen Wassers, in Form von Tropfen kondensiert, wobei diese Eigenschaft auf die Oberflächenbeschaffenheit, insbesondere die Oberflächenrauigkeit zurückzuführen ist.

Ein strukturiertes Substrat mit Anti-Fogging-Eigenschaften, hier eine Anti-Fogging-Verglasung genannt, beschreibt im Sinne der Erfindung ein Substrat, bevorzugt flächiges und/oder transparentes Substrat, mit einer periodischen Punktstruktur, vorzugsweise einer ersten periodischen Punktstruktur, mit Strukturweiten im Mikro- oder Submikrometerbereich, also im Bereich von 50 nm bis 50 µm. Diese Anti-Fogging-Eigenschaften kommen zustande, wenn die Abmessungen der erzeugten Struktur, also die Interferenzperiode und Abmessung der einzelnen inversen Zapfen, die Oberflächenrauigkeit des Substrats derart erhöhen, dass die hydrophilen Eigenschaften der unstrukturierten Oberfläche derart verstärkt werden, dass sich beim Benetzen mit Wasser Kontaktwinkel im Bereich von 0° bis 20°, bevorzugt 0° bis 15°, besonders bevorzugt 0° bis 10°, ganz besonders bevorzugt 0° bis 5° ausbilden und damit eine superhydrophile Oberfläche gegeben ist. Dabei basiert die erhöhte Oberflächenrauigkeit darauf, dass die Oberflächentextur durch die in das Substrat eingebrachte periodische Punktstruktur im Mikro- oder Submikrometerbereich verändert ist, insbesondere darauf, dass die Oberfläche des Substrats durch die eingebrachte periodische Punktstruktur Vertiefungen aufweist.

Das strukturierte Substrat weist somit eine Schicht aus einem Material auf, dessen unstrukturierte Oberfläche hydrophile Eigenschaften, also einen Wasserkontaktwinkel von kleiner als 90°, aufweist. Diese Schicht muss dabei so an dem strukturierten Substrat angeordnet sein, dass die erste periodische Punktstruktur in dieser Schicht oder wenigstens auch in dieser Schicht angeordnet ist, also diese Schicht, wenigstens in einem Teilbereich, strukturiert ist. Dabei kann auch das gesamte Substrat aus diesem Material ausgebildet sein, also nur aus einer Schicht aus diesem Material bestehen.

Das Substrat weist somit an der Oberfläche eine Schicht auf, dessen Material hydrophil ausgebildet ist, wobei eine unstrukturierte Oberfläche dieses Materials einen Wasserkontaktwinkel von kleiner als 90°, vorzugsweise kleiner als 80°, aufweist. Dadurch entsteht durch die Strukturierung einer Oberfläche dieses Materials effizient ein strukturiertes Substrat mit einer strukturierten Oberfläche mit superhydrophilen Eigenschaften, welches bevorzugt einen Wasserkontaktwinkel von kleiner als 20°, vorzugsweise von kleiner als 10° und besonders bevorzugt von kleiner als 5°, aufweist.

Weiterhin haben die Erfinder herausgefunden, dass ein so strukturiertes Substrat auch Antireflexionseigenschaften aufweisen kann. Diese Antireflexionseigenschaften kommen zustande, wenn die Abmessungen der erzeugten Struktur, also die Interferenzperiode und Abmessung der einzelnen Zapfen, in Bereichen kleiner als die Wellenlänge des sichtbaren Lichts liegen, also vorzugsweise unterhalb von 700 nm, bevorzugt unterhalb von 500 nm.

Unter Reflexion versteht man in der Physik das Zurückwerfen von einer elektromagnetischen Welle an einer Grenzfläche von Materialien unterschiedlichen Brechungsindizes. Der Reflexionswinkel und der Transmissionswinkel von Licht in transparenten Substraten können allgemein über das Snelliussche Brechungsgesetz berechnet werden zu ${n}_{1} {sinδ}_{1} = {n}_{2} {sinδ}_{2}$ berechnet, wobei n₁ und n₂ den Brechungsindex von Luft und dem Substrat angeben und δ₁ und δ₂ jeweils die Winkel des einfallenden und reflektierten Strahls angeben.

Durch die periodische Punktstruktur, vorzugsweise eine erste periodische Punktstruktur, auf der Oberfläche des Substrats, bevorzugt flächigen und/oder transparenten Substrats, verändert sich der Brechungsindex des Substrats in der Form, dass sich ein gradueller Brechungsindex ergibt. Das hat zur Folge, dass Licht mit Wellenlängen größer der Interferenzperiode p der periodischen Punktstruktur vermehrt transmittiert wird. Licht mit Wellenlängen kleiner oder gleich der periodischen Punktstruktur wird an der Oberfläche gebeugt.

Antireflexionseigenschaften bezeichnen im Sinne der Erfindung periodische Punktstrukturen, deren Abmessungen im Bereich der einfallenden elektromagnetischen Welle liegen, sodass die einfallende Welle derart vom Betrachter weggebeugt wird, dass keine Reflexion als "störend" wahrgenommen wird. Zusätzlich umfasst der Begriff Antireflexionseigenschaften im Sinne der Erfindung auch, dass der Brechungsindex an der Grenze zwischen dem ersten Medium, zum Beispiel Luft, und dem Substrat, bevorzugt flächigen und/oder transparenten Substrat, graduell ist, sodass für die einfallende elektromagnetische Welle kein klarer Übergang von einem Medium zum anderen vorhanden ist und die einfallende elektromagnetische Welle vermehrt transmittiert wird.

Der Brechungsindex des strukturierten Substrats ist dabei durch die erzeugte periodische Punktstruktur, vorzugsweise eine erste periodische Punktstruktur, graduell. Er nimmt über die Höhe der Struktur hinweg ab, sodass kein klarer Luft-Medium Übergang existiert. Dadurch kommt es zur erhöhten Transmission von einfallenden elektromagnetischen Wellen mit einer Wellenlänge größer als die Interferenzperiode der erzeugten Punktstruktur, und zur Beugung von einfallenden elektromagnetischen Wellen mit einer Wellenlänge im Bereich der Interferenzperiode der erzeugten Punktstruktur.

Von der vorliegenden Erfindung ist auch ein strukturiertes Substrat (5) mit einer Oberfläche mit Anti-Fogging-Eigenschaften betroffen, wobei die Oberfläche aus einem strukturierten und einem unstrukturierten Bereich besteht, wobei der strukturierte Bereich aus einer ersten **periodischen Punktstruktur** mit einer ersten Interferenzperiode im Mikro- oder Submikrometerbereich gebildet ist, wobei die erste periodische Punktstruktur aus inversen **Zapfen** gebildet ist, und wobei die inversen Zapfen periodisch mit einem Abstand bezogen auf deren jeweiligen Sattelpunkt bzw. Höhenmittelpunkt (kreisförmige Grundfläche) im Bereich von 50 nm bis 50 µm zueinander angeordnet sind. Ein derart strukturiertes Substrat zeichnet sich dadurch aus, dass es über eine erste periodische Punktstruktur mit genau einer Interferenzperiode verfügt. Es sind keine überlagerten periodischen Strukturen vorhanden, welche eine zweite Interferenzperiode aufweisen. Somit ergibt sich eine präzisere Kontrolle der Substrateigenschaften, insbesondere der Transparenz des Substrats, welche aufgrund geringer Strukturtiefen, welche daraus resultieren, dass jedes Interferenzpixel gerade nur einmal bestrahlt wird, nicht durch die Strukturierung beeinträchtigt wird.

Zusätzlich bietet ein solches Substrat eine gute Kontrolle der hydrophilen Eigenschaften des Substrats, da zuverlässig ein spezifischer Wasserkontaktwinkel an der Substrat-Oberfläche erzeugt werden kann. Eine derart zuverlässige Reproduzierbarkeit des Wasserkontaktwinkels, kann dadurch erreicht werden, dass potenziell auftretende LIPSS-Strukturen dadurch vermieden werden, dass eine Einfachbestrahlung, also ein einzelner Laserpuls zum Erzeugen der periodischen Punktstruktur, vorzugsweise der ersten periodischen Punktstruktur, genutzt wird. Einfachbestrahlung verhindert das Auftreten von unkontrollierten Selbstorganisationsprozessen, welche zu LIPSS-Strukturen, im Sinne der Erfindung auch als quasi-periodische Wellenstrukturen bezeichnet, führen.

LIPSS-Strukturen treten nachteilig häufig dann auf, wenn eine Punktstruktur, vorzugsweise eine erste Punktstruktur, bevorzugt eine erste periodische Punktstruktur, innerhalb eines Interferenzpixels mehrfach aufeinanderfolgend, also mit mehreren Pulsen, bestrahlt wird. Die dadurch auftretenden Selbstorganisationsprozesse sind schlecht steuerbar, wodurch die Reproduzierbarkeit negativ beeinflusst wird.

Vorzugsweise liegt die Interferenzperiode der ersten Struktur, insbesondere der ersten periodischen Punktstruktur, welche den strukturierten Bereich bildet, im Bereich von 200 nm bis 50 µm, bevorzugt 200 nm bis 20 µm, ganz besonders bevorzugt von 200 nm bis 10 µm, ganz besonders bevorzugt im Bereich von 200 nm bis 500 nm.

Vorzugsweise beträgt der Anteil der strukturierten Fläche, insbesondere Oberfläche des Substrats 5 % bis 100 %, bevorzugt 10 % bis 70 %, besonders bevorzugt 20 % bis 50 % der Gesamtoberfläche des Substrats.

Bevorzugt weist das erfindungsgemäße Substrat zumindest eine periodische Punktstruktur auf, vorzugsweise eine erste periodische Punktstruktur, welche aus inversen Zapfen ausgebildet ist, wobei die inversen Zapfen regelmäßige, wiederholbare Strukturabmessungen aufweisen. Die Strukturabmessungen beziehen sich dabei neben der Interferenzperiode, also dem Abstand der inversen Zapfen zueinander bezogen auf ihren Sattelpunkt, auch auf die Strukturtiefe und/ oder die Grundfläche der inversen Zapfen. Dabei beträgt die Strukturtiefe der inversen Zapfen, also der Abstand zwischen dem Sattelpunkt der inversen Zapfen und der Oberfläche des unstrukturierten Substrats vorzugsweise 0,05 µm bis 2 µm, besonders bevorzugt 0,1 µm bis 1 µm. Die geringen Strukturtiefen ermöglichen vorteilhaft das Erhalten der optischen Eigenschaften, insbesondere der Transparenz des unstrukturierten Substrats, da die eingebrachten periodischen Punktstrukturen aufgrund der geringen Strukturtiefe nicht "störend" wirken. Dabei weicht die Transparenz des strukturierten Substrats gegenüber dem unstrukturierten Substrat gleichen Aufbaus um maximal 10 %, vorzugsweise um maximal 5 % oder 2 %, ab, wobei die Transparenz des strukturierten Substrates bevorzugt geringer ist als die des unstrukturierten Substrates gleichen Materials und Aufbaus. Insbesondere sind diese geringen Strukturtiefen durch eine Einfachbestrahlung mittels eines Laserpulses mit einer geringen Laserpulsenergie erzeugbar. Alternativ können geringe Strukturtiefen auch mittels Mehrfachbestrahlung mit angepassten Parametern, insbesondere Pulsenergien und Pulsdauern generiert werden. Die Grundfläche der inversen Zapfen beträgt vorzugsweise 10 % bis 40 % der Interferenzperiode der Punktstruktur, vorzugsweise eine erste Punktstruktur, bevorzugt eine erste periodische Punktstruktur.

Nach einer besonders bevorzugten Ausgestaltung der Erfindung weist das erfindungsgemäß strukturierte Substrat zumindest eine erste periodische Punktstruktur mit einer Interferenzperiode mit Abmessungen im Mikro- und/oder Submikrometerbereich auf, wobei die Interferenzperiode im Bereich von 50 nm bis 2 µm, bevorzugt im Bereich von 100 nm bis 700 nm, besonders bevorzugt im Bereich von 100 nm bis 500 nm, ganz besonders bevorzugt im Bereich von 100 nm bis 300 nm, oder im Bereich von 9,5 µm bis 50 µm, bevorzugt im Bereich von 10 µm bis 40 µm, besonders bevorzugt im Bereich von 12 µm bis 35 µm, ganz besonders bevorzugt 15 µm bis 30 µm liegt. Die Erfinder haben herausgefunden, dass durch diese Auswahl der erzeugten Interferenzperioden der Punktstruktur, vorzugsweise eine erste Punktstruktur, bevorzugt eine erste periodische Punktstruktur, Effekte an der Oberfläche des Substrats verhindert werden, welche die Transparenz des Substrats beeinträchtigen. Insbesondere hat sich gezeigt, dass für periodische Strukturen mit Interferenzperioden oberhalb von 500 nm und bis zu 5 µm, insbesondere im Bereich von 500 nm bis 1 µm Beugungseffekte an der Oberfläche des Substrats auftreten. Diese Effekte sind auf die Beugung von einfallender elektromagnetischer Strahlung mit Wellenlängen im Bereich des sichtbaren Lichts zurückzuführen. Sie verleihen der Oberfläche des Substrats einen regenbogenartigen Lichtschimmer, welcher die Transparenz reduziert und ablenkend wirkt. Daher ist zum Vermeiden eines solchen Effekts die Interferenzperiode der periodischen Punktstruktur, vorzugsweise der ersten periodischen Punktstruktur, derart gewählt, dass der genannte Bereich ausgespart ist. Vorteilhaft ist somit gewährleistet, dass die Transparenz des Substrats nach der Strukturierung erhalten bleibt.

Die Erfinder haben zudem herausgefunden, dass die Zuverlässigkeit einer Anti-Fogging-Verglasung mit der Wiederholbarkeit des erzeugbaren Wasserkontaktwinkels zusammenhängt. Der Wasserkontaktwinkel ist, wie hierin definiert, ein Maß zur Hydrophilie des strukturierten Substrats. Je kleiner der Wasserkontaktwinkel, desto hydrophiler das Substrat. Dabei sind aus dem Stand der Technik Untersuchungen bekannt, die zu dem Ergebnis kamen, dass der Wasserkontaktwinkel durch das Aufbringen von periodischen Punktstrukturen, vorzugsweise ersten periodischen Punktstrukturen, mit Interferenzperioden im Bereich von 2,5 µm bis 9 µm die hydrophilen Eigenschaften eines Substrats erhöhen, insbesondere dadurch, dass sie den Wasserkontaktwinkel verkleinern. Die Untersuchungen legen nahe, dass der Wasserkontaktwinkel für kleinere Interferenzperioden reproduzierbarer ist. Reproduzierbar bedeutet im Sinne der Erfindung, dass derselbe Wert für den Wasserkontaktwinkel für verschiedene Substrate mit einer unterschiedlichen oder derselben Oberflächenrauigkeit vor der Strukturierung erreicht werden kann. Die Erfinder haben jedoch herausgefunden, dass der Wasserkontaktwinkel sowohl für Interferenzperioden unterhalb von 2 µm, insbesondere 50 nm bis 2 µm, als auch für große Interferenzperioden oberhalb von 9,5 µm, insbesondere 10 µm bis 50 µm besonders zuverlässig reproduzierbar ist. Vorteilhaft ist die Interferenzperiode der ersten periodischen Punktstruktur daher im Bereich von 50 nm bis 2 µm, oder 9,5 µm bis 50 µm gewählt, sodass eine höhere Reproduzierbarkeit des Wasserkontaktwinkels erzielbar ist.

Nach einer bevorzugten Ausgestaltung der Erfindung liegt die Interferenzperiode der ersten periodischen Punktstruktur im Bereich von 9,5 µm bis 50 µm, bevorzugt 10 µm bis 30 µm, besonders bevorzugt 12 µm bis 30 µm. Vorteilhaft können somit insbesondere auf rauen und/oder gewölbten Substratoberflächen besonders zuverlässig reproduzierbare periodische Punktstrukturen mit reproduzierbaren Wasserkontaktwinkeln hergestellt werden.

Nach einer weiteren Ausgestaltung der Erfindung liegt die Interferenzperiode der ersten periodischen Punktstruktur im Bereich von 50 nm bis 2 µm, bevorzugt von 100 nm bis 1 µm, besonders bevorzugt im Bereich von 100 nm bis 700 nm, ganz besonders bevorzugt im Bereich von 100 nm bis 500 nm. Die Erfinder haben herausgefunden, dass sich bei Interferenzperioden unterhalb vom 2 µm antibakterielle Eigenschaften auf der Oberfläche eines Substrats nachweisen lassen. Vorteilhaft weist ein so strukturiertes Substrat zusätzlich zu ausgeprägten Anti-Fogging-Eigenschaften also auch antibakterielle, also auch antiseptische, Eigenschaften auf.

Die Aufgabe wird auch durch ein strukturiertes Substrat mit Anti-Fogging-Eigenschaften gelöst, welches eine Punktstruktur, bevorzugt periodische Punktstruktur, aufweist, wobei die Punktstruktur aus sich überlagernden Strukturen, auch **hierarchischen Strukturen,** besteht, aufweisend zumindest eine erste Struktur mit einer Interferenzperiode im Mikro- und/oder Submikrometerbereich und eine zweite Struktur mit einer Interferenzperiode im Mikro- und/oder Submikrometerbereich, wobei die erste Struktur Interferenzperioden aufweist und wobei die Interferenzperioden deutlich größer sein können als die der zweiten Struktur, insbesondere der Linienstruktur oder Punktstruktur, und wobei zumindest eine Struktur aus inversen Zapfen (wie hierin definiert) gebildet ist, welche insbesondere durch interferierende Laserstrahlen erzeugbar sind. Bevorzugt weist die zweite Struktur Interferenzperioden mit Abmessungen im Bereich von 1 % bis 30 %, insbesondere von 5 % bis 20 %, bevorzugt von 5 % bis 15 % der Abmessungen der Interferenzperiode der ersten Punktstruktur, vorzugsweise der ersten periodischen Punktstruktur, auf.

Vorteilhaft können durch solche hierarchischen Strukturen die Anti-Fogging-Eigenschaften eines Substrats zusätzlich verstärkt werden, da ein höherer Grad an Hydrophilie erreicht werden kann. Dieser ist darauf zurückzuführen, dass hierarchische Strukturen im Vergleich zu herkömmlichen Strukturierungen im Mikro- oder Submikrometerbereich eine deutliche Erhöhung der Oberflächenrauigkeit erzielen.

Vorzugsweise liegt die Interferenzperiode der ersten Struktur, insbesondere der ersten periodischen Punktstruktur, im Bereich von 50 nm bis 2 µm, bevorzugt im Bereich von 100 nm bis 1 µm, besonders bevorzugt im Bereich von 100 nm bis 700 nm, ganz besonders bevorzugt im Bereich von 200 nm bis 500 nm. So können vorteilhaft die Beugungseffekte im sichtbaren Bereich derart reduziert werden, dass ein regenbogenartiger Schimmer der Oberfläche verhindert wird.

Nach einer weiteren Ausgestaltung liegt die Interferenzperiode der ersten Struktur, insbesondere ersten periodischen Punktstruktur, im Bereich von 9,5 µm bis 50 µm, besonders bevorzugt im Bereich von 10 µm bis 40 µm oder 12 µm bis 40µm, ganz besonders bevorzugt im Bereich von 15 µm bis 30 µm.

Beispielsweise lässt sich die periodische Punktstruktur, insbesondere die Punktstruktur aus sich überlagernden Strukturen bei dem Einsatz von interferierenden Laserstrahlen durch entsprechende Ausgestaltung der Parameter (Auswahl der Laserstrahlungsquelle, Anordnung der optischen Elemente, Pulsdauer und -intensität, Anzahl der Laserpulse, welche auf ein Interferenzpixel treffen) an die Anforderungen der jeweiligen Anwendung optimal anpassen.

Beispielsweise handelt es sich bei einer so erzeugten Struktur mit Anti-Fogging-Eigenschaften um eine Punktstruktur, vorzugsweise periodische Punktstruktur, aus inversen Zapfen mit mittleren Abmessungen im Mikrometerbereich, insbesondere mit einem mittleren Abstand bezogen auf deren jeweiligen Sattelpunkt bzw. Höhenmittelpunkt von 9,5 µm bis 50 µm. Der ersten periodischen Punktstruktur ist eine weitere Struktur überlagert, wobei die mittlere Abmessung der überlagernden Struktur bevorzugt Abmessungen im Bereich von 50 nm bis 2°µm aufweist. Im Sinne der Erfindung wird eine solche Struktur auch als hierarchische Struktur bezeichnet.

Nach einer weiteren Ausgestaltung weist die sich überlagernde Struktur eine quasi-periodische Linienstruktur auf, wobei die Linienstruktur als Wellenstruktur ausgeprägt ist, wobei das Material auf der Oberfläche des Substrats im Bereich der sich überlagernden Struktur eine Abfolge von Wellenbergen und Wellentälern aufweist, deren Interferenzperiode im Submikrometerbereich, bevorzugt im Bereich von 100 nm bis 700 nm, besonders bevorzugt im Bereich von 100 nm bis 500 nm, ganz besonders bevorzugt im Bereich von 100 nm bis 300 nm liegt. Im Sinne der Erfindung bezieht sich der Begriff quasi-periodisch auf sich regelmäßig wiederholende Strukturmerkmale, welche allerdings im Gegensatz zu einer echt periodischen Struktur Abweichungen in der Interferenzperiode aufweisen, wobei diese Abweichungen jedoch in einem Bereich deutlich kleiner als die Abmessungen der Strukturmerkmale, bevorzugt im Bereich von 1 % bis 5 % der Abmessungen der Strukturmerkmale liegen. Auch Defekte in der Strukturuniformität, d.h. ein fehlender Wellenberg oder ein fehlendes Wellental sind möglich.

Die Wellenstruktur wird während des Strukturierungsprozesses, d.h. beim Auftreffen von Laserpulsen, insbesondere infolge einer Mehrfachbestrahlung, in das zu strukturierende Substrat als Folge des Auftretens eines Bereiches hoher Intensität ausgebildet, wobei die Strukturierung durch einen Selbstorganisationsprozess erfolgt, welcher durch das zumindest teilweise Aufschmelzen des Substratmaterials mittels Laserpulsen in einem Bereich hoher Intensität angeregt wird. Insbesondere wird die Wellenstruktur unter Ausnutzen von laser-induzierten periodischen Oberflächenstrukturen (engl. Laser-induced Periodic Surface Structures - LIPSS) erzeugt, wobei das Auftreten dieser Oberflächenstrukturen an das Erzeugen der Punktstrukturen, vorzugsweise der ersten periodischen Punktstrukturen, mittels interferierender Laserstrahlen gekoppelt ist. Das bedeutet insbesondere, dass die quasi-periodischen Wellenstrukturen lediglich in den Bereichen der Intensitätsmaxima innerhalb eines Interferenzpixels auftreten, insbesondere innerhalb der inversen Zapfen der ersten periodischen Punktstruktur. Der Anteil der in den Intensitätsminima auftretenden unstrukturierten Bereiche bleibt in Bezug auf eine Strukturierung mittels einer einfachen periodischen Punktstruktur, vorzugsweise ersten periodischen Punktstruktur gleich.

Nach einer Ausgestaltung werden die hierarchischen Strukturen durch Mehrfachbestrahlung desselben Interferenzpixels mit identischen Verfahrensparametern erzeugt, wobei die Verfahrensparameter die Pulsenergie, Pulsdauer und/oder die Anordnung von optischen Elementen betrifft. Vorteilhaft ist so eine Strukturierung möglich, welche eine geringe Intensität der einfallenden Laser(teil-)strahlen benötigt, wodurch die optischen Elemente, die Teil der zur Strukturierung verwendeten Laserstrukturierungsvorrichtung sind, geschont werden.

Nach einer weiteren Ausgestaltung werden die hierarchischen Strukturen durch Einfachbestrahlung desselben Interferenzpixels mittels Laser(teil-)strahlen mit hoher Intensität erzeugt. Vorteilhaft ist somit eine flächige Strukturierung eines Substrats, bspw. mit Anti-Fogging-Eigenschaften, durch interferierende Laserstrahlen und unter Ausnutzen von laser-induzierten periodischen Oberflächenstrukturen möglich, ohne eine lange Bearbeitungszeit oder eine hohe Anzahl an sukzessiv ausführbaren Prozessschritten in Kauf zu nehmen. Die Erfindung ermöglicht somit ein simultanes Erzeugen von hierarchischen Strukturen, welche im technischen Bereich sowohl im Bereich von Substraten mit Anti-Fogging-Eigenschaften, als auch im Bereich von selbstreinigenden, hydrophoben oder superhydrophoben oder hydrophilen oder superhydrophilen Substraten, optional auch mit anti-icing und/oder Antireflexionseigenschaften, einsetzbar sind.

Nachteilig kann ein vorgegebener Wasserkontaktwinkel aufgrund der Selbstorganisationsprozesse und der damit einhergehenden Unsicherheiten weniger gut reproduziert werden. Um dennoch einen zuverlässigen Prozess zu gewährleisten, bei dem eine hohe Reproduzierbarkeit des Wasserkontaktwinkels erreicht wird, haben die Erfinder festgestellt, dass bestimmte Interferenzperioden geeignet sind, eine zuverlässige und reproduzierbare Einstellung eines gewünschten, vorzugsweise möglichst kleinen, Wasserkontaktwinkels zu erreichen. Das strukturierte Substrat ist dabei dadurch gekennzeichnet, dass die Interferenzperiode der ersten periodischen Punktstruktur im Bereich von 50 nm bis 2,0 µm und/oder im Bereich von 9,5 µm bis 50 µm liegt.

Nach einer weiteren Ausgestaltung werden die hierarchischen Strukturen durch Mehrfachbestrahlung des Substrats mit abweichenden Verfahrensparametern erzeugt, wobei die Verfahrensparameter insbesondere derart abweichen, dass eine zweite periodische Struktur mit abweichender Interferenzperiode erzeugt wird. Dabei handelt es sich bei der zweiten periodischen Struktur um eine Linienstruktur oder eine Punktstruktur, bevorzugt um eine Punktstruktur. Eine Linienstruktur bezeichnet dabei im Sinne der Erfindung eine sog. 1D-Struktur, die aus parallel angeordneten Strukturbergen und Strukturtälern besteht, welche in regelmäßiger Abfolge zu je einem Berg und einem Tal angeordnet sind. Die zweite periodische Struktur wird in dieser Ausgestaltung analog zur ersten periodischen Punktstruktur durch direkte Laserinterferenzstrukturierung erzeugt. Die Interferenzperiode der zweiten periodischen Struktur ist dabei durch die Verfahrensparameter einstellbar. Das Erzeugen der zweiten periodischen Struktur ist dabei nicht an das Erzeugen der ersten periodischen Struktur gekoppelt. Daher weist ein derart strukturiertes Substrat im Vergleich zu einem lediglich mit einer ersten periodischen Punktstruktur strukturierten Substrat einen geringeren Anteil an nicht strukturierter Oberfläche auf, da der nach dem Erzeugen der ersten periodischen Punktstruktur verbleibende unstrukturierte Bereich beim Erzeugen der zweiten periodischen Struktur mit geringeren Interferenzperioden teilweise strukturiert werden.

In einer bevorzugten Ausgestaltung weist die erste periodische Punktstruktur, des erfindungsgemäßen strukturierten Bereiches, insbesondere eines strukturierten Bereiches der durch eine erste periodische Punktstruktur im Mikro- oder Submikrometerbereich mit einer ersten Interferenzperiode im Bereich von 50 nm bis 50 µm gebildet wird, oder eines strukturierten Bereiches, der eine erste periodische Punktstruktur im Mikro- oder Submikrometerbereich mit einer ersten Interferenzperiode im Bereich von 50 nm bis 2,0 µm aufweist oder eines strukturierten Bereiches, der eine erste periodische Punktstruktur im Mikro- oder Submikrometerbereich mit einer ersten Interferenzperiode im Bereich von 9,5 µm bis 50 µm aufweist, dabei Abmessungen auf, welche deutlich größer sind, zumindest 10% bis 30% größer sind, als die sich auf ihr ablagernden Bakterien. Dadurch werden die sich auf der Oberfläche ablagernden Bakterien isoliert und somit unschädlich gemacht. Eine Zellteilung der Bakterien innerhalb der Punktstrukturen und ein damit einhergehendes Herauswachsen der Bakterien aus den Punktstrukturen wird aufgrund der Abmessungen unterbunden. In einer besonders bevorzugten Ausgestaltung weist die periodische Punktstruktur, vorzugsweise die erste periodische Punktstruktur, dabei Abmessungen auf, welche deutlich kleiner sind, zumindest 10% bis 30% kleiner sind, als die sich auf ihr ablagernden Bakterien. Dadurch ist ein Anhaften der Bakterien auf der Oberfläche nicht möglich und die Oberfläche wird somit steril gehalten.

Nach einer weiteren Ausgestaltung der Erfindung weist das erfindungsgemäße strukturierte Substrat mit einer Oberfläche mit einem erfindungsgemäß strukturierten Bereich, der durch eine erste periodische Punktstruktur im Mikro- oder Submikrometerbereich mit einer ersten Interferenzperiode im Bereich von 50 nm bis 50 µm gebildet wird, oder aus einem strukturierten Bereich, der eine erste periodische Punktstruktur im Mikro- oder Submikrometerbereich mit einer ersten Interferenzperiode im Bereich von 50 nm bis 2,0 µm aufweist oder aus einem strukturierten Bereich, der eine erste periodische Punktstruktur im Mikro- oder Submikrometerbereich mit einer ersten Interferenzperiode im Bereich von 9,5 µm bis 50 µm aufweist, eine periodische Punktstruktur, vorzugsweise eine erste periodische Punktstruktur, auf, welche aus Zapfen ausgebildet ist. Die Struktureigenschaften, wie die Interferenzperiode und die hydrophilen Eigenschaften, insbesondere der Wasserkontaktwinkel, der sich bei Benetzung auf der Oberfläche des Substrats ausbildet sind dabei identisch zu den hierin definierten Eigenschaften eines strukturierten Substrats welches eine periodische Punktstruktur, vorzugsweise eine erste periodische Punktstruktur, aufweist, wobei die Punktstruktur, vorzugsweise die erste periodische Punktstruktur, aus inversen Zapfen ausgebildet ist. Folglich gilt das für inverse Zapfen erläuterte auch für die Strukturen, die aus Zapfen ausgebildet sind. Die so erzeugte periodische Punktstruktur, vorzugsweise eine erste periodische Punktstruktur, aufweisend regelmäßig zueinander angeordnete Zapfen, ist zum Erzeugen eines Substrats mit Anti-Fogging-Eigenschaften also genauso geeignet wie die hierin definierte periodische Punktstruktur, vorzugsweise eine erste periodische Punktstruktur, aufweisend inverse Zapfen. Die Struktureigenschaften sind dabei unverändert.

In einer Ausgestaltung der Erfindung eignet sich das hierin offenbarte Verfahren und die hierin offenbarte Vorrichtung zum Erzeugen eines Substrates, das eine periodische Punktstruktur im Mikro- und/oder Submikrometerbereich, vorzugsweise eine erste periodische Punktstruktur, welche mittels Laserinterferenzstrukturierung erzeugt wurde, umfasst, welches eine erhöhte Oberflächenrauigkeit aufweist. Dabei basiert die erhöhte Oberflächenrauigkeit darauf, dass die Oberflächentextur durch die in das Substrat eingebrachte periodische Punktstruktur im Mikro- und/oder Submikrometerbereich, vorzugsweise eine erste periodische Punktstruktur, verändert ist, insbesondere darauf, dass die Oberfläche des Substrats durch die eingebrachte periodische Punktstruktur, vorzugsweise eine erste periodische Punktstruktur, Erhöhungen oder Vertiefungen aufweist. Insbesondere kann eine erhöhte Oberflächenrauigkeit erzielt werden, indem ein Substrat mittels des hierin beschriebenen Verfahrens und der hierin beschriebenen Vorrichtung ohne hierarchische Strukturen mittels Einfachbestrahlung, wobei der strukturierte Bereich vorzugsweise aus genau einer ersten Punktstruktur gebildet ist, oder mit hierarchischen Strukturen mit Abmessungen im Mikro- und/oder Submikrometer Bereich mittels Laserinterferenzstrukturierung durch eine Mehrfachbestrahlung desselben Interferenzpixels und/oder ein Aufbringen einer weiteren periodischen Struktur mittels direkter Laserinterferenzstrukturierung strukturiert wird. Ein so bearbeitetes Substrat ist vorteilhaft im Bereich der Fertigung einsetzbar, um bspw. die Haftreibung und/oder Gleitreibung zwischen technischen Komponenten zu erhöhen, oder in der Medizintechnik, um die Adhäsion von Zellen auf einer Fremdoberfläche zu erhöhen.

### Interferenzbereich, bzw. Interferenzpixel

Das erfindungsgemäße Substrat weist eine erste **periodische Punktstruktur** im Mikro- und/oder Submikrometerbereich auf, wobei die erste periodische Punktstruktur durch in einem Interferenzbereich interferierende Laserstrahlen erzeugbar ist. Der Interferenzbereich ist durch innerhalb seiner räumlichen Ausdehnung auftretende, alternierende Strahlungsintensitätsmaxima und -minima gekennzeichnet. Diese Maxima und Minima treten mit einer periodischen, d.h. sich wiederholenden Regelmäßigkeit auf und bilden somit ein Interferenzmuster, welches auf das Substrat übertragbar ist. Der Interferenzbereich, innerhalb dessen dieses Muster erkennbar ist, wird auch als Interferenzpixel bezeichnet. Die Ausdehnung des Interferenzpixel ist typischerweise kreisförmig, aber auch andere geometrische Ausdehnungen, bspw. ellipsenförmige oder linienförmige Ausdehnungen sind denkbar. Der Interferenzbereich, innerhalb dessen das Interferenzmuster erkennbar ist, ist dabei physikalisch durch die Intensitätsschwelle des zu bearbeitenden Substrats festgelegt. Die Intensitätsschwelle bezeichnet die Energie, bei welcher das Material des Substrats mit den einfallenden Laserstrahlen wechselwirkt, sodass eine Veränderung innerhalb des Materials, bspw. Aufschmelzen, bzw. Abtragen des Materials stattfindet. Dabei nimmt die an den Maxima des Interferenzmusters auftretende Energie der interferierenden Laserstrahlen zum Rand des Interferenzbereiches hin ab, sodass der auf dem Substrat aufgebrachte Interferenzpixel in seiner Ausmessung kleiner ist als der Interferenzbereich, wobei die genaue Größe durch die Eigenschaften der Laserstrahlungsquelle und des Substrats vorgegeben wird.

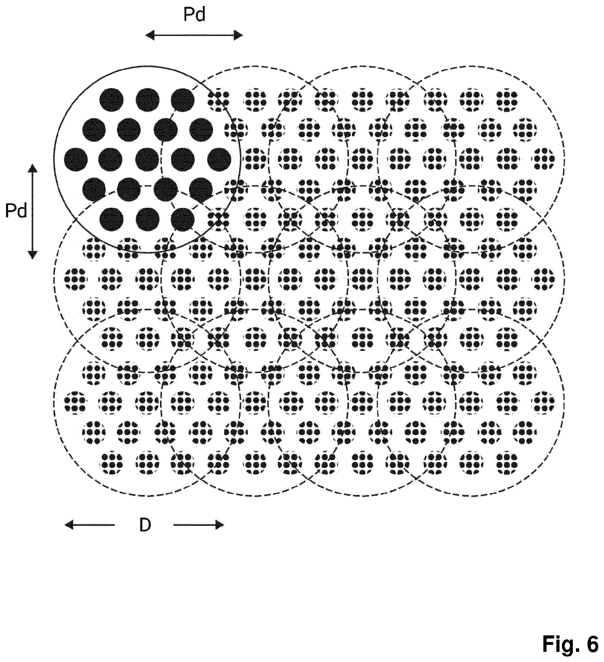

Der Begriff Interferenzpixel, bspw. erstes, zweites, drittes und/oder weiteres Interferenzpixel bezeichnet im Sinne der vorliegenden Erfindung somit ein periodisches Muster bzw. Gitter von zumindest drei inversen Zapfen, vorzugsweise von zumindest sieben inversen Zapfen, ganz besonders bevorzugt zumindest 19 inversen Zapfen auf der Oberfläche eines Substrates, die sich innerhalb eines Interferenzpixels ausbilden (vgl. Fig. 6). Vorzugsweise wird das periodische Muster bzw. Gitter durch das Überlagern von zumindest drei, besonders bevorzugt von zumindest vier Laser(teil-)strahlen infolge des Fokussierens (Bündelns) dieser Laser(teil-)strahlen auf die Oberfläche oder in das Innere des Substrats erzeugt, wodurch die Teilstrahlen auf der Oberfläche oder im Inneren des Substrats konstruktiv und destruktiv interferieren.

Vorzugsweise weisen die periodischen Punktstrukturen, vorzugsweise ersten periodischen Punktstrukturen, innerhalb einer Art eines Interferenzpixels einen Variationskoeffizienten (ein Wert, der sich aus der Teilung der Standardabweichung durch den Durchschnittswert ergibt) des Zapfenquerschnitts von 15% oder weniger, mehr bevorzugt 10% oder weniger, noch mehr bevorzugt 5% oder weniger auf. Dies erlaubt zudem eine bessere Nachweisbarkeit des erfindungsgemäß strukturierten Substrates gegenüber herkömmlichen Verfahren zur Strukturierung/Beschichtung von Substraten (bspw. Ätzen, Partikelstrahlen, Polymerbeschichtung), bei welchen die Abweichungen Prozessbedingt größer ausfallen und die zu erzeugende Interferenzperiode weniger genau abgebildet wird.

Die erste periodische Punktstruktur und/oder eine zweite periodische Punktstruktur ist dabei vorzugsweise derart ausgebildet, dass das strukturierte Substrat bei einer ersten periodischen Punktstruktur von weniger als 1.000 nm elektromagnetische Strahlung mit einer Wellenlänge von mehr als 550 nm, bevorzugt bei einer ersten periodischen Punktstruktur von weniger als 750 nm von mehr als 500 nm, ganz besonders bevorzugt bei einer ersten periodischen Punktstruktur von weniger als 600 nm von mehr als 450 nm transmittiert. In Abhängigkeit der Strukturtiefe der inversen Zapfen können somit insbesondere Wellenlängen im roten und/oder gelben Lichtspektrum, im grünen Lichtspektrum bis hin ins blaue Lichtspektrum in das Substrat transmittieren.

Der Brechungsindex des strukturierten Substrats ist durch die erzeugte periodische Punktstruktur, vorzugsweise erste periodische Punktstruktur, graduell. Er nimmt über die Höhe der Struktur hinweg ab, sodass kein klarer Luft-Medium Übergang existiert. Dadurch kommt es zur erhöhten Transmission von einfallenden elektromagnetischen Wellen mit einer Wellenlänge größer als die Interferenzperiode der erzeugten Punktstruktur, und zur Beugung von einfallenden elektromagnetischen Wellen mit einer Wellenlänge im Bereich der Interferenzperiode der erzeugten Punktstruktur.

Zum Erzeugen eines Substrates mit hydrophilen Eigenschaften ist es ebenfalls denkbar, dass lediglich eine Struktur mit Abmessungen im Mikro- oder Submikrometerbereich erzeugt wird, ohne dass das Strahlteilerelement in einem Zwischenschritt bewegt wird.

Vorteilhaft können somit mittels desselben Verfahrens und auf Basis derselben Vorrichtung in technisch leicht realisierbarer Art und Weise Substrate mit hydrophilen und/oder superhydrophilen Eigenschaften erzeugt werden, indem eine periodische Punktstruktur, vorzugsweise erste periodische Punktstruktur, im Mikro- oder Submikrometerbereich und/oder eine Punktstruktur, vorzugsweise periodische Punktstruktur, mit hierarchischer Struktur im Mikro- und Submikrometerbereich erzeugt wird. Durch das Verschieben des Strahlteilerelements ist eine zumindest zweifache, aber auch eine beliebige Anzahl an weiterer Strukturierung auf der Oberfläche des Substrates ohne weitere Veränderung des Aufbaus, bspw. ohne den Austausch von optischen Elementen oder Verschieben des Substrats, realisierbar. Dadurch ist sowohl die Präzision in der Ausrichtung der Strukturen, als auch die Geschwindigkeit des Prozesses gesteigert gegenüber herkömmlichen Verfahren oder Vorrichtungen.

Die Erfinder haben einen Zusammenhang zwischen der Oberflächenbeschaffenheit eines Substrats und der Bildung von Kondenswasser, insbesondere in Form von Beschlag oder Nebel, an dessen Oberfläche festgestellt. Insbesondere können demgemäß sog. Anti-Fogging Eigenschaften erzeugt werden, wenn die Strukturgröße an der Oberfläche eines Substrates hinreichend klein ist. Forschungsergebnisse haben gezeigt, dass ein Substrat mit superhydrophilen Eigenschaften auch Anti-Fogging Eigenschaften aufweisen kann.

Ein solches Substrat kann vorteilhaft im Bereich der Luft- und Raumfahrt, im Bereich von Automobilkomponenten oder auch Telekommunikations- und Antennentechnik verwendet werden, um exponierte Bestandteile vor dem Beschlagen zu schützen.

In einer Ausgestaltung der Erfindung eignet sich das hierin offenbarte Verfahren und die hierin offenbarte Vorrichtung zum Erzeugen eines Substrates, das eine Punktstruktur, vorzugsweise periodische Punktstruktur, insbesondere eine erste und/ oder zweite periodische Punktstruktur, im Mikro- oder Submikrometerbereich, welche mittels Laserinterferenzstrukturierung erzeugt wurde, aufweist, und welches sich zusätzlich durch Antireflexionseigenschaften auszeichnet. Im Sinne der Erfindung beziehen sich Antireflexionseigenschaften hierin auf das vermehrte Transmittieren, bzw. Beugen von einfallender elektromagnetischer Strahlung mit Wellenlängen im Bereich des sichtbaren Lichts, insbesondere mit Wellenlängen im Bereich von 400 nm bis 700 nm. Dabei zeichnet sich das Substrat dadurch aus, dass die von ihm umfasste erste und/ oder zweite periodische Punktstruktur vorzugsweise Abmessungen im Submikrometerbereich, besonders bevorzugt im Nanometerbereich aufweist. Ganz besonders bevorzugt sind die Abmessungen der periodischen Punktstruktur, vorzugsweise ersten periodischen Punktstruktur, im Bereich der Wellenlänge von elektromagnetischer Strahlung im Bereich des sichtbaren Lichts. So sind die Abmessungen der periodischen Punktstruktur, vorzugsweise ersten periodischen Punktstruktur, bevorzugt im Bereich von 630 nm bis 700 nm zum Transmittieren, bzw. Beugen von rotem Licht, im Bereich von 590 nm bis 630 nm zum Transmittieren, bzw. Beugen von rotem und orangenem Licht, im Bereich von 560 nm bis 590 nm zum Transmittieren, bzw. Beugen von rotem, orangenem und gelben Licht, im Bereich von 500 nm bis 560 nm zum Transmittieren, bzw. Beugen von rotem, orangenem, gelbem und grünem Licht, im Bereich von 475 nm bis 500 nm zum Transmittieren, bzw. Beugen von rotem, orangenem, gelbem, grünem und türkisem Licht, im Bereich von 450 nm bis 475 nm zum Transmittieren, bzw. Beugen von rotem, orangenem, gelbem, grünem, türkisem und blauem Licht, im Bereich von 425 nm bis 450 nm zum Transmittieren, bzw. Beugen von rotem, orangenem, gelbem, grünem, türkisem, blauem und indigofarbenem Licht, im Bereich von 400 nm bis 425 nm zum Transmittieren, bzw. Beugen von rotem, orangenem, gelbem, grünem, türkisem, blauem, indigofarbenem und violettem Licht. Somit lassen sich durch das Verändern der Abmessungen der periodischen Punktstruktur, vorzugsweise der ersten periodischen Punktstruktur, die Antireflexionseigenschaften des Substrats kontrollieren.

In einer Ausgestaltung der Erfindung eignet sich das hierin offenbarte Verfahren und die hierin offenbarte Vorrichtung zum Erzeugen eines Substrates, das eine periodische Punktstruktur, vorzugsweise eine erste Punktstruktur, im Mikro- oder Submikrometerbereich, welche mittels Laserinterferenzstrukturierung erzeugt wurde, umfasst und welches sich zusätzlich durch Antireflexionseigenschaften auszeichnet. Im Sinne der Erfindung beziehen sich Antireflexionseigenschaften hierin auf das vermehrte Transmittieren, bzw. Beugen von einfallender elektromagnetischer Strahlung mit Wellenlängen im Bereich des nicht sichtbaren Lichts, insbesondere im Bereich von Infrarotstrahlung, bzw. Wärmestrahlung, insbesondere mit Wellenlängen im Bereich von 780 nm bis 1 mm. Dabei zeichnet sich das Substrat dadurch aus, dass die von ihm umfasste periodische Punktstruktur, vorzugsweise erste periodische Punktstruktur, vorzugsweise Abmessungen im Mikrometerbereich aufweist. Vorteilhaft ist so die Wärmetransmission des Substrats durch Verändern der Abmessungen der periodischen Punktstruktur, vorzugsweise der ersten periodischen Punktstruktur, anpassbar.

In einer Ausgestaltung der Erfindung eignet sich das hierin offenbarte Verfahren und die hierin offenbarte Vorrichtung zum Erzeugen eines Substrates, das eine periodische Punktstruktur, vorzugsweise eine erste periodische Punktstruktur, im Mikro- oder Submikrometerbereich, welche mittels Laserinterferenzstrukturierung erzeugt wurde, umfasst und welches sich durch Antireflexionseigenschaften auszeichnet. Im Sinne der Erfindung beziehen sich Antireflexionseigenschaften hierin auf das vermehrte Transmittieren, bzw. Beugen von einfallender elektromagnetischer Strahlung mit Wellenlängen im Bereich des nicht sichtbaren Lichts, insbesondere im Bereich von Ultraviolettstrahlung (UV-Strahlung), insbesondere mit Wellenlängen im Bereich von 100 nm bis 380 nm. Dabei zeichnet sich das Substrat dadurch aus, dass die von ihm umfasste periodische Punktstruktur, vorzugsweise erste periodische Punktstruktur, vorzugsweise Abmessungen im Nanometerbereich aufweist. Vorteilhaft ist ein so strukturiertes Substrat in Bereichen einsetzbar, in denen ein Schutz vor UV-Strahlung notwendig ist.

In einer weiteren Ausgestaltung der Erfindung eignet sich das hierin offenbarte Verfahren und die hierin offenbarte Vorrichtung zum Erzeugen eines Substrates, welches hierarchische Strukturen, welche mittels Laserinterferenzstrukturierung durch eine Mehrfachbestrahlung desselben Interferenzpixels erzeugt wurden, aufweist, welche sich durch hydrophile oder superhydrophile Eigenschaften auszeichnen. Dabei sind die hydrophilen oder superhydrophilen Eigenschaften darauf zurückzuführen, dass Strukturen mit Abmessungen im Mikro- oder Submikrometerbereich, insbesondere hierarchische Strukturen mit Abmessungen im Mikro- und Submikrometerbereich den Wasserkontaktwinkel, auch Benetzungswinkel, von Flüssigkeiten auf Substraten derart verändern, dass dieser kleiner wird. Durch einen kleineren Wasserkontaktwinkel ergibt sich, dass auf die Oberfläche auftreffende Flüssigkeiten diese sehr gut benetzen und es zu keiner Tropfenbildung kommt. Stattdessen wird ein uniformes Benetzen der Oberfläche herbeigeführt, welches die Transparenz des Substrates nicht beeinträchtigt. Besonders geeignete Materialien für ein solches strukturiertes Substrat sind solche Materialien, welche bereits hydrophile Eigenschaften aufweisen, z.B. Glasoberflächen. Es ist also ein Substrat besonders geeignet, welches ein Material aufweist, das hydrophil ausgebildet ist, wobei eine unstrukturierte Oberfläche des Materials einen Wasserkontaktwinkel von kleiner als 90°, vorzugsweise kleiner als 80°, aufweist. Dadurch entsteht effizient ein strukturiertes Substrat mit einer strukturierten Oberfläche mit superhydrophilen Eigenschaften, welches bevorzugt einen Wasserkontaktwinkel von kleiner als 20° aufweist. In einer Ausgestaltung der Erfindung eignet sich das hierin offenbarte Verfahren und die hierin offenbarte Vorrichtung zum Erzeugen eines Substrates, das eine periodische Punktstruktur im Mikro- oder Submikrometerbereich, vorzugsweise eine erste periodische Punktstruktur, welche mittels Laserinterferenzstrukturierung erzeugt wurde, umfasst, welches eine erhöhte Oberfläche im Vergleich zu einem unstrukturierten Substrat mit gleichen Außenabmessungen aufweist. Dabei trägt die periodische Punktstruktur im Mikro- oder Submikrometerbereich, vorzugsweise eine erste periodische Punktstruktur, dazu bei, dass sich die Oberfläche des Substrats proportional zu der Dichte der Interferenzbereiche pro Interferenzpixel erhöht.

Insbesondere kann eine erhöhte Oberfläche im Vergleich zu einem unstrukturierten Substrat mit gleichen Außenabmessungen erzielt werden, indem ein Substrat mittels des hierin beschriebenen Verfahrens und der hierin beschriebenen Vorrichtung mit hierarchischen Strukturen mit Abmessungen im Mikro- und Submikrometer Bereich mittels Laserinterferenzstrukturierung durch eine Einfachbestrahlung oder eine Mehrfachbestrahlung, vorzugsweise eine Mehrfachbestrahlung, desselben Interferenzpixels strukturiert wird. Ein so bearbeitetes Substrat ist vorteilhaft in technischen Bereichen mit einem Anspruch an einen hohen Wärmetransport einsetzbar, da durch die erhöhte Oberfläche im Vergleich zu einem unstrukturierten Substrat mit gleichen Außenabmessungen eine größere Kapazität zum Wärmetausch bereitgestellt wird. Des Weiteren ist ein so bearbeitetes Substrat im Bereich der elektrischen Verbindungstechnik zum Reduzieren von Kontaktwiderständen einsetzbar, da durch die erhöhte Oberfläche im Vergleich zu einem unstrukturierten Substrat mit gleichen Außenabmessungen mehr Kontaktpunkte zwischen zu kontaktierenden Materialien herstellbar sind. Außerdem ist ein so strukturiertes Substrat im Bereich der Batterietechnik einsetzbar, insbesondere zum Strukturieren der Anode und Kathode, da durch die erhöhte Oberfläche im Vergleich zu einem unstrukturierten Substrat mit gleichen Außenabmessungen mehr Kapazität zum Austausch von Ladungsträgern zwischen dem Metall der Elektroden besteht.

Ein durch das hierin offenbarte Verfahren und die hierin offenbarte Vorrichtung erzeugtes strukturiertes Substrat eignet sich darüber hinaus zum weiteren bearbeiten mittels eines Beschichtungsprozesses, wobei das Substrat eine physikalische und/oder chemische Beschichtung erhalten kann. Durch eine solche Beschichtung können die Eigenschaften des strukturierten Substrats, beispielsweise die Antireflexionseigenschaften und/oder hydrophile und/oder hydrophobe Eigenschaften verstärkt werden. Denkbar ist das Aufbringen einer chemischen Sprühbeschichtung und/oder das Aufbringen einer Beschichtung mittels chemical vapor deposition und/oder Sputtern.

Die Erfindung umfasst somit auch ein strukturiertes Substrat mit einer Beschichtung. Dabei ist auf der strukturierten Oberfläche des strukturierten Substrates eine Beschichtung, vorzugsweise eine Schutzbeschichtung, bevorzugt eine transparente Schutzbeschichtung, angeordnet. Eine solche Beschichtung, vorzugsweise Schutzbeschichtung, bevorzugt transparente Schutzbeschichtung, ist vorzugsweise sehr dünn ausgebildet und weist beispielsweise eine Dicke von 1 nm bis 5 µm auf. Dadurch bleibt die Struktur der strukturierten Oberfläche im Wesentlichen erhalten. Bevorzugt weist die Beschichtung, vorzugsweise Schutzbeschichtung, eine hohe Härte auf, wodurch die Langlebigkeit der strukturierten Oberfläche des strukturierten Substrates erhöht und damit verbessert wird. Relevant ist hier, dass das unterliegende Substrat bereits eine strukturierte Oberfläche aufweist, also nicht nur die Beschichtung strukturiert ist. Durch die Kombination aus einem strukturierten Substrat und einer dünnen darauf angeordneten Beschichtung können durch die Oberflächenveränderung in Kombination mit den Eigenschaften der Materialien besondere Eigenschaften der Oberfläche, insbesondere spezielle Benetzungseigenschaften der resultierenden strukturierten Oberfläche, generiert werden.

Dabei ist die Beschichtung derart an dem Substrat auf der strukturierten Oberfläche angeordnet, dass die erste Punktstruktur in der Beschichtung ausgebildet ist und auch in der an die Beschichtung angrenzenden, unterliegenden Schicht ausgebildet ist.

Durch die Materialwahl der Beschichtung kann der Wasserkontaktwinkel der Oberfläche definiert eingestellt werden. Die Oberflächenspannung wird dabei durch funktionale Endgruppen innerhalb der Beschichtung modifiziert, sodass entweder hydrophile oder hydrophobe Eigenschaften entstehen.

Nach einer vorteilhaften Ausgestaltung weist das Material für die Beschichtung hydrophobe Benetzungseigenschaften auf. Dadurch kann eine super-hydrophobe Eigenschaft auch auf einem darunter liegenden hydrophilen Material, wie beispielsweise Glas, erreicht werden.

Nach einer weiteren vorteilhaften Ausgestaltung weist das Material für die Beschichtung hydrophile Benetzungseigenschaften auf. Dadurch kann eine besonders langlebige und stabile superhydrophile Oberfläche erreicht werden.

Geeignete Materialien für eine hydrophobe Beschichtung sind dabei (Nano-)Beschichtungen auf Siliziumdioxidbasis, Fluorierte Silane und Fluorpolymerbeschichtungen, Manganoxid-Polystyrol (MnO₂/PS)-Nanokomposite, Zinkoxid-Polystyrol (ZnO/PS)-Nanokomposite, Beschichtungen auf Basis von Kalziumkarbonat und auch Kohlenstoff-Nanoröhrenstrukturbeschichtungen, also eine Beschichtung welche Kohlenstoffnanoröhrchen aufweist, bevorzugt transparente Kohlenstoff-Nanoröhrenstrukturbeschichtungen.

Geeignete Materialien für eine hydrophile Beschichtung sind dabei beispielsweise keramische Materialien, wie BeO-basierte, MgO-basierte, TiO₂-basierte, Al₂O₃-basierte, ZrO₂-basierte, ZnO-basierte, SnO-basierte, SiO₂-basierte, Alumosilikat-basierte Beschichtungen, Silikat-basierte Beschichtungen, Spinell-Keramiken, wie Mg-Al-Spinell, Aluminiumoxynitrid (ALON), Yttriumaluminiumgranat, Yttriumoxid-basierte Beschichtungen, Mischoxidkeramiken wie ATZ / ZTA, Siliciumcarbid (SiC), Wolframcarbid (WC), Alumosilikate, (Schicht)Silikatmatierialien sowie Kombinationen davon, Hydrogele / Sol-Gel-Beschichtungen, Polymere auf Acrylatbasis / Acrylamid-Copolymere, Beschichtungen auf Polyurethan-Basis oder auch Polyalkoholdiepoxid.

Vorteilhaft sind Beschichtungen wie Hydrogele, Polymere auf Acrylatbasis sowie Beschichtungen auf Siliziumdioxidbasis und auch Kohlenstoff-Nanoröhrchen bei geringer Dicke, insbesondere bis zu 5 µm, transparent, weisen also eine hohe Transmission auf. Dadurch können strukturierte Substrate mit einer Beschichtung erzeugt werden, welche eine hohe Transmission (wie hierin beschrieben) aufweisen.

Zu den vorteilhaften Modifikationen der Oberfläche gehört die Bereitstellung hydrophober Polymere, wie Alkylketten und/oder Alkylsilan- und/oder fluorierte Alkylketten, die bevorzugt als Polymerbürsten ausgeführt sind. Polymerbürsten im Sinne der vorliegenden Erfindung sind dichte Schichten von Polymerketten, die an eine Oberfläche gebunden oder gepfropft sind, häufig an einem Ende der Ketten. Die Methoden, mit denen Oberflächen modifiziert werden, um chemische Befestigungspunkte für die Ketten zu schaffen, sind dem Fachmann bekannt und umfassen beispielsweise Biokonjugation, radikalische/anionische/katonische Kettenpolymerisation, besonders bevorzugt lebende Kettenpolymerisation und/oder oberflächeninduzierte Polymerisation (SIP). Dadurch lassen sich die Oberflächeneigenschaften wie Benetzbarkeit und Haftung nach Strukturierungs- und Verarbeitungsprozessen nachträglich verbessern. Bevorzugt weisen diese Schichten eine Schichtdicke von 10 bis 250 nm, besonders bevorzugt von 20 bis 150 nm auf. Diese Schichten sind bevorzugt transparent und erlauben es, physikalische Eigenschaften wie die Hydrophobie zu beeinflussen, während die optischen Eigenschaften nicht bzw. kaum beeinflusst werden.

In einer besonders bevorzugten Ausführungsform sind die Beschichtungen vorteilhaft so gestaltet, dass eine Änderung der Bedingungen, wie Temperatur oder pH-Wert, die Oberflächeneigenschaften beeinflusst. So kann die Hydrophobie des Materials gesteuert werden, z. B. durch Erhöhung der Temperatur. Vorteilhaft ermöglicht dies die Steuerung der Benetzbarkeit und Adhäsion.

Schichtdicken können mittels eines Rasterkraftmikroskops (atomic force microscopy, AFM) und/oder durch Ellipsometrie im UV/Vis Bereich bestimmt werden.

### Verfahren

Von der vorliegenden Erfindung ist auch ein Verfahren zur Herstellung eines Substrats, bevorzugt flächigen und/oder transparenten Substrats mit Anti-Fogging-Eigenschaften, aufweisend eine periodische Punktstruktur mit Abmessungen im Mikro- und/oder Submikrometerbereich, vorzugsweise einer ersten periodische Punktstruktur, mittels direkter Laserinterferenzstrukturierung mitumfasst.

Im Sinne der Erfindung umfasst das Verfahren zur Herstellung eines strukturierten Substrats mit Anti-Fogging-Eigenschaften, bevorzugt flächigen und/oder transparenten Substrats, mit einer periodischen Punktstruktur im Mikro- und/oder Submikrometerbereich, vorzugsweise einer ersten periodischen Punktstruktur, mittels Laserinterferenzstrukturierung, die folgenden Schritte:
Es wird ein Substrat (5), bevorzugt flächiges und/oder transparentes Substrat, bereitgestellt, welches sich auf einer Haltevorrichtung befindet. Von einer Laserstrahlungsquelle (1) wird ein Laserstrahl emittiert. Der Laserstrahl wird durch ein Strahlteilerelement (2), das auch als optisches Strahlteilerelement bezeichnet werden kann, und zumindest drei, besonders bevorzugt vier Teilstrahlen geteilt. Die Teilstrahlen treffen auf ein Fokussierelement (4) auf, welches die zumindest drei, besonders bevorzugt vier Teilstrahlen auf der Oberfläche oder im Inneren des Substrats (5), bevorzugt flächigen und/oder transparenten Substrats, fokussiert (bündelt), sodass die Teilstrahlen auf der Oberfläche oder im Inneren des Substrats konstruktiv und destruktiv interferieren. Somit wird eine periodische Punktstruktur im Mikro- und/oder Submikrometerbereich, vorzugsweise eine erste periodische Punktstruktur, auf der Oberfläche oder im Inneren des Substrats (5), bevorzugt flächigen und/oder transparenten Substrats, durch Laserinterferenzbearbeitung erzeugt. Dabei werden die zumindest drei Teilstrahlen so überlagert, dass ein 2D-Muster entsteht.

Die periodische Punktstruktur, vorzugsweise die erste Punktstruktur, wird nach einer Variante des Verfahrens innerhalb eines Interferenzpixels mittels eines einzelnen Laserpulses, hierin als Einfachbestrahlung bezeichnet, erzeugt. Eine Einfachbestrahlung bedeutet dabei, dass der Interferenzpixel innerhalb eines Bearbeitungsschrittes nur einmal mittels eines einzelnen Laserpulses belichtet wird. Es wird also eine Punktstruktur mit einer Interferenzperiode innerhalb eines Interferenzpixels durch die Belichtung mit nur einem Laserpuls erzeugt. Dabei überlappen nebeneinander angeordnete Interferenzpixel vorzugsweise nicht, sodass ein entstandener inverser Zapfen nicht erneut beleuchtet wird. Vorteilhaft ist somit eine hohe Prozessgeschwindigkeit erreichbar. Zusätzlich verhindert das Verwenden einer Einfachbestrahlung das Auftreten von quasi-periodischen Wellenstrukturen, sog. LIPSS, durch unkontrollierte Selbstorganisationsprozesse, welche die optischen Eigenschaften der Substratoberfläche dahingehend verändern, dass die Transparenz und die Reproduzierbarkeit des Wasserkontaktwinkels verschlechtert sind. Folglich kann durch eine Einfachbestrahlung ein Auftreten der LIPSS-Strukturen verhindert werden. Dadurch kann eine deutlich präzisere Prozesskontrolle erreicht und zuverlässig ein spezifischer Wasserkontaktwinkel erzeugt werden.

Vorzugsweise werden einzelne, getrennte Pulse erzeugt, wodurch vorteilhaft LIPSS-Strukturen vermieden werden können.

Nach einer vorteilhaften Variante des Verfahrens werden längere Pulsdauern verwendet, vorzugsweise größer als 1 ns, bevorzugt größer als 10 ns. So kann ein Vermeiden von LIPSS-Strukturen begünstigt werden.

Vorzugsweise werden durch Einfachbestrahlung geringe Strukturtiefen, insbesondere im Bereich von 0,05 bis 2 µm, bevorzugt von 0,1 bis 1 µm erreicht. Durch das Verwenden eines einzelnen Laserpulses und dadurch, dass zwischen benachbarten Interferenzpixeln kein Pulsüberlapp besteht, wird gewährleistet, dass die Strukturtiefen der periodischen Punktstruktur, vorzugsweise der ersten periodischen Punktstruktur, eine geringe Ausprägung haben. Vorteilhaft wird so erreicht, dass die optischen Eigenschaften des Substrats, insbesondere seine Transparenz, gegenüber dem unstrukturierten Substrat nicht verschlechtert sind. Insbesondere weicht die Transparenz des strukturierten Substrates gegenüber dem unstrukturierten Substrat gleichen Aufbaus um maximal 10 %, vorzugsweise um maximal 5 % oder 2 % ab, wobei die Transparenz des strukturierten Substrates bevorzugt geringer ist als die des unstrukturierten Substrates gleichen Materials und Aufbaus.

Eine Oberfläche mit Anti-Fogging-Eigenschaften, die aus einem strukturierten Bereich und einem unstrukturierten Bereich gebildet wird kann nach einer weiteren Ausgestaltung des Verfahrens dadurch generiert, dass derselbe Interferenzpixel mittels mehrerer aufeinanderfolgender Laserpulse durch eine Mehrfachbestrahlung bearbeitet wird. Mehrfachbestrahlung bedeutet dabei, dass derselbe Bereich des Substrats durch mehrere aufeinanderfolgende Laserpulse bearbeitet wird. Es wird also eine Punktstruktur, vorzugsweise eine erste periodische Punktstruktur, mit einer Interferenzperiode innerhalb eines Interferenzpixels mehrmals belichtet, wobei ein entstandener inverser Zapfen erneut einmal oder mehrmals belichtet wird. Die Pulslänge ist dabei durch den Nutzer einstellbar. Dabei erfolgt somit eine mehrfache Belichtung eines Interferenzpixels, bevor eine Änderung eines Verfahrensparameters, wie beispielsweise die Belichtungsposition vorgenommen wird.

Insbesondere wird bei diesem Verfahren derselbe Interferenzpixel mittels Mehrfachbestrahlung bearbeitet. Somit bildet sich in Folge der aufeinanderfolgenden Mehrfachbestrahlung mit identischen Verfahrensparametern eines Interferenzpixels durch Selbstorganisationsprozesse eine der periodischen Punktstruktur, vorzugsweise der ersten periodischen Punktstruktur, überlagerte quasi-periodische Linienstruktur als Wellenstruktur aus. Unter Verfahrensparametern sind im Sinne der Erfindung die Einstellung des Abstands des Strahlteilerelements zum Fokussierelement, die Laserpulsdauer, die Laserpulsenergie, die Laserwellenlänge und/oder die Position des Interferenzbereichs auf dem Substrat zu verstehen. Selbstorganisationsprozesse bezeichnen insbesondere sog. LIPSS, wie sie aus dem Stand der Technik bekannt sind. LIPSS treten in Folge eines teilweisen Erwärmens der Substratoberfläche und dem anschließenden Erstarren derselben in Form von regelmäßigen, quasi-periodischen (wie hierin definiert) Wellenstrukturen auf.

Vorteilhaft sind so hierarchische Strukturen auf der Oberfläche des Substrats schnell und somit effektiv erzeugbar. Eine Neueinstellung der Laserinterferenzvorrichtung und/oder eine Neuausrichtung des Substrats ist dafür nicht notwendig. Zusätzlich sind die Strukturparameter der periodischen Punktstruktur, insbesondere die Strukturtiefe somit ebenfalls einstellbar. Vorzugsweise wird eine geringe Strukturtiefe hierbei dadurch erreicht, dass die Prozessparameter, insbesondere die Laserpulsenergie, derart angepasst werden, dass der Energieeintrag durch die Mehrfachbestrahlung pro Interferenzpixel möglichst gering bleibt.

Nachteilig kann ein vorgegebener Wasserkontaktwinkel aufgrund der Selbstorganisationsprozesse und der damit einhergehenden Unsicherheiten weniger gut reproduziert werden. Um dennoch einen zuverlässigen Prozess zu gewährleisten haben die Erfinder festgestellt, dass bestimmte Interferenzperioden beachtet werden sollten, um eine zuverlässige und reproduzierbare Einstellung eines gewünschten, vorzugsweise möglichst kleinen, Wasserkontaktwinkels zu erreichen. Das Verfahren unter Verwendung von Mehrfachbestrahlung ist somit dadurch gekennzeichnet, dass die Interferenzperiode der periodischen Punktstruktur im Bereich von 50 nm bis 2,0 µm und/oder im Bereich von 9,5 µm bis 50 µm liegt. Insbesondere ist das Erreichen der gewünschten Interferenzperioden der durch die Selbstorganisationsprozesse erzeugten LIPSS von den Materialeigenschaften des zu strukturierenden Substrats und den Eigenschaften des zur Strukturierung verwendeten Laserstrahls abhängig, insbesondere von der Wellenlänge des Laserstrahls. Eine gewünschte Interferenzperiode ist also über eine geeignete Auswahl der Laserstrahlungsquelle einstellbar.

Nach einer weiteren Ausgestaltung der Erfindung wird durch Mehrfachbestrahlung mit abweichenden Verfahrensparametern eine weitere periodische Punktstruktur oder periodische Linienstruktur mit einer von der Interferenzperiode der ersten periodischen Punktstruktur verschiedenen Interferenzperiode auf das Substrat aufgebracht. Dabei betreffen die abweichenden Verfahrensparameter insbesondere den Abstand des Strahlteilerelements zum Fokussierelement, wodurch die Interferenzperiode der weiteren periodischen Punktstruktur oder Linienstruktur im Vergleich zur ersten periodischen Punktstruktur verändert wird. Aber auch eine zusätzliche Veränderung der Laserpulsdauer und/oder -energie ist möglich.

Somit kann vorteilhaft eine flexible zweite Struktur mit Abmessungen im Mikro- und/oder Submikrometerbereich auf das Substrat aufgebracht werden, die von der ersten periodischen Punktstruktur unabhängig ist. Dadurch ist eine einfache Ausrichtung der Interferenzpixel auf dem Substrat gewährleistet. Zusätzlich ist so der Anteil der strukturierten Fläche auf der Substratoberfläche erhöht, sodass ausgeprägte Anti-Fogging-Eigenschaften erzielbar sind. Auch hier haben sich Interferenzperioden im Bereich von 50 nm bis 2,0 µm und/oder im Bereich von 9,5 µm bis 50 µm als zuverlässig erwiesen. Vorteilhaft an einem solchen Verfahren ist, dass die Interferenzperioden durch das Einstellen des Strahlteilerelements präzise kontrollierbar sind, und dass die gewünschten Interferenzperioden unabhängig von Materialeigenschaften und den Eigenschaften des zur Strukturierung genutzten Laserstrahls einstellbar sind.

Bevorzugt beträgt der Abstand des optischen Strahlteilerelements von der Fokussierlinse nach dem erfindungsgemäßen Verfahren vorzugsweise 10 mm bis 50 mm oder 150 mm bis 200 mm.

Die Laserpulsdauer beträgt vorzugsweise 50 fs bis 1 ns, besonders bevorzugt 50 fs bis 10 ps. Durch diese kurzen Laserpulsdauer kann ein unerwünschtes und/oder unkontrolliertes Aufschmelzen des Substrates (bspw. in Form einer strukturellen oder chemischen Umwandlung), insbesondere in Folge lokaler Überhitzung bspw. durch einen zu hohen Energieeintrag, unterbunden oder zumindest minimiert werden. Dies ist insbesondere bei den hierin eingesetzten "empfindlichen" Materialien die die Substrate aufweisen oder aus denen die die Substrate bestehen vorteilhaft.

Die Laserwellenlänge beträgt vorzugsweise 200 nm bis 10 µm, bevorzugt 266 nm bis 1064 nm.

Die Laserpulsenergie beträgt vorzugsweise 50 µJ bis 20 mJ, bevorzugt 300 µJ bis 800 µJ, besonders bevorzugt 500 bis 800 µJ. Durch diese geringe Laserpulsenergie pro Laserpuls kann ein unerwünschtes und/oder unkontrolliertes Aufschmelzen des Substrates (bspw. in Form einer strukturellen oder chemischen Umwandlung), insbesondere in Folge lokaler Überhitzung bspw. durch einen zu hohen Energieeintrag, unterbunden oder zumindest minimiert werden. Dies ist insbesondere bei den hierin eingesetzten "empfindlichen" Materialien die die Substrate aufweisen oder aus denen die die Substrate bestehen vorteilhaft.

Nach einer weiteren Ausgestaltung des Verfahrens umfasst das Verfahren zusätzlich die folgenden Schritte:
- Das Bereitstellen eines weiteren, also zweiten Substrats, wobei das zweite Substrat vorzugsweise transparent ist, und
- das Prägen des ersten Substrats auf das weitere Substrat, sodass auf dem zweiten Substrat eine periodische Punktstruktur entsteht, welche aus Zapfen gebildet wird. Dabei wird das erste Substrat als Negativform für das zweite Substrat verwendet. Vorteilhaft ist das erste Substrat somit zum Prägen von beliebig vielen weiteren Substraten verwendbar, wodurch der Prozess des Erzeugens eines strukturierten Substrats mit Anti-Fogging-Eigenschaften erheblich beschleunigt werden kann.

### Punktstruktur

Bei einer Erzeugung eines erfindungsgemäßen strukturierten und eines unstrukturierten Bereiches, insbesondere eines strukturierten Bereich, der durch eine erste periodische Punktstruktur im Mikro- oder Submikrometerbereich mit einer ersten Interferenzperiode im Bereich von 50 nm bis 50 µm gebildet wird, oder aus einem strukturierten Bereich, der eine erste periodische Punktstruktur im Mikro- oder Submikrometerbereich mit einer ersten Interferenzperiode im Bereich von 50 nm bis 2,0 µm aufweist oder aus einem strukturierten Bereich, der eine erste periodische Punktstruktur im Mikro- oder Submikrometerbereich mit einer ersten Interferenzperiode im Bereich von 9,5 µm bis 50 µm aufweist, können weiterhin auch Antireflexionseigenschaften generiert werden.

Die Erfinder der vorliegenden Erfindung haben darüber herausgefunden, dass dafür neben der Periodizität auch die Strukturtiefe (d.h. die Tiefe der inversen Zapfen, gemessen von deren Sattelpunkt der Vertiefung bis zum Scheitelpunkt) einen Einfluss auf die Antireflexionseigenschaften (wie hierin definiert) haben. Beispielsweise liegt die Strukturtiefe bzw. Profiltiefe der inversen Zapfen (Erhebungen und Vertiefungen) im statistischen Mittel im Bereich von 0,05 µm bis 2 µm, bevorzugt im Bereich von 0,1µm bis 1 µm.

Bevorzugt wird eine Vorrichtung zur Herstellung eines strukturierten Substrats (5), bevorzugt flächigen und/oder transparenten Substrats, genutzt, die zwei Umlenkelemente (6), (7) umfasst. Die Umlenkelemente (6), (7) sind im Strahlengang (3) des Lasers zwischen dem Strahlteilerelement (2) und dem Fokussierelement (4) angeordnet. Die Umlenkelemente (6), (7) dienen zur Aufweitung des Diffraktionswinkels der zumindest drei, besonders bevorzugt vier Teilstrahlen, in dem sie auf der Oberfläche oder im Inneren des Substrats (5), bevorzugt flächigen und/oder transparenten Substrats, interferieren. Durch die Einstellung der Abstände der optischen Elemente kann gewährleistet werden, dass zur Veränderung der Interferenzperiode lediglich das Strahlteilerelement (2) entlang seiner optischen Achse beweglich sein muss. Dies ermöglicht leichtere Einstellprozesse während der Bearbeitung.

In einer bevorzugten Ausführungsform wird eine Vorrichtung zur Herstellung eines strukturierten Substrats, bevorzugt flächigen und/oder transparenten Substrats, genutzt, die eine gepulste Laserstrahlungsquelle (1) verwendet. In einer besonders bevorzugten Ausführungsform wird eine Vorrichtung zur Herstellung eines strukturierten Substrats, bevorzugt flächigen und/oder transparenten Substrats, genutzt, die über eine Haltevorrichtung für das Substrat verfügt, die in der xy-Ebene, senkrecht zum Strahlengang (3) des von der Laserstrahlungsquelle (1) emittierten Laserstrahls frei beweglich ist.

Über die Frequenz der Laserstrahlungsquelle (1), f, und die Geschwindigkeit der Bewegung der Haltevorrichtung, v, lässt sich die Pixeldichte Pd, also der Abstand in der ein Interferenzpixel mit der Weite D auf dem Substrat, bevorzugt flächigen und/oder transparenten Substrat, aufgebracht werden kann, einstellen zu: $Pd = \frac{v}{f}$

Ist die Weite des Interferenzpixels, D, größer als die Pixeldichte Pd, so überlagern sich benachbarte Interferenzpixel in einem Bereich. Dieser Bereich ist dem Fachmann als Pulsüberlapp, OV, bekannt. Er kann berechnet werden zu: $OV = \frac{\left(D-Pd\right)}{D}$

In einer bevorzugten Ausgestaltung ist bei dem Verfahren zur Herstellung eines strukturierten Substrats, bevorzugt flächigen und/oder transparenten Substrats, Pd kleiner als D. Der dadurch entstehende Pulsüberlapp OV führt zu einer Mehrfachbestrahlung des Substrats, bevorzugt flächigen und/oder transparenten Substrats. Bevorzugt können so nicht-texturierte Flächen vermieden werden.

In einer besonders bevorzugten Ausgestaltung werden bei dem Verfahren zur Herstellung eines strukturierten Substrats, bevorzugt flächigen und/oder transparenten Substrats dieselben Interferenzpixel mehrfach bestrahlt. Dadurch ist es möglich, die Tiefe der entstandenen Mikrostrukturen zu erhöhen.

Der Vorteil eines durch ein solches Verfahren erzeugten strukturierten Substrats, bevorzugt flächigen und/oder transparenten Substrats ist die hohe Regelmäßigkeit der erzeugten periodischen Punktstrukturen mit Strukturabmessungen im Mikro- und/oder Submikrometerbereich. Eine so erzeugte periodische Punktstruktur mit Abmessungen im Mikro- und/oder Submikrometerbereich hat vorzugsweise einen Variationskoeffizienten (ein Wert, der sich aus der Teilung der Standardabweichung durch den Durchschnittswert ergibt) des Zapfenquerschnitts von 15% oder weniger, mehr bevorzugt 10% oder weniger, noch mehr bevorzugt 5% oder weniger.

Insbesondere eignet sich die Mehrfachbestrahlung eines Substrats zur Herstellung von hierarchischen Strukturen. So bewirkt die Mehrfachbestrahlung desselben Interferenzpixels ein zumindest teilweises Aufschmelzen des Substratmaterials, wobei sich während des Strukturierungsprozesses, d.h. beim Auftreffen eines Laserpulses, als Folge des Auftretens eines Bereiches hoher Intensität eine Wellenstruktur ausbildet. Dabei bildet sich die Strukturierung, insbesondere die Wellenstruktur durch einen Selbstorganisationsprozess aus. Insbesondere überlagert die Wellenstruktur eine periodische Punktstruktur im Mikro- oder Submikrometerbereich, welche mittels Laserinterferenzstrukturierung erzeugbar ist. Somit ist mit einem Verfahrensschritt eine hierarchische Strukturierung in einem Substrat erzeugbar. Nach einer bevorzugten Ausgestaltung der Erfindung erfolgt daher die Mehrfachbestrahlung, vorzugsweise 2-fache bis 400-fache, insbesondere 10-fache bis 300-fache, besonders bevorzugt 10-fache bis 100-fache, insbesondere 20-fache bis 100-fache, Bestrahlung desselben Interferenzpixels auf dem Substrat, wodurch eine Wellenstruktur (wie hierin definiert) ausgebildet wird, insbesondere eine periodische Punktstruktur aus sich überlagernden Strukturen ausgebildet wird, wobei mindestens eine Struktur Abmessungen im Submikrometerbereich, insbesondere eine quasi-periodische Wellenstruktur aufweist, und wobei zumindest eine Struktur aus inversen Zapfen gebildet ist. Besonders bevorzugt ist der Zeitversatz zwischen den einzelnen Pulsen dabei im Bereich der Pulsdauer des Laserpulses, bevorzugt im Bereich von 50 fs bis 1 ns, besonders bevorzugt im Bereich von 10 fs bis 50 ps, ganz besonders bevorzugt im Bereich von 10 fs bis 10 ps.

Dabei bezeichnet eine hierarchische Strukturierung eine Struktur, bei welcher eine erste Struktur mit Abmessungen im Mikro- oder Submikrometerbereich, welche einem Interferenzmuster entspricht, von einer weiteren Struktur überlagert ist, welche Abmessungen aufweist, die unterhalb der Abmessungen der ersten Struktur liegen und welche durch einen Selbstorganisationsprozess oder einen weiteren Laserinterferenzprozess ausgebildet ist. Bevorzugt befinden sich die Abmessungen der weiteren Struktur, welche durch einen Selbstorganisationsprozess oder einen weiteren Laserinterferenzprozess ausgebildet ist, im Bereich von 1% bis 30% der Abmessungen der ersten Struktur, welche einem Interferenzmuster entspricht.

Zusätzlich ist es durch das hierin definierte Verfahren möglich, mittels derselben Vorrichtung und darüber hinaus im selben Prozessschritt ein Substrat mit hierarchischen Strukturen zu versehen, während herkömmliche Prozesse sukzessiv vorgehen, d.h. nicht in der Lage sind, zeitgleich welcher eine erste Struktur mit Abmessungen im Mikro- oder Submikrometerbereich, welche einem Interferenzmuster entspricht, und eine weitere Struktur, welche durch einen Selbstorganisationsprozess ausgebildet ist, zu erzeugen.

Eine Verschiebung des zu strukturierenden Substrates, bevorzugt flächigen und/oder transparenten Substrats, im Laserstrahl ist aufgrund der relativ großen dabei bewegten Massen vergleichsweise aufwändig und langsam. Es ist daher vorteilhaft das Substrat, bevorzugt flächigen und/oder transparenten Substrats während der Bearbeitung ortsfest vorzusehen und die flächige Strukturierung des Substrates dadurch zu realisieren, dass die Fokussierung der Teilstrahlen auf die Oberfläche oder das Volumen des Substrats durch Manipulation der Laserteilstrahlen mit optischen Elementen (Fokussierspiegel bzw. Galvo-Spiegel (Laserscanner)) in Strahlrichtung bewirkt wird. Da die dabei bewegten Massen relativ klein sind, ist dies mit weit geringerem Aufwand bzw. viel schneller möglich. Vorzugsweise ist das Substrat während des Verfahrens ortsfest angeordnet.

Die flächige Strukturierung des Substrates ist selbstverständlich grundsätzlich auch durch eine Verschiebung des Substrates im Laserstrahl möglich.

Durch die mittels des hierin offenbarten Verfahrens erzeugten periodischen Strukturen im Mikro- und/oder Submikrometerbereich, vorzugsweise ersten periodischen Punktstrukturen, weist das derart strukturierte Substrat Anti-Fogging-Eigenschaften auf. Dies wird dadurch gewährleistet, dass Wasser, das das Substrat benetzt, keine Tröpfchen bildet und stattdessen zu einem homogenen Wasserfilm verläuft, sodass die Sicht durch, bzw. auf das Substrat nicht durch Nebel, bzw. Beschlag behindert ist.

Von der Erfindung ist daher auch ein strukturiertes Substrat mit Anti-Fogging-Eigenschaften erfasst, das eine erste periodische Punktstruktur im Mikro- und/oder Submikrometerbereich umfasst, wobei die erste periodische Punktstruktur aus inversen Zapfen oder Zapfen gebildet ist, wobei die inversen Zapfen oder Zapfen periodisch mit einem Abstand bezogen auf deren Sattelpunkt bzw. Mittelpunkt mit einer Interferenzperiode im Bereich von 50 nm bis 2,0 µm und/oder im Bereich von 9,5 µm bis 50 µm zueinander angeordnet sind.

Nach einer bevorzugten Ausgestaltung der Erfindung, wird das strukturierte Substrat durch Bearbeitung mit einem Verfahren, wie hierin definiert, erhalten.

Ein durch das hierin offenbarte Verfahren und die hierin offenbarte Vorrichtung erzeugtes strukturiertes Substrat eignet sich darüber hinaus zum weiteren bearbeiten mittels eines Beschichtungsprozesses, wobei das Substrat eine physikalische und/oder chemische Beschichtung erhalten kann. Durch eine solche Beschichtung können die Eigenschaften des strukturierten Substrats, beispielsweise die Antireflexionseigenschaften und/oder hydrophile und/oder hydrophobe Eigenschaften verstärkt werden. Denkbar ist das Aufbringen einer chemischen Sprühbeschichtung und/oder das Aufbringen einer Beschichtung mittels chemical vapor deposition und/oder Sputtern.

Die Erfindung umfasst somit auch ein Verfahren, bei dem das strukturierte Substrat nach der Strukturierung gemäß einer der hierin erwähnten Beschichtungsarten beschichtet wird. Dadurch tritt die Strukturierung, insbesondere die erste periodische Punktstruktur dann auch in der Beschichtung, aber auch im darunter liegenden Substrat auf.

### Vorrichtung

### Laserstrahlungsquelle (1)

Die Vorrichtung zum Erzeugen eines strukturierten Substrats mit Anti-Fogging-Eigenschaften weist eine Laserstrahlungsquelle (1) auf, die einen Laserstrahl emittiert. Das Strahlungsprofil des emittierten Laserstrahls entspricht entweder einem Gauß-Profil, oder einem Top-Hat-Profil, besonders bevorzugt einem Top-Hat-Profil. Das Top-Hat-Profil ist hilfreich, um eine zu strukturierende Oberfläche eines Substrates homogener zu strukturieren bzw. abzudecken und um ggf. eine schnellere Strukturierungsrate zu ermöglichen.

In einer besonders bevorzugten Ausgestaltung handelt es sich bei der Laserstrahlungsquelle (1) um eine Quelle, die einen gepulsten Laserstrahl erzeugt. Die Pulsweite der gepulsten Laserstrahlungsquelle liegt dabei beispielsweise im Bereich von 50 fs bis 1 ns, insbesondere 50 fs bis 100 ns, ganz besonders bevorzugt 50 Femtosekunden bis 10 ps.

Mit Laserstrahl oder Teilstrahl ist, wenn nicht ausdrücklich anderes angegeben ist, kein idealisierter Strahl der geometrischen Optik gemeint, sondern ein realer Lichtstrahl, wie beispielsweise ein Laserstrahl, der keinen infinitesimal kleinen, sondern einen ausgedehnten Strahlquerschnitt (Gauß-Verteilungsprofil oder einen intrinsischer Top-Hat-Strahl) aufweist.

Mit Top-Hat-Profil oder Top-Hat-Intensitätsverteilung ist eine Intensitätsverteilung gemeint, die sich zumindest hinsichtlich einer Richtung im Wesentlichen durch eine Rechteckfunktion (rect (x)) beschreiben lässt. Dabei sind reale Intensitätsverteilungen, die Abweichungen von einer Rechteckfunktion im Prozentbereich beziehungsweise geneigte Flanken aufweisen, ebenfalls als Top-Hat-Verteilung oder Top-Hat-Profil bezeichnet. Verfahren und Vorrichtungen zur Erzeugung eines Top-Hat-Profils sind dem Fachmann bestens bekannt und bspw. in EP 2 663 892 beschrieben. Ebenso sind bereits optische Elemente zur Transformation des Intensitätsprofils eines Laserstrahls bekannt. Beispielsweise können mittels diffraktiven und/oder refraktiven Optiken Laserstrahlen mit gaußförmigem Intensitätsprofil in Laserstrahlen transformiert werden, welche in einer oder mehreren definierten Ebenen ein Top-Hat-förmiges Intensitätsprofil aufweisen, wie zum Beispiel ein Gauss-to-Top Hat Focus Beam Shaper der Firma TOPAG Lasertechnik GmbH, siehe z.B. DE102010005774A1. Derartige Laserstrahlen mit Top-Hat-förmigem Intensitätsprofilen sind besonders attraktiv für die Lasermaterialbearbeitung, insbesondere bei der Verwendung von Laserpulsen, die kürzer als 50 ps sind, da mit der im Wesentlichen konstanten Energie- bzw. Leistungsdichte hierbei besonders gute und reproduzierbare Bearbeitungsergebnisse erzielt werden können.

Die in der erfindungsgemäßen Vorrichtung enthaltene Laserstrahlungsquelle (1) kann eine Intensität von 50 µJ bis 20 mJ besonders bevorzugt 300 µJ bis 800 µJ. Durch die erfindungsgemäße Vorrichtung ist die Intensität der Laserstrahlungsquelle in einem Bereich flexibel wählbar. Der Strahldurchmesser spielt für das Erzeugen des Interferenzmusters auf dem Substrat, bevorzugt flächigen und/oder transparenten Substrat, keine Rolle. Durch die bevorzugte Anordnung der optischen Elemente im Strahlengang des Lasers ist keine Einheit zur Kontrolle der Intensität des Laserstrahls notwendig.

Die Laserstrahlungsquelle ist vorzugsweise dazu eingerichtet, Wellenlängen im Bereich von 100 nm bis 15 µm (bspw. CO₂-Laser im Bereich von 10,6 µm), ganz besonders bevorzugt im Bereich von 266 nm bis 1.064 nm zu emittieren. Als Laserstrahlungsquelle eignen sich beispielsweise UV-Laserstrahlquellen (155 bis 355 nm), Laserstrahlquellen, die grünes Licht (532 nm) emittieren, Diodenlaser (typischerweise 800 bis 1000 nm) oder Laserstrahlquellen, die im nahen infrarot (typischerweise 1064 nm) Strahlung emittieren, insbesondere mit einer Wellenlänge im Bereich von 200 bis 650 nm Wellenlänge. Für die Mikroverarbeitung geeignete Laser sind dem Fachmann bekannt und umfassen beispielsweise HeNe-Laser, HeAg-Laser (ca. 224 nm), NeCu-Laser (ca. 249 nm), Nd:YAG Laser (ca. 355 nm), YAG-Laser (ca. 532 nm), InGaN-Laser (ca. 532 nm).

Nach einer weiteren Ausgestaltung weist die erfindungsgemäße Vorrichtung mindestens eine weitere Laserstrahlungsquelle auf, welche derart ausgestaltet ist, dass sie einen Laserstrahl erzeugt, welcher mit dem Laserstrahl der ersten Laserstrahlungsquelle, bzw. dem in Teilstrahlen aufgeteilten Laserstrahl der ersten Laserstrahlungsquelle in einem Interferenzbereich interferiert. Dabei weist die weitere Laserstrahlungsquelle die gleichen Eigenschaften, wie oben beschrieben auf, wobei diese denen der ersten Laserstrahlungsquelle gleichen oder von dieser verschieden sein können.

### Optische Elemente

Die vorliegende Erfindung umfasst eine Vielzahl an optischen Elementen. Bei diesen Elementen handelt es sich primär um Prismen und Linsen.

Diese Linsen können refraktiv oder diffraktiv sein. Es können sphärische, asphärische oder zylindrische Linsen verwendet werden. In einer bevorzugten Ausgestaltung werden zylindrische Linsen verwendet. Dadurch ist es möglich, die Überlappungsbereiche der Teilstrahlen (hierin auch als Interferenzpixel bezeichnet) in eine Raumrichtung zu komprimieren und in eine andere zu strecken. Wenn die Linsen nicht sphärisch/asphärisch sind, sondern zylindrisch, hat dies den Vorteil, dass die Strahlen zugleich verformt werden können. Dadurch kann der Bearbeitungsspot (d.h. das auf dem Substrat erzeugte Interferenzmuster) von einem Punkt zu einer Linie verformt werden, die das Interferenzmuster enthält. Mit ausreichender Energie des Lasers kann diese Linie im Bereich von 10-15 mm lang sein (und ca. 100 µm dick sein).

Des Weiteren können Spatial Light Modulators (SLM) zur Strahlformung eingesetzt werden. Dem Fachmann ist die Verwendung von SLMs zur räumlichen Modulation der Phase oder der Intensität oder der Phase und Intensität eines einfallenden Lichtstrahls bekannt. Die Anwendung von Liquid Crystal on Silicon (LCoS)-SLM zur Strahlteilung ist in der Literatur beschrieben und auch in der erfindungsgemäßen Vorrichtung denkbar. Darüber hinaus können SLMs auch zur Fokussierung der Teilstrahlen auf dem Substrat verwendet werden. Die Ansteuerung eines solchen SLMs kann optisch, elektronisch, oder akustisch erfolgen.

Alle im Folgenden erläuterten optischen Elemente sind im Strahlengang (3) des Lasers angeordnet. Im Sinne der Erfindung bezeichnet der Strahlengang des Lasers den Verlauf sowohl des von der Laserstrahlungsquelle emittierten Laserstrahls als auch den Verlauf der durch ein Strahlteilerelement aufgeteilten Teilstrahlen. Als optische Achse des Strahlengangs (3) wird jedoch die optische Achse des von der Laserstrahlungsquelle (1) emittierten Laserstrahls verstanden. Sofern nicht anders erläutert, sind alle optischen Elemente senkrecht zur optischen Achse des Strahlengangs (3) angeordnet.

### Strahlteilerelement (2)

Im Strahlengang (3) des Lasers, hinter der Laserstrahlungsquelle (1), befindet sich ein Strahlteilerelement (2). Das Strahlteilerelement (2) kann ein diffraktives oder ein refraktives Strahlteilerelement sein. Diffraktive Strahlteilerelemente werden auch nur kurz als diffraktives optisches Element (DOE) bezeichnet. Im Sinne der Erfindung bezeichnet ein diffraktives Strahlteilerelement ein optisches Element, welches Mikro- oder Nanostrukturen, vorzugsweise Mikrostrukturen, welche einen Eingangsstrahl entsprechend den unterschiedlichen Beugungsordnungen in verschiedene Strahlen aufteilen, enthält. Ein refraktives Strahlteilerelement bezeichnet im Sinne der Erfindung ein Strahlteilerelement, bei dem die Strahlen aufgrund von Brechzahlunterschieden an Oberflächen geteilt werden, wobei diese in der Regel transparent ausgebildete optische Elemente sind, wie z. B. ein Prisma bzw. ein Doppelprisma. Vorzugsweise handelt es sich bei dem Strahlteilerelement (2) um ein refraktives Strahlteilerelement.

Nach einer bevorzugten Ausgestaltung handelt es sich bei dem Strahlteilerelement um ein einzelnes optisches Element, insbesondere ein diffraktives oder refraktives optisches Element, welches derart aufgebaut ist, dass die Unterteilung des einfallenden Laserstrahls auf den optischen Eigenschaften des Strahlteilerelements basiert. Somit ist vorteilhaft gewährleistet, dass gegenüber einem mehrteiligen Strahlteilerelement, welches aus mehreren optischen Elementen (bspw. Spiegel, Prismen, etc.) besteht, ein einfacher optischer Aufbau realisierbar ist. Die gewünschte Strahlaufteilung ist erreichbar, ohne dass ein Kalibrieren, bzw. Anpassen der Anordnung von mehreren optischen Elementen zueinander. Auch ist die Beweglichkeit des Strahlteilerelements im Strahlenganz einfach zu realisieren, da nur das Bewegen eines einzelnen optischen Elements durchzuführen ist. Zudem ergeben sich durch das Verwenden eines einteiligen Strahlteilerelements weniger verschleißanfällige Komponenten, welche ggf. auszutauschen sind.

Nach einer möglichen Ausgestaltung ist der Strahlteiler als polarisierender Strahlteiler, bei dem einer der resultierenden Strahlen eine andere Polarisation aufweist als der andere, oder als nicht polarisierender Strahlteiler, bei dem die Polarisation für die Teilung des Strahls keine Rolle spielt, ausgebildet.

In einer bevorzugten Ausgestaltung teilt das Strahlteilerelement (2) den emittierten Laserstrahl in zumindest 3, vorzugsweise zumindest 4, insbesondere 4 bis 8, also 4, 5, 6, 7, oder 8 Teilstrahlen auf.

In einer weiteren Ausgestaltung teilt das Strahlteilerelement (2) den emittierten Laserstrahl in zumindest 2, vorzugsweise zumindest 3 bis 4, insbesondere 4 bis 10, also 4, 5, 6, 7, 8, 9 oder 10 Teilstrahlen auf.

Für eine Aufteilung in 3 Teilstrahlen wird nach einer vorteilhaften Ausführung des Verfahrens ein refraktives Strahlteilerelement verwendet. Vorzugsweise weist ein solches Strahlteilerelement ein runde Top-hat-Intensitätsverteilung auf. So kann vorteilhaft eine hohe Interferenzqualität und ein hoher Interferenzkontrast erreicht werden.

Das Strahlteilerelement (2) ist entlang seiner optischen Achse frei beweglich. D. h., es kann entlang seiner optischen Achse auf die Laserstrahlungsquelle zu oder von ihr wegbewegt werden. Durch die Bewegung des Strahlteilerelements (2) verändert sich die Aufweitung der zumindest 3 Teilstrahlen, sodass diese mit unterschiedlichen Abständen zueinander auf ein Fokussierelement auftreffen. Dadurch kann der Winkel θ, in dem die Teilstrahlen auf das Substrat (5), bevorzugt flächiges und/oder transparentes Substrat, auftreffen, verändert werden. Somit ergibt sich bei einer Überlagerung von vier Teilstrahlen eine nahtlose Änderung der Interferenzperiode pₙ zu $p = \frac{λ}{\sqrt{2} sinθ}$ wobei λ die Wellenlänge des emittierten Laserstrahls ist.

Nach einer bevorzugten Ausgestaltung der vorliegenden Erfindung ist das Strahlteilerelement als rotierendes Element ausgebildet. Dies erlaubt es vorteilhaft, dass die Polarisation der Teilstrahlen modifiziert werden können.

Besonders bevorzugt beträgt der Winkel θ, in dem die Teilstrahlen auf das Substrat (5), bevorzugt flächiges und/oder transparentes Substrat, auftreffen, 0,1° bis 90°.

Der Winkel θ ist ferner abhängig von den Abständen der optischen Elemente untereinander, insbesondere vom Abstand der optischen Elemente zum Strahlteilerelement, ganz besonders vom Abstand des Fokussierelements zum Strahlteilerelement. Abhängig von der gewünschten Interferenzperiode, welche auf, bzw. im flächigen und/oder transparenten Substrat zu erzeugen ist, kann die Position des Strahlteilerelements so eingestellt bzw. berechnet werden, dass die gewünschte Interferenzperiode einstellbar ist. Dabei wird die Position der von der Vorrichtung umfassten optischen Elemente, insbesondere die Position des Fokussierelements derart im Verhältnis zum Strahlteilerelement berücksichtigt, dass bei einem größeren oder kleineren Abstand der optischen Elemente zueinander die Position des Strahlteilerelements entsprechend anpassbar ist.

Um ein strukturiertes Substrat mit Anti-Fogging-Eigenschaften zu generieren hat sich als besonders vorteilhaft herausgestellt, wenn ein Abstand vom Strahlteilerelement (2) zum Umlenkelement (7) von 10 mm bis 50 mm oder 150 mm bis 200 mm eingestellt ist.

Nach einer bevorzugten Ausgestaltung der Erfindung umfasst die Vorrichtung auch eine Messeinrichtung, insbesondere eine Messeinrichtung, die mittels eines Lasers oder eines optischen Sensors arbeitet, die zum Messen der Position des Strahlteilerelements und gegebenenfalls des Abstandes des Strahlteilerelements zu den weiteren optischen Elementen, insbesondere zur Position des Fokussierelements eingerichtet ist.

Ferner kann die erfindungsgemäße Vorrichtung eine mit der Messeinrichtung signaltechnisch verbundene Steuereinrichtung umfassen, die insbesondere mit einer Recheneinheit derart verbunden ist, mit der die gemessenen Position des Strahlteilerelements mit einem ersten vorbestimmten Vergleichswert vergleichbar ist, wobei die Steuereinrichtung programmtechnisch derart eingerichtet ist, dass, falls der Abstand des Strahlteilerelements zu den weiteren optischen Elementen, insbesondere zur Position des Fokussierelements und/oder des Umlenkelements (7) größer oder kleiner ist als der erste vorbestimmte Vergleichswert, dann über die Steuereinrichtung ein Steuersignal erzeugt wird, mit dem zumindest eine Position eines optischen Elements, insbesondere des

Strahlteilerelements (2) derart verändert wird, insbesondere des Strahlteilerelements (2) im Verhältnis zum Umlenkelement (7), dass die gewünschte Interferenzperiode auf dem Substrat erzeugt wird.

In diesem Zusammenhang kann auch das Verfahren zur Herstellung eines Substrats mit einer Punktstruktur im Mikro- oder Submikrometerbereich insbesondere nach Schritt (a) die folgenden Schritte umfassen:
(i) Messen der Position des Strahlteilerelements (2) und gegebenenfalls des Abstandes des Strahlteilerelements zu den weiteren optischen Elementen oder zu wenigstens einem der weiteren optischen Elemente, insbesondere zur Position des Fokussierelements (4) und/oder des Umlenkelements (7),
(ii) Vergleichen der gemessenen Position des Strahlteilerelements mit einem ersten vorbestimmten Vergleichswert und,
(iii) falls der gemessene Abstand des Strahlteilerelements zu den weiteren optischen Elementen oder zu wenigstens einem der weiteren optischen Elemente, insbesondere zur Position des Fokussierelements (4) und/oder des Umlenkelements (7) größer oder kleiner ist als der erste vorbestimmte Vergleichswert: Verändern der Position des optischen Elements, insbesondere des Strahlteilerelements (2) derart (insbesondere im Verhältnis zu den anderen optischen Elementen, besonders bevorzugt des Strahlteilerelements (2) im Verhältnis zum Umlenkelement (7)), dass die gewünschte Interferenzperiode auf dem Substrat erzeugt wird.

Das Unterteilen des Laserstrahls im Strahlteilerelement (2) kann sowohl durch ein teilweise reflektives Strahlteilerelement, beispielsweise einen halbdurchlässigen Spiegel, als auch ein transmissives Strahlteilerelement, beispielsweise ein dichroitisches Prisma, erfolgen.

In einer bevorzugten Ausgestaltung sind dem Strahlteilerelement (2) weitere Strahlteilerelemente im Strahlengang des Lasers nachgeordnet. Diese Strahlteilerelemente sind derart angeordnet, dass sie jeden der zumindest drei Teilstrahlen in zumindest zwei weitere Teilstrahlen aufteilen. Dadurch kann eine höhere Anzahl an Teilstrahlen erzeugt werden, die auf das Substrat, bevorzugt flächige und/oder transparente Substrat, gelenkt werden, sodass sie auf der Oberfläche oder im Inneren des Substrats interferieren. Dadurch kann die Interferenzperiode des Interferenzmusters eingestellt werden.

### Fokussierelement (4)

Des Weiteren ist im Strahlengang (3) des Lasers dem Strahlteilerelement (2) nachgeordnet ein Fokussierelement (4) angeordnet, das derart eingerichtet ist, dass es die Teilstrahlen derart durchlaufen, dass die Teilstrahlen auf der Oberfläche eines zu strukturierenden Substrats (5) in einem Interferenzbereich interferieren. Das Fokussierelement (4) fokussiert die zumindest drei Teilstrahlen in einer Raumrichtung, ohne die zumindest drei Teilstrahlen in der Raumrichtung senkrecht dazu zu fokussieren. Beispielsweise kann das Fokussierelement (4) eine fokussierende optische Linse sein. Unter fokussieren versteht man im Sinne der Erfindung das Bündeln der zumindest drei Teilstrahlen auf der Oberfläche eines Substrates, bevorzugt eines flächigen und/oder transparenten Substrates.

Das Fokussierelement (4) kann im Strahlengang (3) frei beweglich sein. Nach einer bevorzugten Ausgestaltung der vorliegenden Erfindung ist das Fokussierelement (4) im Strahlengang bzw. entlang der optischen Achse fixiert.

Es versteht sich, dass die hierin definierten optischen Elemente bspw. zur Strahlteilung und zur Ausrichtung der Teilstrahlen in Richtung auf ein entsprechend zu strukturierendes Substrat in einem gemeinsamen Gehäuse angeordnet sein können.

In einer bevorzugten Ausgestaltung handelt es sich bei dem Fokussierelement (4) um eine sphärische Linse. Die sphärische Linse ist derart eingerichtet, dass sie die einfallenden zumindest drei Teilstrahlen derart durchlaufen, dass sie auf der Oberfläche des zu strukturierenden Substrats (5), bevorzugt flächigen und/oder transparenten Substrats, in einem Interferenzbereich interferieren. Die Weite des Interferenzbereichs beträgt vorzugsweise 1 bis 600 µm, besonders bevorzugt 10 bis 400 µm, ganz besonders bevorzugt 20 bis 200 µm. Hierdurch kann zugleich eine hohe Strukturierungsrate, beispielsweise wie hierin definiert, eingestellt werden.

In einer besonders bevorzugten Ausgestaltung handelt es sich bei dem Fokussierelement (4) um eine zylindrische Linse. Die zylindrische Linse ist derart eingerichtet, dass der Bereich, in dem sich die zumindest drei Teilstrahlen auf der Oberfläche oder im Inneren des Substrats (5), bevorzugt flächigen und/oder transparenten Substrats, überlagern, in eine Raumrichtung gedehnt wird. Dadurch nimmt der Bereich des Substrats, auf dem das Interferenzmuster erzeugt werden kann, eine elliptische Form an. Die große Halbachse dieser Ellipse kann eine Länge von 20 µm bis 15 mm erreichen. Damit vergrößert sich der in einer Bestrahlung strukturierbare Bereich.

### Erstes Umlenkelement (7)

In einer besonders bevorzugten Ausgestaltung befindet sich vor dem Fokussierelement (4) und nach dem Strahlteilerelement (2) angeordnet ein Umlenkelement (7), das vorzugsweise im Strahlengang (3) des Lasers angeordnet ist. Dieses Umlenkelement (7) wird zum Aufweiten der Abstände zwischen den zumindest drei Teilstrahlen genutzt und kann damit ebenfalls den Winkel, in dem die Teilstrahlen auf das Substrat (5), bevorzugt flächiges und/oder transparentes Substrat, auftreffen, verändern. Es ist derart eingerichtet, dass es die Divergenz der zumindest drei Teilstrahlen erhöht und damit den Bereich, in dem die zumindest drei Teilstrahlen interferieren, entlang der optischen Achse des Strahlengangs (3) von der Laserstrahlungsquelle (1) wegzubewegen.

Unter Aufweiten der Abstände zwischen den zumindest drei Teilstrahlen wird im Sinne der Erfindung verstanden, dass sich der Winkel der jeweiligen Teilstrahlen zur optischen Achse des von der Laserstrahlungsquelle (1) emittierten Laserstrahls vergrößert.

Das Aufweiten und die dadurch erfolgende Umlenkung der Teilstrahlen hat den Vorteil, dass die Teilstrahlen durch das Fokussierelement (4) stärker gebündelt werden können. Somit ergibt sich eine höhere Intensität in dem Bereich, in dem die zumindest drei Teilstrahlen auf der Oberfläche des Substrats (5), bevorzugt flächigen und/oder transparenten Substrats, interferieren.

Durch die geeignete Wahl des Umlenkelements kann auf eine Einheit zur Kontrolle der Intensität des Laserstrahls verzichtet werden. In einer bevorzugten Ausgestaltung der Vorrichtung wird ein Umlenkelement (7) verwendet, dass durch die Aufweitung der zumindest drei Teilstrahlen das Fokussieren der zumindest drei Teilstrahlen auf dem Substrat (5) mittels eines Fokussierelements (4) erlaubt, wobei die Intensität der Interferenzpunkte auf der Oberfläche des Substrats, bevorzugt flächigen und/oder transparenten Substrats, ohne eine zusätzliche Einstellung der Intensität der Laserstrahlungsquelle (1) erreicht werden kann. Dies hat den Vorteil, dass zur Strukturierung des Substrates unter Erzeugen der periodischen Punktstruktur auch Laserstrahlungsquellen mit niedriger Intensität (Leistung pro Fläche) genutzt werden können, wodurch die optischen Elemente vor Verschleiß geschützt und geringe Strukturtiefen einfacher zu erzeugen sind.

### Weiteres Umlenkelement (6)

Des Weiteren kann vorgesehen sein, dass im Strahlengang (3) der Laserstrahlungsquelle (1) dem Strahlteilerelement (3) nachgeordnet ein weiteres Umlenkelement (6) angeordnet ist, das die Teilstrahlen derart umlenkt, dass sie nach Austritt aus dem weiteren Umlenkelement (6) im Wesentlichen parallel zueinander verlaufen. Dadurch kann die Vorrichtung derart eingerichtet sein, dass der Bearbeitungspunkt, also der Punkt in dem die zumindest drei Teilstrahlen auf der Oberfläche oder im Inneren des Substrats, bevorzugt flächigen und/oder transparenten Substrats, interferieren, bei Verschiebung des Strahlteilerelements im Strahlengang des Lasers entlang seiner optischen Achse konstant bleibt. Unter dem Begriff "im Wesentlichen parallel" soll im Rahmen dieser Schrift ein Winkelversatz von zwischen +15° und -15°, insbesondere lediglich von zwischen +10° und - 10°, ganz besonders bevorzugt von zwischen +5° und -5° zwischen den beiden Teilstrahlen, insbesondere aber natürlich kein Winkelversatz, also 0°, verstanden werden.

Das weitere Umlenkelement (6) kann eine konventionelle, refraktive Linse sein. Alternativ kann das weitere Umlenkelement (6) aber auch als diffraktive Linse (z. B. Fresnel-Linse) ausgestaltet sein. Diffraktive Linsen haben den Vorteil, dass diese wesentlich dünner und leichter sind, was eine Miniaturisierung der hierin offenbarten Vorrichtung vereinfacht.

Durch geeignete Auswahl der Brechungsindices der optischen Elemente (4), (6) und (7) können die Abstände zwischen optischen Elementen und Substrat, sowie die Interferenzperiode p eingestellt werden. Alle optischen Elemente mit Ausnahme des Strahlteilerelements (2) können vorzugsweise innerhalb des Strahlengangs (3) des Lasers fixiert sein. Diese besonders bevorzugte Ausführungsform bietet daher den Vorteil, dass zur Anpassung des Interferenzbereichs oder des Interferenzwinkels lediglich ein Element, nämlich das Strahlteilerelement (2), bewegt werden muss. Das erspart Arbeitsschritte bei der Einrichtung der Vorrichtung, wie Kalibrierung der Vorrichtung auf die gewünschte Interferenzperiode. Des Weiteren beugt eine fixe Einstellung, d.h. wobei vorzugsweise alle optischen Elemente innerhalb des Strahlengangs (3) des Lasers fixiert sind, der optischen Elemente deren Verschleiß vor.

### Polarisationselement (8)

In einer weiteren Ausführungsform befindet sich hinter dem Umlenkelement, besonders bevorzugt in einem Aufbau mit zwei Umlenkelementen (6), (7) hinter dem weiteren Umlenkelement (6), und vor dem Fokussierelement (4) in zumindest einem der Strahlengänge der zumindest 3 Teilstrahlen je ein Polarisationselement (8). Die Polarisationselemente können die Polarisation der Teilstrahlen zueinander modifizieren. Dadurch lässt sich das resultierende Interferenzmuster, das die zumindest 3 Teilstrahlen auf der Oberfläche oder im Volumen eines Substrats, bevorzugt flächigen und/oder transparenten Substrats, abbilden, modifizieren. Durch die Anordnung eines Polarisationselement (8) in zumindest einem der Strahlengänge der Teilstrahlen, vorzugsweise nicht in jedem Strahlengang der Teilstrahlen, vorzugsweise in einem Strahlengang bis (n-1) Strahlengängen, wobei n die Anzahl der erzeugten Teilstrahlen im Applikationsverfahrens, kann vorteilhaft die Polarisationsebene zumindest eines Teilstrahls im Strahlengang gedreht und somit das Muster eines Interferenzpixels in der Ebene des Substrates "gestört" werden.

Insbesondere können somit die interferierenden Teilstrahlen nicht polarisiert, linear polarisiert, zirkular polarisiert, elliptisch polarisiert, radial polarisiert oder azimutal polarisiert sein.

### Optisches Element zur Strahlformung

In einer weiteren Ausgestaltung besitzt die Laserstrahlungsquelle (1) ein Strahlungsprofil, das einem Gauß-Profil, wie oben beschrieben, entspricht. In einer solchen Ausführungsform kann sich hinter der Laserstrahlungsquelle (1) und vor dem Strahlteilerelement (2) ein weiteres optisches Element zur Strahlformung befinden. Dieses Element dient dazu, das Strahlungsprofil der Laserstrahlungsquelle einem Top-Hat-Profil anzugleichen.

Es kann in der erfindungsgemäßen Vorrichtung auch ein optisches Element mit einer konkav parabolisch oder planar reflektierenden Oberfläche vorgesehen sein, wobei das optische Element beispielsweise um mindestens eine Achse drehbar oder entlang des Strahlengangs (3) verschiebbar ausgebildet ist. Hierdurch kann gegebenenfalls auf ein zusätzliches im Strahlengang (3) positioniertes Fokussierelement (4) bzw. ein weiteres Umlenkelement (6) verzichtet werden. Beispielsweise können durch dieses optische Element Laserstrahlen oder Teillaserstrahlen auf die Oberfläche des Fokussierelements (4) oder ein weiteres fokussierendes optisches Element gerichtet werden, bevor die Strahlen zur Ausbildung von Strukturelementen das zu strukturierende Substrat erreichen.

Alternativ kann beispielsweise auch zumindest ein optisches Element mit einer konkav parabolisch oder planar reflektierenden Oberfläche vorgesehen sein, welches beispielsweise um mindestens eine Achse drehbar oder entlang des Strahlengangs (3) verschiebbar ausgebildet ist, wobei dieses optische Element dem ersten Umlenkelement (7) und dem weiteren Umlenkelement (6) im Strahlengang nachgeordnet positioniert ist. So können beispielsweise die Teilstrahlen im Strahlengang umgelenkt werden (Umlenkspiegel) oder derart im Strahlengang fokussiert werden, dass das zu strukturierende Substrat während der Bearbeitung ortsfest positioniert sein kann (sog. Fokussierspiegel bzw. Galvo-Spiegel (Laserscanner) (9)).

Ebenfalls denkbar ist auch eine Ausführungsform, welche einen Polygonscanner umfasst. In dieser Ausgestaltung umfasst zumindest ein optisches Element ein sich periodisch drehendes Prisma, bevorzugt ein sich periodisch drehendes Spiegelprisma, insbesondere einen Polygonspiegel oder auch Polygonrad, sowie ein dem sich periodisch drehenden Prisma im Strahlengang nachgeordnetes Fokussierelement (4). Das Fokussierelement ist derart eingerichtet, dass es die Teilstrahlen derart durchlaufen, dass die Teilstrahlen auf der Oberfläche oder im Inneren eines zu strukturierenden Substrats (5) in einem Interferenzbereich interferieren. In einer bevorzugten Ausgestaltung umfasst das optische Element weiterhin zumindest weiteres Umlenkelement, beispielsweise ein reflektierendes Umlenkelement zum Umlenken der Teilstrahlen im Strahlengang. Das zumindest eine weitere Umlenkelement kann dem sich periodisch drehenden Prisma im Strahlengang vor- und/oder nachgeordnet sein. Das zumindest eine weitere Umlenkelement ist dem Fokussierelement im Strahlengang vorgeordnet.

Ein solcher Aufbau erlaubt vorteilhaft das schnelle Abtasten einer Oberfläche eines Substrats, sodass eine hohe Strukturierungsrate von bis zu 3 m²/min, insbesondere im Bereich von 0,05 bis 2 m²/min, besonders bevorzugt im Bereich von 0,1 bis 1 m²/min, ganz besonders bevorzugt im Bereich von 0,1 bis 0,9 m²/min erreichbar ist. Die genaue Strukturierungsrate ist dabei insbesondere von der verfügbaren Laserleistung abhängig. Mit zukünftigen Technologien, welche eine höhere Laserleistung aufweisen, sind demzufolge noch höhere Strukturierungsraten erreichbar.

### Haltevorrichtung für das Substrat

In einer weiteren Ausgestaltung ist das Substrat (5), bevorzugt flächige und/oder transparente Substrat, in der xy-Ebene beweglich. Durch Bewegung des Substrats (5), bevorzugt flächigen und/oder transparenten Substrats, in der xy-Ebene kann eine flächige Bearbeitung mittels Laserinterferenzstrukturierung gewährleistet werden. Dabei wird in jedem Bearbeitungsschritt (d.h. Laserpuls, der auf das zu strukturierende Substrat trifft) ein Interferenzpixel (wie hierin definiert) erzeugt, der eine Größe D abhängig vom Einfallswinkel und der Intensitätsverteilung des Laserstrahls, sowie den Fokussierungseigenschaften der optischen Elemente besitzt. Der Abstand zwischen den verschiedenen Interferenzpixeln, die Pixeldichte Pd, wird durch die Wiederholrate der Laserstrahlungsquelle (1), sowie der Bewegung des Substrats in Relation zum Fokussierpunkt der optischen Elemente, also dem Punkt, in welchem der Interferenzbereich auf der Oberfläche oder im Inneren des Substrats erzeugt wird, bestimmt. Ist die Pixeldichte Pd kleiner als die Größe der Interferenzpixel D, so ist eine flächige, homogene Bearbeitung möglich.

Durch das Bewegen des Substrats in Relation zum Fokussierpunkt (welcher das Interferenzpixel erzeugt) in Kombination mit gepulsten Laser(teil-)strahlen kann somit eine flächige, optional homogene und periodische, Punktstruktur auf der Oberfläche eines Substrats, bevorzugt flächigen und/oder transparenten Substrats, erzeugt werden.

Alternativ zum Bewegen des Substrats in Relation zum Fokussierpunkt kann auch der Fokussierpunkt (bspw. durch scannerbasierte Methoden) über die Probe bzw. das Substrat geführt werden.

Eine Verschiebung des zu strukturierenden Substrates, bevorzugt flächigen und/oder transparenten Substrats, im Laserstrahl kann aufgrund der relativ großen dabei bewegten Massen vergleichsweise aufwändig und langsam sein. Es ist daher vorteilhaft das Substrat, bevorzugt flächige und/oder transparente Substrat während der Bearbeitung ortsfest vorzusehen und die flächige Strukturierung des Substrates dadurch zu realisieren, dass die Fokussierung der Teilstrahlen auf die Oberfläche des Substrats durch Manipulation der Laserteilstrahlen mit optischen Elementen (Fokussierspiegel bzw. Galvo-Spiegel (Laserscanner)) in Strahlrichtung bewirkt wird. Da die dabei bewegten Massen relativ klein sind, ist dies mit weit geringerem Aufwand bzw. viel schneller möglich. Vorzugsweise ist das Substrat während des Verfahrens ortsfest angeordnet.

### Verwendung des strukturierten Substrates

Das hierin definierte strukturierte Substrat mit Anti-Fogging-Eigenschaften findet beispielsweise Anwendung bei Photovoltaikanlagen, wobei durch die Einbringung der Anti-Fogging-Eigenschaften die Effizienz dieser Photovoltaikanlagen wesentlich erhöht werden kann. Eine große Herausforderung im Bereich der Photovoltaikanlagen liegt bei witterungsbedingten großen Verlusten aufgrund der Verschmutzung und/oder des Beschlagens der Oberflächen der Anlagen. Der Wirkungsgrad von Photovoltaikanlagen muss entsprechend stetig verbessert werden. Einer der vielversprechendsten Ansätze ist die Reduktion von witterungsbedingten Ausfällen mit Hilfe von Anti-Fogging-Beschichtungen und/oder Texturierungen der Oberfläche. Der Einsatz des hierin offenbarten Substrats und Verfahrens vereinfacht, beschleunigt und verbessert die Behandlung der Oberflächen und garantiert eine erhöhte Haltbarkeit der Strukturierung.

Darüber hinaus haben die Erfinder herausgefunden, dass sich das hierin definierte Substrat und Verfahren zur Strukturierung von Fensterscheiben (als ein weiteres Beispiel für eine Anti-Fogging-Verglasung) eignet. So können die hierin offenbarten strukturierten Substrate beispielsweise in Form einer Anti-Fogging-Verglasung oder als Folierung auf Häuserfassaden, bevorzugt mit flächigen und transparenten Substraten, als transparente Verglasungen verwendet werden, die beispielsweise zum Gewährleisten uneingeschränkter Sichtbedingungen bei schlechter Witterung nutzbar sind.

Darüber hinaus kann eine Reduktion der Bildung von Beschlag bei Mikroskopen und Teleskopen den Kontrast der damit aufgezeichneten Bilder erhöhen, wodurch die Effizienz und der Einsatz dieser optischen Geräte erhöht werden. Von der vorliegenden Erfindung ist daher auch die Verwendung eines hierin definierten strukturierten Substrats als optisches Element mit periodischen Punktstruktur im Mikro- und/oder Submikrometerbereich in optischen Geräten, wie bspw. Mikroskopen und Teleskopen mit umfasst, für die die Strahlführung, Strahlformung, Strahlbündelung und/oder Strahlfokussierung wesentlich sind.

Es ist ebenfalls zweckdienlich, dass hierin definierte strukturierte Substrat als Negativform (sog. Master) bspw. innerhalb eines Prägeprozesses zur indirekten Aufbringung oder Erzeugung von Strukturen auf einem anderen Substrat zu verwenden. Beispielsweise ist dies bei Rolle-zu-Rolle-Prozessen relevant, bei denen mit Hilfe eines Heiß- oder UV-Prägeprozesses Strukturen von einem sog. Master (meist Metall wie z.B. Nickel) auf eine Polymerfolie (z.B. PET) im Endlosverfahren übertragen werden. Somit können auf anderen Substraten die inversen Strukturen im Hochdurchsatz als periodische Punktstrukturen im Mikro- und/oder Submikrometerbereich erzeugt werden.

Die erfindungsgemäße Vorrichtung und das erfindungsgemäße Verfahren bieten außerdem die Möglichkeit, ohne großen technischen Aufwand ein flächiges und transparentes Substrat mit hydrophilen oder superhydrophilen zu erzeugen. Ein derart strukturiertes Substrat hat ein breites Anwendungsspektrum in Bereichen, in denen die homogenen Benetzungseigenschaften von hydrophilen und oder superhydrophilen Substraten erwünscht sind, bspw. im Bereich von Automobilkomponenten, Displays oder Verglasung, aber auch im Bereich der Luftfahrt oder Antennentechnik. Insbesondere sind die Anti-Fogging-Eigenschaften des erfindungsgemäßen Substrats in diesen Bereichen von Vorteil, da das Beschlagen von Verglasung in den genannten Bereichen besonders unerwünscht ist.

Weiterhin bietet das erfindungsgemäße Verfahren und die erfindungsgemäße Vorrichtung auch die Möglichkeit zum Erzeugen eines strukturierten Substrates, welches sich zur weiteren Bearbeitung, beispielsweise einer chemischen und/oder physikalischen Behandlung, insbesondere zum Beschichten mittels einer chemischen Sprühbeschichtung eignet, um die resultierenden Anti-Fogging-Eigenschaften und hydrophilen oder superhydrophilen Eigenschaften und/oder Antireflexionseigenschaften des Substrats zu steigern und/oder zu modifizieren.

### BEZUGSZEICHENLISTE

- 1: Laserstrahlungsquelle
- 2: Strahlteilerelement
- 3: Strahlengang
- 4: Fokussierelement
- 5: Substrat
- 6: weiteres Umlenkelement
- 7: Umlenkelement
- 8: Polarisationselement
- 9: Fokussierspiegel bzw. Galvo-Spiegel
- 91: Polygonrad
- 10: erstes Interferenzpixel
- 11: zweites Interferenzpixel
- 12: drittes Interferenzpixel
- 13: viertes Interferenzpixel
- 14: inverse Zapfen
- 14.1: inverse Zapfen des ersten Interferenzpixels
- 14.2: inverse Zapfen des zweiten Interferenzpixels
- 14.3: inverse Zapfen des dritten Interferenzpixels
- 14.4: inverse Zapfen des vierten Interferenzpixels
- 15: Versatz
- 16: Punktstruktur
- p₁: erste Interferenzperiode
- p₂: zweite Interferenzperiode
- 19: quasiperiodische Wellenstruktur
- 20: Wellenberg
- 21: Wellental
- 22: Defekt
- 23: Wasserkontaktwinkel
- 24: Flüssigkeit
- 25: Gasphase
- 26: Tangente
- 28: strukturierter Bereich
- 29: unstrukturierter Bereich
- A-A: Schnittlinie

### AUSFÜHRUNGSBEISPIELE

Anhand folgender Figuren und Ausführungsbeispiele wird die vorliegende Erfindung näher erläutert, ohne die Erfindung auf diese zu beschränken. Insbesondere sind in den einzelnen Figuren gezeigte und zu dem jeweiligen Beispiel beschriebene Merkmale nicht auf das jeweilige Einzelbeispiel beschränkt.

Dabei zeigt
- **Fig. 1:**: eine schematische perspektivische Ansicht einer Vorrichtung zur Durchführung des erfindungsgemäßen Verfahrens.
- **Fig. 2:**: eine schematische perspektivische Ansicht einer Vorrichtung zur Durchführung des erfindungsgemäßen Verfahrens, die ein Umlenkelement (6) zur Parallelisierung der Teilstrahlen enthält.
- **Fig. 3:**: eine schematische perspektivische Ansicht einer Vorrichtung zur Durchführung des erfindungsgemäßen Verfahrens, die ein Umlenkelement (7) zur Aufweitung des Winkels der Teilstrahlen zur optischen Achse des Strahlengangs (3) enthält.
- **Fig. 4A:**: eine schematische perspektivische Ansicht einer Vorrichtung zur Durchführung des erfindungsgemäßen Verfahrens, die optische Elemente (6) mit einer planaren, reflektierenden Oberfläche, die die Teilstrahlen auf das Fokussierelement (4) umlenken, enthält.
- **Fig. 4B:**: eine schematische perspektivische Ansicht einer Vorrichtung zur Durchführung des erfindungsgemäßen Verfahrens, die als optisches Element zur Strahlformung einen Galvo-Spiegel (9) umfasst, was eine ortsfeste Positionierung des zu strukturierenden Substrats während des Prozesses der Strukturierung erlaubt.
- **Fig. 5:**: eine schematische perspektivische Ansicht einer Vorrichtung zur Durchführung des erfindungsgemäßen Verfahrens, wobei die Vorrichtung ein Polarisationselement (8), welches den Phasenverlauf der Teilstrahlen zueinander verschiebt, enthält, wobei
a) das Strahlteilerelement (2) im Strahlengang (3) nah an der Laserstrahlungsquelle (1) positioniert ist.
b) das Strahlteilerelement (2) im Strahlengang (3) nah am Umlenkelement (7) positioniert ist.
- **Fig. 6:**: eine schematische Ansicht der sich auf der Oberfläche oder im Inneren des Substrats ergebenden Interferenzpixel mit der Weite D, und die Verteilung der einzelnen Interferenzpixel auf der Oberfläche oder im Inneren des Substrats, wobei die Interferenzpixel zueinander verschoben sind mit der Pixeldichte Pd.
- **Fig. 7:**: eine schematische perspektivische Ansicht des strukturierten Substrats (5) mit den erzeugten periodischen Punktstrukturen, bestehend aus inversen Zapfen, mit Abmessungen im Mikro- und Submikrometerbereich, und symbolisch die Transmission von einfallenden elektromagnetischen Wellen mit Wellenlängen größer als die Interferenzperiode der erzeugten Strukturen, sowie die Beugung von einfallenden elektromagnetischen Wellen mit Wellenlängen im Bereich oder kleiner der erzeugten Strukturen.
- **Fig. 8:**: eine schematische perspektivische Ansicht einer Vorrichtung zur Durchführung des erfindungsgemäßen Verfahrens, die als optisches Element einen Galvospiegel (9) mit einer planaren, reflektierenden Oberfläche, die die Teilstrahlen auf das Fokussierelement (4) umlenken, sowie ein Polygonrad (91) enthält.
- **Fig. 9:**: Eine grafische Darstellung des Diffraktionswinkels von einfallendem Licht über der Wellenlänge des einfallenden Lichts für strukturierte Substrate mit drei unterschiedlichen Strukturweiten.
- **Fig. 10:**: eine schematische perspektivische Ansicht des strukturierten Substrats (5) mit den erzeugten periodischen Punktstrukturen, bestehend aus inversen Zapfen, mit Abmessungen im Mikrometerbereich, der eine quasi-periodische Wellenstruktur im Submikrometerbereich überlagert ist.
- **Fig. 11A:**: eine schematische Darstellung eines inversen Zapfens.
- **Fig. 11B:**: eine schematische Darstellung einer zapfenähnlichen Vertiefung mit kreisförmiger Grundfläche.
- **Fig. 11C:**: eine schematische Darstellung einer zapfenähnlichen Vertiefung mit unregelmäßiger Grundfläche.
- **Fig. 12:**: einen kumulativen Aufbau der Punktstruktur aus einer Überlagerung mehrerer Interferenzpixel,
- **Fig. 13:**: eine Punktstruktur, welche aus der Überlagerung von mehreren ersten und zweiten Interferenzpixeln gebildet ist,
- **Fig. 14:**: eine schematische
**A)** Draufsicht und
**B)** eine Schnittansicht
   einer quasi-periodischen Wellenstruktur im Submikrometerbereich.
- **Fig. 15:**: eine Visualisierung des Wasserkontaktwinkels.

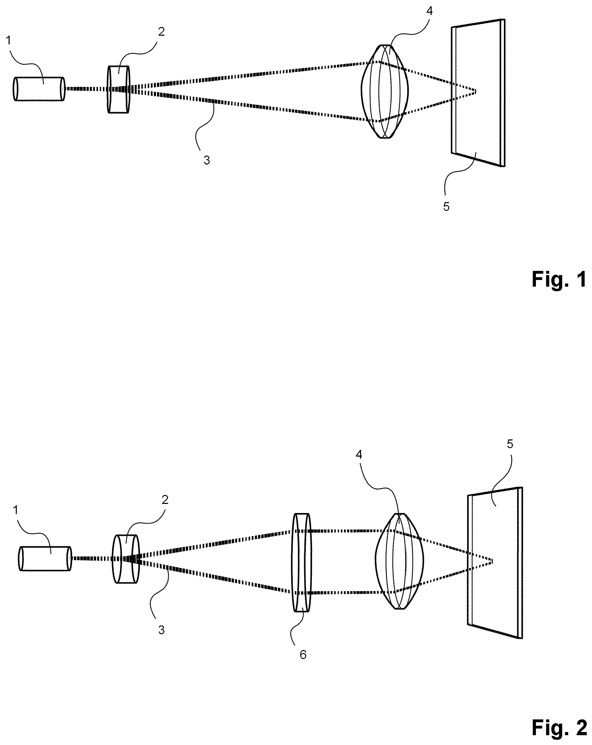

**Fig. 1** visualisiert in einem ersten Ausführungsbeispiel eine Vorrichtung wie sie in dem erfindungsgemäßen Verfahren zum Strukturieren eines Substrats mit Anti-Fogging-Eigenschaften verwendet wird, aufweisend eine Laserstrahlungsquelle (1) zum Emittieren eines Laserstrahls. Im Strahlengang (3) des Laserstrahls hinter der Laserstrahlungsquelle (1) angeordnet, befindet sich ein Strahlteilerelement (2), welches im Strahlengang (3) beweglich angeordnet ist. Im Strahlengang (3) des Laserstrahls hinter dem Strahlteilerelement (2) angeordnet, befindet sich ein Fokussierelement (4). Im Strahlengang (3) des Laserstrahls hinter dem Fokussierelement (4) angeordnet, befindet sich eine Haltevorrichtung, auf der ein Substrat (5), bevorzugt flächiges und/oder transparentes Substrat, gelagert ist.

In dieser Ausgestaltung emittiert die Laserstrahlungsquelle (1) einen gepulsten Laserstrahl. Es handelt sich hier bei der Laserstrahlungsquelle um einen UV Laser mit einer Wellenlänge von 355 nm Wellenlänge und einer Pulsdauer von 12 ps. Das Strahlungsprofil der Laserstrahlungsquelle entspricht in dieser Ausführungsform einem Top-Hat-Profil.

In diesem Ausführungsbeispiel entspricht das Strahlteilerelement (2) einem diffraktiven Strahlteilerelement. Ein diffraktives Strahlteilerelement ist hier ein Strahlteilerelement, welches Mikro- oder Nanostrukturen enthält. Das Strahlteilerelement (2) unterteilt den Laserstrahl in 4 Teilstrahlen.

Das Fokussierelement (4) entspricht in diesem Ausführungsbeispiel einer refraktiven, sphärischen Linse, die die im Wesentlichen parallel zueinander verlaufenden Teilstrahlen so auf das Substrat (5), bevorzugt flächige und/oder transparente Substrat, lenkt, dass sie dort in einem Interferenzbereich interferieren. Der Interferenzwinkel entspricht in dieser Ausgestaltung 27,2°, woraus eine Interferenzperiode von 550 nm für die periodische Punktstruktur bei dem gleichen Polarisationszustand resultiert.

Gemäß diesem Ausführungsbeispiel wird das flächige Substrat einmal bestrahlt, sodass sich eine Bearbeitungsdauer pro Struktureinheit, d. h. pro Interferenzpixel, von 12 ps ergibt.

Bei dem Substrat (5), bevorzugt flächigen und/oder transparenten Substrat, handelt es sich um ein Glas, ganz speziell ein Quarzglas, welches auf einer Haltevorrichtung gelagert ist, sodass es in der xy-Ebene, senkrecht zum Strahlengang des von der Laserstrahlungsquelle (1) emittierten Laserstrahls beweglich ist.

**Fig. 2** visualisiert in einem weiteren Ausführungsbeispiel die Vorrichtung wie in Fig. 1 beschrieben, zusätzlich aufweisend ein Umlenkelement (6), welches sich im Strahlengang (3) des Lasers nach dem Strahlteilerelement (2) und dem Fokussierelement (4) befindet.

In dieser Ausgestaltung ist das Umlenkelement eine konventionelle, refraktive, konvexe Linse. Die Teilstrahlen treffen derart auf das Umlenkelement (6) auf, dass sie nach Durchlaufen des Umlenkelements im Wesentlichen parallel zueinander verlaufen. Dadurch lässt sich der Punkt, in dem die Teilstrahlen auf der Oberfläche des Substrats interferieren, einstellen.

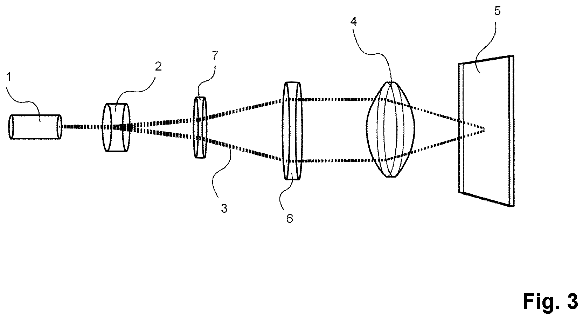

**Fig. 3** visualisiert in einem weiteren Ausführungsbeispiel eine Vorrichtung basierend auf dem in Fig. 1 und Fig. 2 gezeigten Aufbau. Zusätzlich umfasst dieser Aufbau ein weiteres Umlenkelement (7), welches im Strahlengang (3) des Lasers zwischen dem Strahlteilerelement (2) und dem Umlenkelement (6) angeordnet ist.

In dieser Ausgestaltung ist das weitere Umlenkelement (7) eine konventionelle, refraktive, konkave Linse. Die Teilstrahlen treffen derart auf das weitere Umlenkelement auf, sodass ihr Winkel zur optischen Achse des Strahlengangs aufgeweitet wird. Dadurch lässt sich der Interferenzwinkel, mit dem die Teilstrahlen auf der Oberfläche des Substrats, bevorzugt flächigen und/oder transparenten Substrats, interferieren, verändern.

In dieser Ausgestaltung sind alle optischen Elemente abgesehen vom Strahlteilerelement (2) entlang der optischen Achse des Strahlengangs (3) fixiert. Der Interferenzwinkel der Teilstrahlen auf dem Substrat wird über eine Verschiebung des Strahlteilerelements (2) entlang der optischen Achse des Strahlengangs eingestellt.

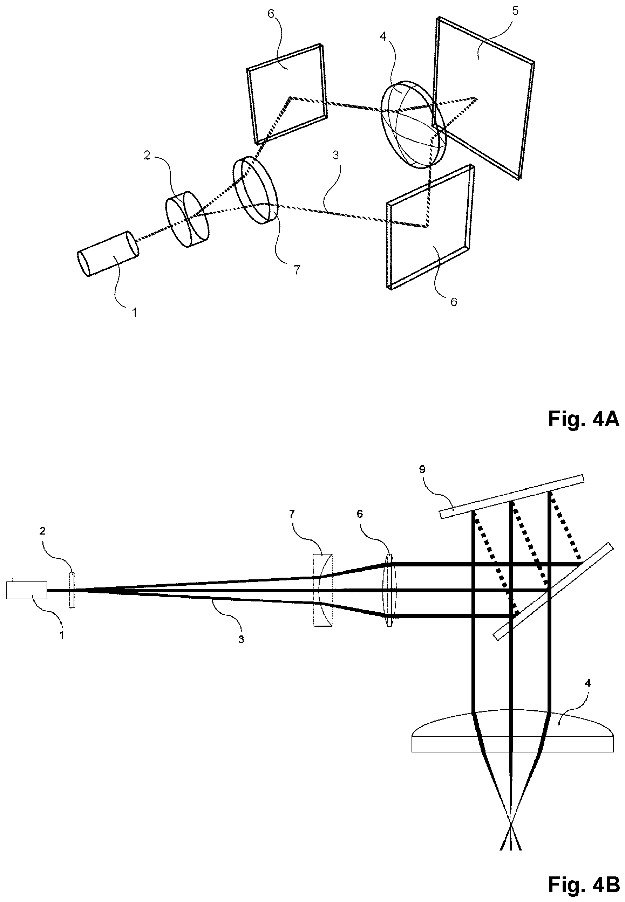

**Fig. 4A** zeigt in einem weiteren Ausführungsbeispiel eine Vorrichtung wie in Fig. 3, aufweisend die optischen Elemente (6) mit einer planaren, reflektierenden Oberfläche, die derart eingerichtet sind, dass sie die Teilstrahlen auf das Fokussierelement (4) umlenken.

In dieser Ausgestaltung werden die zumindest drei Teilstrahlen durch Verschiebung der optischen Elemente (6) in einem bevorzugten Winkel auf das Substrat gelenkt. Dadurch kann auf ein Umlenkelement in Form einer Linse (Bezugszeichen (6) in Fig. 3) verzichtet werden.

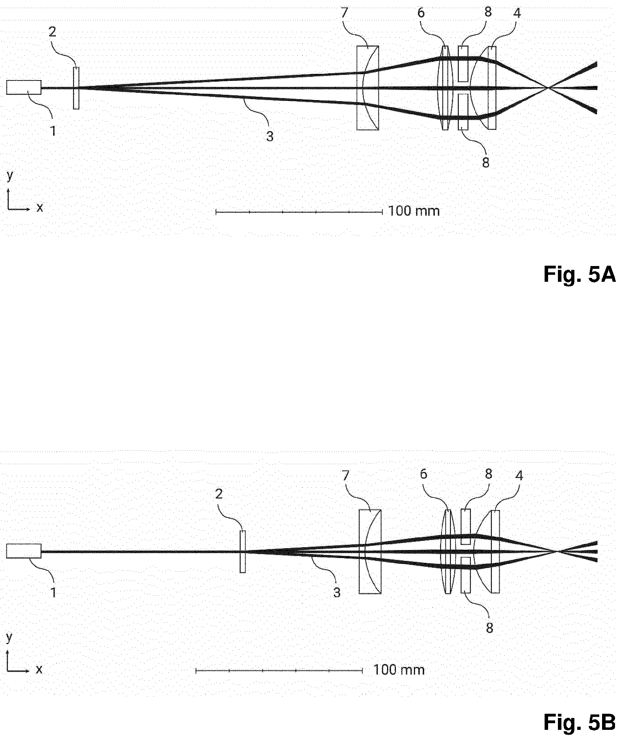

**Fig. 5** visualisiert in einem weiteren Ausführungsbeispiel eine Vorrichtung wie in Fig. 3, zusätzlich aufweisend je ein Polarisationselement (8) pro Teilstrahl, welche im Strahlengang (3) des Laserstrahls zwischen dem Umlenkelement (6) und dem Fokussierelement (4) angeordnet sind.

Das Polarisationselement ist derart angeordnet, dass es die Polarisierung der einzelnen Teilstrahlen zueinander so verändert, dass sich eine Veränderung des Interferenzmusters ergibt.

Diese Ausgestaltung ist in zwei unterschiedlichen Konfigurationen dargestellt. In Fig. 5 a) ist das Strahlteilerelement (2) im Strahlengang (3) nah an der Laserstrahlungsquelle (1) positioniert. In Fig. 5 b) ist das Strahlteilerelement (2) im Strahlengang (3) nah am Umlenkelement (7) positioniert. Auf diese Weise lässt sich das Interferenzmuster der interferierenden Teilstrahlen auf der Oberfläche des Substrats (5) stufenlos einstellen, ohne dass die anderen optischen Elemente im Aufbau oder das Substrat bewegt werden müssen.

Zusätzlich wäre es auch denkbar, dass die Anordnung ein zusätzliches optisches Element zur Strahlformung enthält, das im Strahlengang (3) des Laserstrahls der Laserstrahlungsquelle (1) nachgeordnet ist. In dieser Ausgestaltung entspricht das Strahlungsprofil der Laserstrahlungsquelle einem Gauß-Profil. Das optische Element zur Strahlformung wandelt dieses Profil in ein Top-Hat-Profil um.

**Fig. 6** enthält eine schematische Ansicht der sich auf der Oberfläche des Substrats ergebenden Interferenzpixel mit der Weite D, und die Verteilung der einzelnen Interferenzpixel auf der Oberfläche oder im Inneren des Substrats, wobei die Interferenzpixel zueinander verschoben sind mit der Pixeldichte Pd.

In dieser Ausgestaltung ist die Pixeldichte Pd kleiner als die Weite eines Interferenzpixels, D. Dadurch kann durch Bewegen des Substrats (5) mittels eines gepulsten Laserstrahls eine flächige homogene periodische Punktstruktur auf der Oberfläche eines Substrats, bevorzugt flächigen und/oder transparenten Substrats, erzeugt werden.

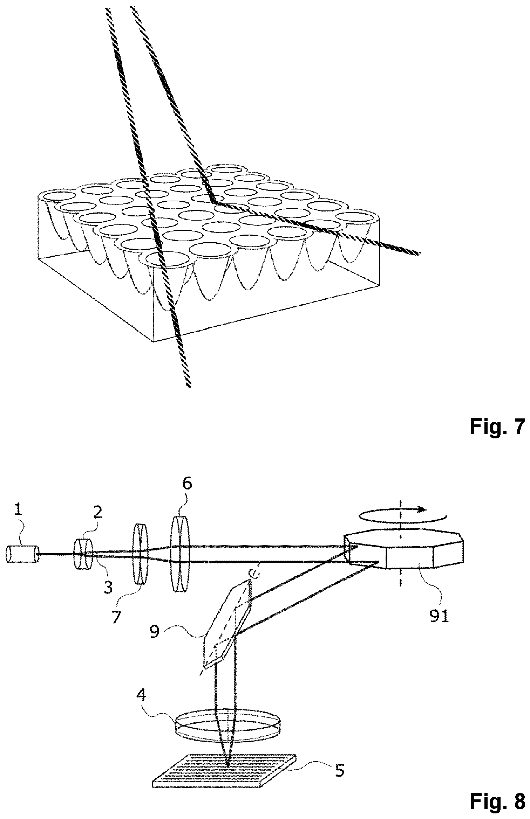

**Fig. 7** visualisiert das durch das erfindungsgemäße Verfahren erzeugte strukturierte Substrat (5) mit den erzeugten periodischen Punktstrukturen, bestehend aus inversen Zapfen, mit Abmessungen im Mikro- und Submikrometerbereich. Es wird zudem symbolisch die Transmission von einfallenden elektromagnetischen Wellen mit Wellenlängen größer als die Interferenzperiode der erzeugten Strukturen, sowie die Beugung von einfallenden elektromagnetischen Wellen mit Wellenlängen im Bereich oder kleiner der erzeugten Strukturen verdeutlicht.

**Fig. 8** zeigt in einem weiteren Ausführungsbeispiel eine Vorrichtung wie in Fig. 4B, aufweisend das optische Element (91) mit einer planaren, reflektierenden Oberfläche, wobei es sich um ein Polygonrad handelt, welches derart eingerichtet ist, dass es um eine eingezeichnete Achse rotiert. Dabei werden die einfallenden Teilstrahlen derart abgelenkt, dass sie auf einen Galvospiegel (9) treffen, welcher die Strahlen über ein Fokussierelement (4) auf das Substrat lenkt. Die Rotation des Polygonrads bewirkt dabei, dass der Punkt, in dem die Strahlen auf dem Substrat gebündelt werden während des Belichtungsprozesses entlang einer Linie beweglich ist. Die Teilstrahlen scannen also das Substrat, was zu einer erhöhten Prozessgeschwindigkeit führt.

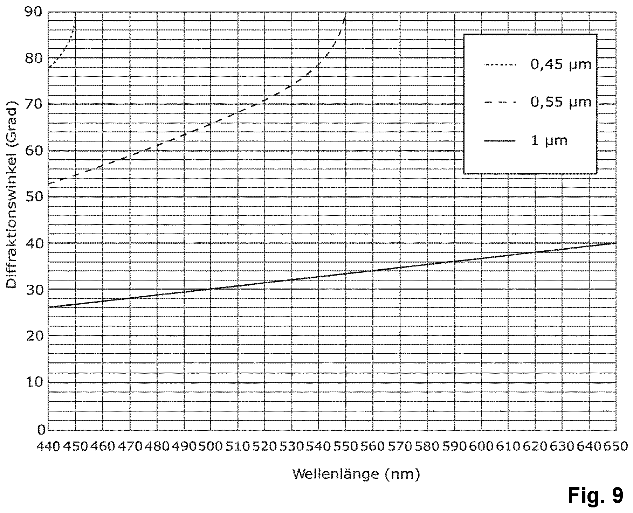

**Fig. 9** zeigt in einer grafischen Darstellung die Transmissions- bzw. Beugungsfähigkeit von einem strukturierten Substrat abhängig von der Strukturweite auf. Dabei wird der Diffraktionswinkel von Licht in Abhängigkeit von dessen Wellenlänge für Strukturen mit drei unterschiedlichen Strukturweiten gezeigt. Ist die Wellenlänge des einfallenden Lichts größer als die Strukturweite, so wird das Licht vollständig transmittiert. Bei Wellenlängen im Bereich der Strukturweite oder kleiner kommt es zur Diffraktion. Die Diffraktionswinkel können aus der Grafik entnommen werden.

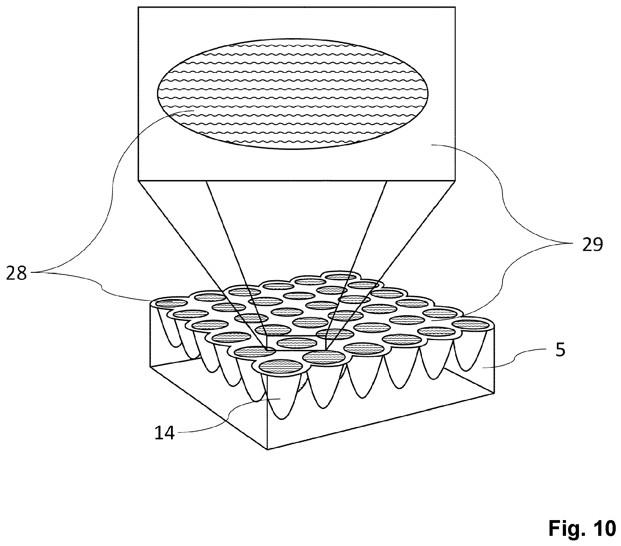

**Fig. 10** visualisiert das durch das erfindungsgemäße Verfahren erzeugte strukturierte Substrat (5) mit den erzeugten periodischen Punktstrukturen, bestehend aus inversen Zapfen 14, mit Abmessungen im Mikrometerbereich. Dieser periodischen Punktstruktur im Mikrometerbereich überlagert ist eine quasi-periodische Wellenstruktur im Submikrometerbereich, welche ebenfalls durch das hierin beschriebene erfindungsgemäße Verfahren in einem Produktionsschritt mittels Mehrfachbestrahlung oder einer hohen Laserpulsenergie erzeugbar ist. Dabei besteht ein strukturierter Bereich 28 aus den auf der Oberfläche vorhandenen Strukturen, insbesondere aus den inversen Zapfen 14 sowie den überlagerten quasi-periodischen Linienstrukturen. Ein unstrukturierter Bereich 29 besteht dabei aus dem Abschnitt der Oberfläche der keine strukturierten Bereiche, insbesondere keine inversen Zapfen 14 und keine Linienstrukturen, aufweist.

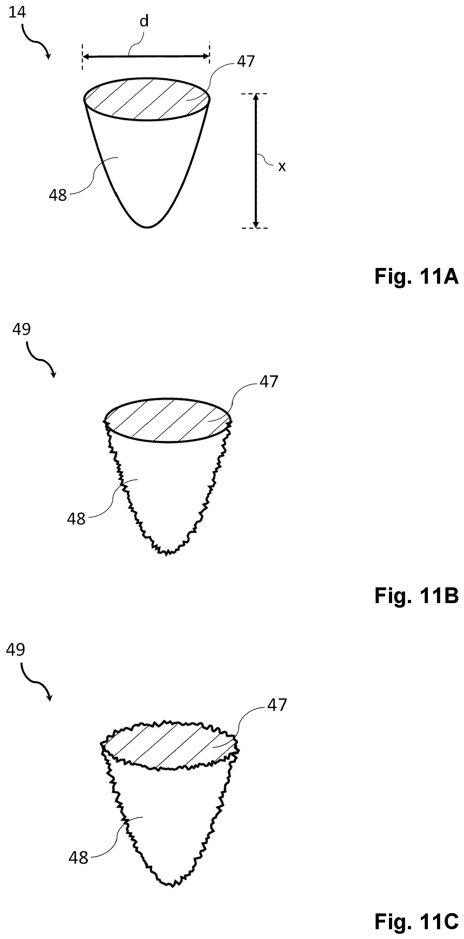

In **Fig. 11A** ist eine schematische Darstellung eines mittels eines Laserinterferenzverfahrens erzeugten inversen Zapfens 14, welcher die Strukturtiefe x aufweist, dargestellt. Die Grundfläche 47 des inversen Zapfens 14 ist hier kreisförmig mit einem Durchmesser d ausgebildet. Die Seitenflächen 48 sind glatt ausgebildet.

Eine schematische Darstellung einer zapfenähnlichen Vertiefung 49, wie sie beispielsweise mittels eines Ätzprozesses unter Verwendung einer, hier nicht dargestellten Maske mit kreisförmigen Öffnungen, generiert werden kann, ist in Fig. 11B gezeigt. Die dargestellte Grundfläche 47 ist zwar kreisförmig, aber die Seitenflächen 48 sind unregelmäßig ausgebildet.

In **Fig. 11C** ist schematische Darstellung einer zapfenähnlichen Vertiefung 49 mit unregelmäßiger Grundfläche 47 und unregelmäßiger, völlig variabler Seitenfläche 48 dargestellt. Eine derartige Vertiefung wird beispielsweise beim Ätzen ohne Maske generiert.

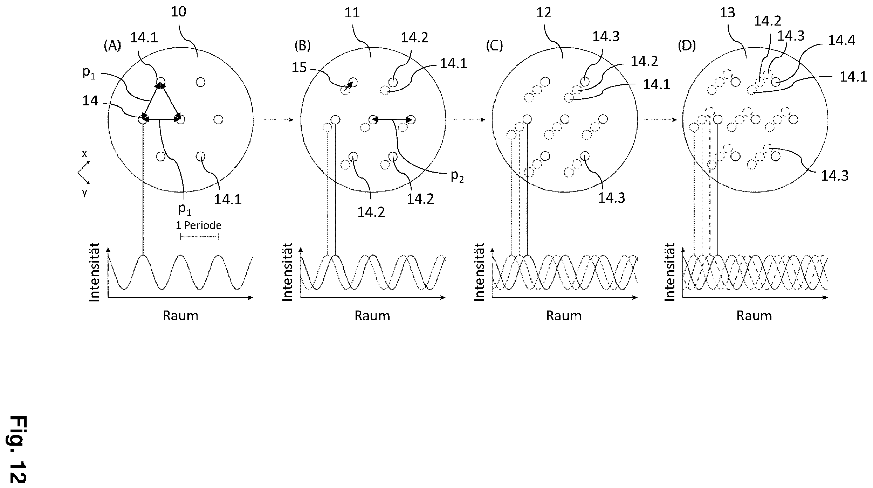

**Fig. 12** visualisiert den kumulativen Aufbau der Punktstruktur aus einer Überlagerung mehrerer Interferenzpixel (10, 11, 12, 13). Jedes Interferenzpixel (10, 11, 12, 13) besteht aus mehreren mittels Laserinterferenzstrukturierung in das Substrat eingebrachten inversen Zapfen (14).

In Teilbild (A) ist das erste Interferenzpixel (10) gezeigt, welches mehrere inverse Zapfen (14, 14.1) aufweist. Teilbild (B) visualisiert eine Überlagerung aus dem ersten Interferenzpixel (10) und dem zweiten Interferenzpixel (11), wobei diese Überlagerung aus inversen Zapfen (14.1) des ersten Interferenzpixels (10) und aus inversen Zapfen (14.2) des zweiten Interferenzpixels (11) besteht.

Dabei besteht ein Versatz (15) zwischen dem ersten Interferenzpixel (10) und dem zweiten Interferenzpixel (11), wodurch die inversen Zapfen (14.2) des zweiten Interferenzpixels (11) um diesen Versatz (15) gegenüber den inversen Zapfen (14.1) des ersten Interferenzpixels (10) verschoben sind.

Teilfigur (C) visualisiert eine Überlagerung, bei der zusätzlich ein drittes Interferenzpixel (12) mit den ersten beiden Interferenzpixeln (10, 11) überlagert ist. Die überlagerte Struktur in Teilbild (C) weist somit inverse Zapfen (14.1) des ersten Interferenzpixels (10), inverse Zapfen (14.2) des zweiten Interferenzpixels (11) sowie inverse Zapfen (14.3) des dritten Interferenzpixels (12) auf. Das dritte Interferenzpixel (12) ist in diesem Ausführungsbeispiel zum zweiten Interferenzpixel (11) in derselben Raumrichtung entlang der x-Achse verschoben, wie das zweite Interferenzpixel (11) zum ersten Interferenzpixel (10).

Teilbild (D) zeigt eine Überlagerung, bei der weiterhin ein viertes Interferenzpixel (13) überlagert ist, wobei dies gegenüber dem dritten Interferenzpixel (12) in einer anderen Raumrichtung entlang der y-Achse verschoben ist. Somit weist der Ausschnitt in Teilbild (D) eine Punktstruktur aus einer Überlagerung aus vier Interferenzpixeln (10, 11, 12, 13) auf.

Die Graphen, welche unterhalb der Interferenzpixel (10, 11, 12, 13) angeordnet sind, dienen der Visualisierung der periodischen Strukturen innerhalb eines Interferenzpixels (10, 11, 12, 13). Aufgrund der Entstehung der Interferenzpixel (10, 11, 12, 13) über den Prozess der Laserinterferenzstrukturierung, also entsprechend des Interferenzbildes der Laser(teilstrahlen), weist jedes einzelne Interferenzpixel (10, 11, 12, 13), welches innerhalb eines Beleuchtungs- oder Bestrahlungsprozesses innerhalb einer ausgewählten Pulsdauer entstanden ist, eine periodische Anordnung der inversen Zapfen (14) auf. Der Abstand der inversen Zapfen (14.1) des ersten Interferenzpixels (10), der aus dem Abstand der Intensitätsmaxima des das erste Interferenzpixel (10) erzeugenden Interferenzbildes resultiert, stellt die Interferenzperiode (p1) dar. Die Intensität entspricht dabei der zur Erzeugung der inversen Zapfen (14.1) notwendigen Intensität im Interferenzmuster der Laser(teil-)strahlen. Somit entspricht der Abstand der Intensitätsmaxima des Interferenzbildes der Interferenzperiode (p₁). Das zweite Interferenzpixel (11) weist dabei eine zweite Interferenzperiode (p₂) auf.

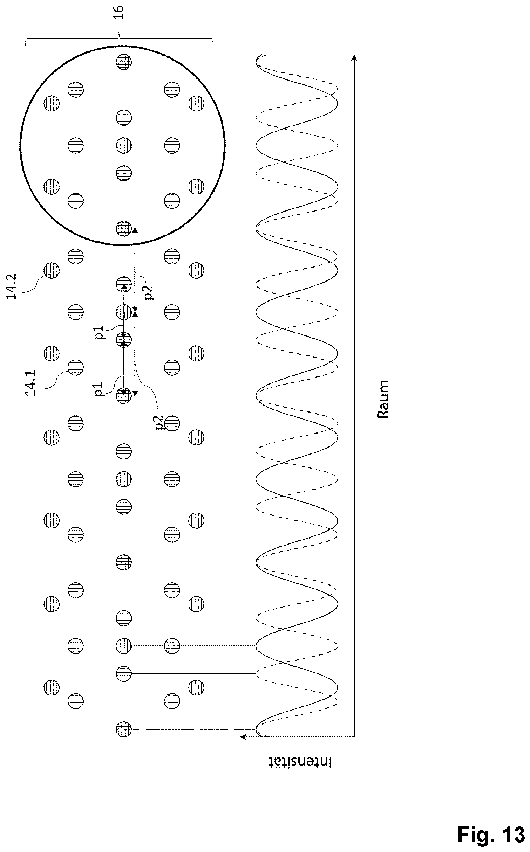

**Fig. 13** zeigt eine Punktstruktur (16), welche aus der Überlagerung von mehreren ersten Interferenzpixeln (10) mit einer ersten Interferenzperiode (p₁) und mehreren zweiten Interferenzpixeln (11) mit einer zweiten Interferenzperiode (p₂) gebildet ist. Die ersten Interferenzpixel (10) weisen dabei inverse Zapfen (14.1) auf, welche hier mit einer vertikalen Musterfüllung dargestellt sind. Die zweiten Interferenzpixel (11) weisen inverse Zapfen (14.2) auf, welche mit einer horizontalen Musterfüllung dargestellt sind. Die Interferenzperiode (p₁) des ersten Interferenzpixels (10) ist kleiner als die zweite Interferenzperiode (p2) des zweiten Interferenzpixels (11).

In einer optionalen Einstellung der Interferenzpixel (10, 11) derart, dass die Anzahl der inversen Zapfen (14.1, 14.2) innerhalb der Interferenzpixel (10, 11) identisch ist, variiert folglich die Fläche der Interferenzpixel (10, 11), was hier durch die Kreise visualisiert ist. Eines der ersten Interferenzpixel (10) ist hier durch sämtliche inverse Zapfen (14.1) mit vertikaler Musterfüllung innerhalb des kleineren Kreises schematisch dargestellt. Eines der zweiten Interferenzpixel ist wiederum durch die inversen Zapfen (14.2), die mit einer horizontalen Musterstrukturierung dargestellt sind, innerhalb des größeren Kreises visualisiert.

Dabei sind die mehreren ersten Interferenzpixel (10) benachbart repetitiv versetzt zueinander angeordnet und die mehreren ersten Interferenzpixel (10) bilden dadurch ein Muster mit der Interferenzperiode (p₁). Weiterhin sind die mehreren der zweiten Interferenzpixel (11) benachbart repetitiv versetzt zueinander angeordnet und die mehreren der zweiten Interferenzpixel (11) bilden somit ein Muster mit der sich von der ersten Interferenzperiode (p₁) unterscheidenden zweiten Interferenzperiode (p₂).

Der unterhalb der Punktstruktur (16) angeordnete Graph visualisiert die Anordnung der inversen Zapfen (14.1, 14.2) entlang einer Linie durch die Punktstruktur (16). Die Maxima der Intensität entsprechen dabei dem Mittelpunkt der inversen Zapfen (14.1, 14.2). Wie in Fig. 12 dient dieser Graph der Darstellung des Prinzips. Die Intensität entspricht dabei dem zur Erzeugung der inversen Zapfen (14.1, 14.2) notwendigen Intensität im Interferenzmuster der Laser(teil )strahlen.

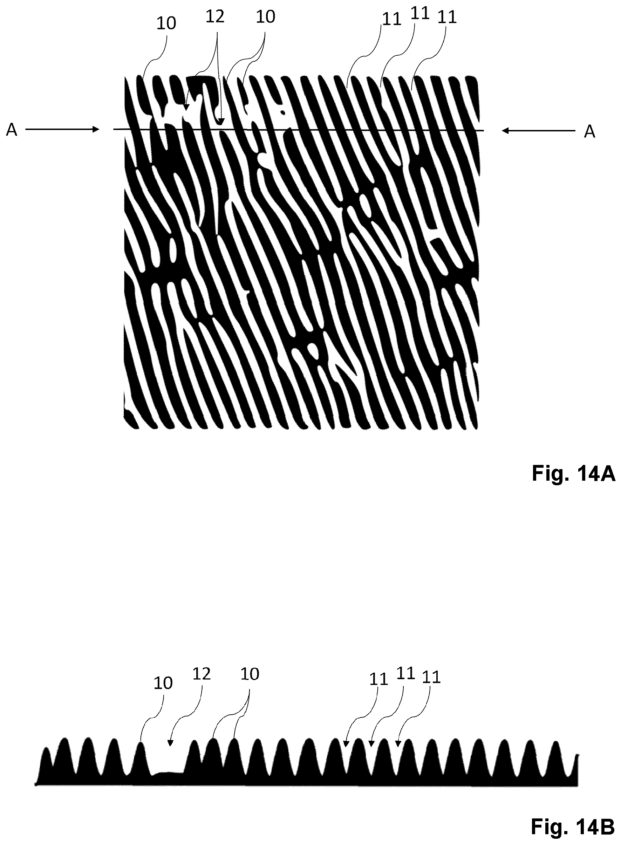

**Fig. 14A** visualisiert eine quasi-periodische Wellenstruktur in einer Draufsicht und **Fig. 14B** in einer Schnittansicht, wie sie ein strukturiertes Substrat aufweist, welches durch ein hierin offenbartes Verfahren, insbesondere durch eine Mehrfachbestrahlung oder durch eine Einfachbestrahlung mit hoher Intensität, erzeugt werden kann. Dabei stellt die Schnittansicht der Fig. 14B einen Querschnitt durch die in Fig. 14A dargestellte Struktur etwa entlang der Schnittlinie A-A dar. In den Materialien auftretende Selbstorganisationsprozesse führen dazu, dass wellenförmige Strukturen mit Wellenbergen 10 und Wellentälern 11 innerhalb eines derart bestrahlten Bereiches entstehen. Die entstehenden Strukturen weisen dabei grundsätzlich eine gewisse Periodizität auf, wobei allerdings auch Defekte 12, also Unregelmäßigkeiten, auftreten. Somit weist eine derartige Struktur im Gegensatz zu einer echt periodischen Struktur sowohl Abweichungen in den Strukturabmessungen, insbesondere bei den Abständen der Wellenberge zu den Wellentälern, als auch Defekte auf, sodass die erzeugte Wellenstruktur nicht homogen ausfällt.

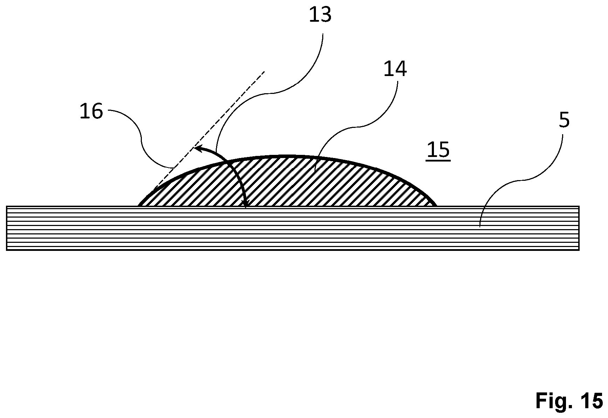

Eine Visualisierung des Wasserkontaktwinkels 13 ist in **Fig. 15** dargestellt. Eine Flüssigkeit 14 ist hier in Tropfenform auf einem Substrat 5 angeordnet. Außerhalb des Flüssigkeitstropfens liegt Luft in Gasphase vor. Als Wasserkontaktwinkel 13 wird dabei der Winkel zwischen der Oberfläche des Substrates 5 und der am Flüssigkeitstropfen anliegenden Tangente 16 bezeichnet. Die Tangente 16 wird dabei an der Oberfläche des Substrates 5 anliegend betrachtet.

## Patentansprüche

1. **Strukturiertes Substrat** (5), mit einer Oberfläche mit Anti-Fogging-Eigenschaften, wobei die Oberfläche aus einem strukturierten (28) und einem unstrukturierten Bereich (29) besteht,
wobei der strukturierte Bereich (28)
a) durch eine erste periodische Punktstruktur im Mikro- oder Submikrometerbereich mit einer ersten Interferenzperiode (p₁) im Bereich von 50 nm bis 50 µm gebildet wird; oder
b) durch eine erste periodische Punktstruktur im Mikro- und/oder Submikrometerbereich mit einer ersten Interferenzperiode (p₁) im Bereich von 50 nm bis 2,0 µm oder im Bereich von 9,5 µm bis 50 µm gebildet wird,
wobei die erste periodische Punktstruktur aus inversen Zapfen (14) gebildet ist, wobei die inversen Zapfen in das zu strukturierende Substrat ausgebildet sind, **dadurch gekennzeichnet, dass** die inversen Zapfen eine abgerundete Kegelspitze aufweisen, und dass die die erste Punktstruktur aufweisende Oberfläche des Substrates bei Benetzen mit Wasser einen Wasserkontaktwinkel (23) von unter 20°, vorzugsweise unter 10°, bevorzugt unter 5° aufweist.

2. Strukturiertes Substrat (5) nach Anspruch 1, wobei das strukturierte Substrat (5) ein Material aufweist, dessen unstrukturierte Oberfläche hydrophile Eigenschaften aufweist, wobei die erste periodische Punktstruktur an und/oder in diesem Material angeordnet ist.

3. Strukturiertes Substrat (5) nach Anspruch 1 oder 2, wobei der unstrukturierte Bereich der Oberfläche hydrophile Eigenschaften, vorzugsweise einen Wasserkontaktwinkel von kleiner als 90° aufweist.

4. Strukturiertes Substrat (5) nach einem der Ansprüche 1 bis 3, wobei die erste periodische Punktstruktur eine Strukturtiefe im Bereich von 0,05 µm und 2 µm aufweist.

5. Strukturiertes Substrat (5) nach einem der Ansprüche 1 bis 4, wobei das Substrat (5) in einem Teilbereich des elektromagnetischen Spektrums einen Transmissionsgrad von wenigstens 50 % oder vorzugsweise wenigstens 70 % oder besonders bevorzugt wenigstens 80 % oder wenigstens 90 % für jede Wellenlänge in dem Teilbereich aufweist.

6. Strukturiertes Substrat (5) nach Anspruch 5, wobei der Teilbereich elektromagnetische Strahlung im Bereich von 380 nm bis 780 nm umfasst,
wobei die Transmission in diesem Teilbereich wenigstens 50 % für jede Wellenlänge in dem Teilbereich ist.

7. Strukturiertes Substrat (5) nach einem der Ansprüche 1 bis 6, wobei die die erste Punktstruktur aufweisende Oberfläche des Substrates hydrophile und/oder superhydrophile Eigenschaften aufweist.

8. Strukturiertes Substrat (5) nach Anspruch 7, wobei der Wasserkontaktwinkel (23) über die die erste periodische Punktstruktur aufweisende Oberfläche nur um maximal 5°, vorzugsweise maximal 3°, variiert.

9. Strukturiertes Substrat (5) nach einem der Ansprüche 1 bis 8, wobei der ersten periodischen Punktstruktur mit Abmessungen im Mikro- und/oder Submikrometerbereich eine Linienstruktur mit Abmessungen im Mikro- und/oder Submikrometerbereich überlagert ist.

10. Strukturiertes Substrat (5) nach Anspruch 9, wobei die der ersten periodischen Punktstruktur überlagerte Linienstruktur periodisch ist, wobei die periodische Linienstruktur das Substrat (5) innerhalb eines Interferenzpixels gleichmäßig strukturiert, und die Linienstruktur eine Interferenzperiode aufweist, welche Abmessungen im Bereich von 1 % bis 30 % der Interferenzperiode der ersten periodischen Punktstruktur aufweist.

11. **Verfahren zum Herstellen eines Substrats** (5) mit einer periodischen Punktstruktur im Mikro- und/oder Submikrometerbereich welches Anti-Fogging-Eigenschaften aufweist gemäß einem der Ansprüche 1 bis 10 mittels direkter Laserinterferenzstrukturierung aufweisend die folgenden Schritte:
a. Bereitstellen eines Substrats,
b. Aufbringen einer ersten periodischen Punktstruktur mit einer ersten Interferenzperiode,
wobei die periodische Punktstruktur durch das Überlagern von mittels eines Strahlteilerelements (2) aus einem Laserstrahl geteilten Laserteilstrahlen in einem Interferenzbereich, auch Interferenzpixel, ausgebildet wird,
wobei die erste periodische Punktstruktur aus inversen Zapfen (14) gebildet ist, wobei die inversen Zapfen in das zu strukturierende Substrat ausgebildet sind,
**dadurch gekennzeichnet, dass**
A) die Interferenzperiode der periodischen Punktstruktur im Bereich von 50 nm bis 50 µm liegt und die periodische Punktstruktur mit der ersten Interferenzperiode innerhalb eines Interferenzpixels mittels Einfachbestrahlung durch einen Laserpuls erzeugt wird, oder
B) die Interferenzperiode der periodischen Punktstruktur im Bereich von 50 nm bis 2,0 µm oder im Bereich von 9,5 µm bis 50 µm liegt und die periodische Punktstruktur mit der ersten Interferenzperiode innerhalb eines Interferenzpixels mittels mehrerer aufeinanderfolgender Laserpulse durch eine Mehrfachbestrahlung oder durch eine Einfachbestrahlung durch einen Laserpuls erzeugt wird.

12. Verfahren nach Anspruch 11, wobei eine Mehrfachbestrahlung mit identischen Verfahrensparametern eines Interferenzpixels erfolgt, sodass sich durch Selbstorganisationsprozesse eine der ersten periodischen Punktstruktur überlagerte quasi-periodische Linienstruktur als Wellenstruktur ausbildet.

13. Verfahren nach einem der Ansprüche 11 oder 12, wobei durch Mehrfachbestrahlung mit abweichenden Verfahrensparametern eine weitere periodische Punktstruktur oder periodische Linienstruktur mit einer zur ersten Interferenzperiode identischen oder einer von der Interferenzperiode der ersten periodischen Punktstruktur verschiedenen Interferenzperiode auf das Substrat (5) aufgebracht wird.

14. Verfahren nach einem der Ansprüche 11 bis 13, wobei das Verfahren zusätzlich die folgenden Schritte umfasst:
c. Bereitstellen eines weiteren Substrats (5), wobei das weitere Substrat vorzugsweise transparent ist
d. Prägen des ersten Substrats auf das weitere Substrat (5), sodass auf diesem eine periodische Punktstruktur aufweisend Zapfen ausgebildet wird.

15. **Verwendung** des strukturierten Substrats (5) nach einem der Ansprüche 1 bis 10 als Anti-Fogging-Verglasung im Bereich der Automobilanwendung, Luft- und Raumfahrt, Gebäudeverglasung und Optik oder Photovoltaikanlagen.

## Claims

1. **Patterned substrate** (5) comprising a surface with anti-fogging properties, wherein the surface consists of a patterned region (28) and an unpatterned region (29),
wherein the patterned region (28)
a) is formed by a first periodic dot structure in the micro- or sub-micrometer range with a first interference period (p₁) in the range of 50 nm to 50 µm;
or
b) is formed by a first periodic dot structure in the micro- and/or sub-micrometer range with a first interference period (p₁) in the range from 50 nm to 2.0 µm or in the range from 9.5 µm to 50 µm,
wherein the first periodic dot structure is formed of inverse cones (14), wherein the inverse cones are formed into the substrate to be patterned,
**characterized in that**
the inverse cones comprise a rounded cone tip,
and **in that** the surface of the substrate comprising the first dot structure comprises a water contact angle (23) of less than 20°, preferably less than 10°, preferably less than 5° when wetted with water.

2. Patterned substrate (5) according to claim 1, wherein the patterned substrate (5) comprises a material whose unpatterned surface has hydrophilic properties, wherein the first periodic dot structure is arranged on and/or within this material.

3. Patterned substrate (5) according to claim 1 or 2, wherein the unpatterned region of the surface comprises hydrophilic properties, preferably a water contact angle of less than 90°.

4. Patterned substrate (5) according to any one of claims 1 to 3, wherein the first periodic dot structure comprises a structure depth in the range from 0.05 µm to 2 µm.

5. Patterned substrate (5) according to any one of claims 1 to 4, wherein the substrate (5) comprises a transmittance in a partial range of the electromagnetic spectrum of at least 50% or preferably at least 70% or particularly preferably at least 80% or at least 90% for each wavelength in the partial range of the electromagnetic spectrum.

6. Patterned substrate (5) according to claim 5, wherein the partial range comprises electromagnetic radiation in the range from 380 nm to 780 nm,
wherein the transmission in said partial range is at least 50% for each wavelength in said partial range.

7. Patterned substrate (5) according to any one of claims 1 to 6, wherein the surface of the substrate comprising the first dot structure comprises hydrophilic and/or super-hydrophilic properties.

8. Patterned substrate (5) according to claim 7, wherein the water contact angle (23) over the surface comprising the first periodic dot structure varies only by a maximum of 5°, preferably a maximum of 3°.

9. Patterned substrate (5) according to any one of claims 1 to 8, wherein a line structure with dimensions in the micro- and/or sub-micrometer range is superimposed on the first periodic dot structure with dimensions in the micro- and/or sub-micrometer range.

10. Patterned substrate (5) according to claim 9, wherein the line structure superimposed on the first periodic dot structure is periodic, wherein the periodic line structure patterns the substrate (5) uniformly within an interference pixel, and the line structure comprises an interference period which comprises dimensions in the range of 1% to 30% of the interference period of the first periodic dot structure.

11. **Method for producing a substrate** (5) with a periodic dot structure in the micro- and/or sub-micrometer range which comprises anti-fogging properties according to any one of claims 1 to 10 by means of direct laser interference patterning, comprising the following steps:
a) providing a substrate,
b) applying a first periodic dot structure having a first interference period,
wherein the periodic dot structure is formed by superimposing partial laser beams divided from a laser beam by means of a beam splitter element (2) in an interference region, also referred to as an interference pixel,
wherein the first periodic dot structure is formed of inverse cones (14), wherein the inverse cones are formed into the substrate to be patterned,
**characterized in that**
A) the interference period of the periodic dot structure is in the range of 50 nm to 50 µm and the periodic dot structure with the first interference period is generated within an interference pixel by means of single irradiation by a laser pulse,
or
B) the interference period of the periodic dot structure is in the range from 50 nm to 2.0 µm or in the range from 9.5 µm to 50 µm and the periodic dot structure with the first interference period is generated within an interference pixel by means of a plurality of successive laser pulses by multiple irradiation or by single irradiation by a laser pulse.

12. Method according to claim 11, wherein a multiple irradiation with identical process parameters of an interference pixel takes place, so that a quasi-periodic line structure superimposed on the first periodic dot structure is formed as a wave structure by self-organization processes.

13. Method according to claim 11 or 12, wherein a further periodic dot structure or periodic line structure with an interference period identical to the first interference period or with an interference period different from the interference period of the first periodic dot structure is applied to the substrate (5) by multiple irradiation with deviating process parameters.

14. Method according to any one of claims 11 to 13, wherein the method additionally comprises the following steps:
c) providing a further substrate (5), wherein the further substrate is preferably transparent,
d) embossing the first substrate onto the further substrate (5) so that a periodic dot structure comprising cones is formed thereon.

15. **Use** of the patterned substrate (5) according to any one of claims 1 to 10 as anti-fogging glazing in the region of automotive applications, aerospace, building glazing and optics or photovoltaic systems.

## Revendications

1. Substrat structuré (5) ayant une surface présentant des propriétés anti-buée, dans lequel la surface est constituée d'une zone structurée (28) et d'une zone non structurée (29),
dans lequel la zone structurée (28)
a) est formée par une première structure ponctuelle périodique dans la gamme micrométrique ou submicrométrique avec une première période d'interférence (p₁) dans la gamme de 50 nm à 50 µm ; ou
b) est formée par une première structure ponctuelle périodique dans la gamme micrométrique et/ou submicrométrique avec une première période d'interférence (p₁) dans la gamme de 50 nm à 2,0 µm ou dans la gamme de 9,5 µm à 50 µm,
la première structure ponctuelle périodique étant formée de broches inversées (14), les broches inversées étant formées dans le substrat à structurer, **caractérisé en ce que** les broches inversées présentent une pointe conique arrondie,
et **en ce que** la surface du substrat présentant la première structure ponctuelle, lorsqu'elle est mouillée par de l'eau, présente un angle de contact avec l'eau (23) inférieur à 20°, de préférence inférieur à 10°, de façon particulièrement préférée inférieur à 5°.

2. Substrat structuré (5) selon la revendication 1, dans lequel le substrat structuré (5) comporte un matériau dont la surface non structurée présente des propriétés hydrophiles, la première structure ponctuelle périodique étant disposée sur et/ou dans ce matériau.

3. Substrat structuré (5) selon la revendication 1 ou 2, dans lequel la zone non structurée de la surface° présente des propriétés hydrophiles, de préférence un angle de contact avec l'eau inférieur à 90°.

4. Substrat structuré (5) selon l'une des revendications 1 à 3, dans lequel la première structure ponctuelle périodique présente une profondeur de structure dans la plage de 0,05 µm à 2 µm.

5. Substrat structuré (5) selon l'une des revendications 1 à 4, dans lequel le substrat (5) présente un facteur de transmission, dans une zone partielle du spectre électromagnétique, d'au moins 50 % ou de préférence d'au moins 70 % ou de manière particulièrement préférée d'au moins 80 % ou d'au moins 90 % pour chaque longueur d'onde dans la zone partielle.

6. Substrat structuré (5) selon la revendication 5, dans lequel la zone partielle comprenant un rayonnement électromagnétique dans la plage de 380 nm à 780 nm,
la transmission dans cette zone partielle étant d'au moins 50 % pour chaque longueur d'onde dans la zone partielle.

7. Substrat structuré (5) selon l'une des revendications 1 à 6, dans lequel la surface du substrat présentant la première structure ponctuelle présente des propriétés hydrophiles et/ou superhydrophiles.

8. Substrat structuré (5) selon la revendication 7, dans lequel l'angle de contact avec l'eau (23) varie sur la surface présentant la première structure ponctuelle périodique au maximum de seulement de 5°, de préférence au maximum de 3°.

9. Substrat structuré (5) selon l'une des revendications 1 à 8, dans lequel une structure linéaire ayant des dimensions dans la plage micrométrique et/ou submicrométrique est superposée à la première structure ponctuelle périodique ayant des dimensions dans la plage micrométrique et/ou submicrométrique.

10. Substrat structuré (5) selon la revendication 9, dans lequel la structure linéaire superposée à la première structure ponctuelle périodique est périodique, la structure linéaire périodique structurant uniformément le substrat (5) à l'intérieur d'un pixel d'interférence, la structure linéaire présentant une période d'interférence dont les dimensions sont comprises entre 1 % et 30 % de la période d'interférence de la première structure ponctuelle périodique.

11. Procédé de fabrication d'un substrat (5) présentant une structure ponctuelle périodique dans la plage micrométrique et/ou submicrométrique, qui présente des propriétés anti-buée selon l'une des revendications 1 à 10 par structuration directe par interférence laser, comprenant les étapes suivantes :
a. fournir un substrat,
b. appliquer une première structure ponctuelle périodique présentant une première période d'interférence,
la structure ponctuelle périodique étant formée par superposition de faisceaux laser partiels divisés à partir d'un faisceau laser au moyen d'un élément séparateur de faisceau (2) dans une zone d'interférence, ainsi que de pixels d'interférence,
la première structure ponctuelle périodique étant formée de broches inversées (14), les broches inversées étant formées dans le substrat à structurer,
**caractérisé en ce que**
A) la période d'interférence de la structure ponctuelle périodique se situe dans la plage de 50 nm à 50 µm et la structure ponctuelle périodique présentant la première période d'interférence est générée à l'intérieur d'un pixel d'interférence au moyen d'une irradiation unique par une impulsion laser, ou
B) la période d'interférence de la structure ponctuelle périodique se situe dans la plage de 50 nm à 2,0 µm ou dans la plage de 9,5 µm à 50 µm, et la structure ponctuelle périodique présentant la première période d'interférence est générée à l'intérieur d'un pixel d'interférence au moyen d'une pluralité d'impulsions laser successives par une irradiation multiple ou par une irradiation unique au moyen d'une impulsion laser.

12. Procédé selon la revendication 11, dans lequel une irradiation multiple est effectuée avec des paramètres de traitement identiques d'un pixel d'interférence, de sorte qu'une structure linéaire quasi-périodique superposée à la première structure ponctuelle périodique est formée sous forme de structure d'onde par un processus d'auto-organisation.

13. Procédé selon l'une des revendications 11 et 12, dans lequel une autre structure ponctuelle périodique ou structure linéaire périodique présentant une période d'interférence identique à la première période d'interférence ou différente de la période d'interférence de la première structure ponctuelle périodique est appliquée au substrat (5) par irradiation multiple avec différents paramètres de traitement.

14. Procédé selon l'une des revendications 11 à 13, dans lequel le procédé comprend en outre les étapes suivantes :
c. fournir un autre substrat (5), l'autre substrat étant de préférence transparent
d. gaufrer le premier substrat sur l'autre substrat (5), de sorte qu'une structure ponctuelle périodique comportant des broches soit formée sur celui-ci.

15. Utilisation du substrat structuré (5) selon l'une des revendications 1 à 10 comme vitrage anti-buée dans le domaine de l'automobile, de l'aérospatiale, du vitrage de bâtiment et de l'optique ou des installations photovoltaïques.
